# EUROPEAN PATENT APPLICATION

(11) **EP 4 592 298 A1**
(43) Date of publication of application: **30.07.2025**
(21) Application number: 23891944.3
(22) Date of filing: 13.11.2023
(51) Int. Cl.: C07F 7/08, H10K 85/40, H10K 50/11, C09K 11/06

(54) **COMPOUND FOR ORGANIC ELECTRICAL ELEMENT, ORGANIC ELECTRICAL ELEMENT USING SAME, AND ELECTRONIC DEVICE THEREOF**

(30) Priority: 15.11.2022 KR 20220152561
(71) Applicant: Duk San Neolux Co., Ltd., Chungcheongnam-do 31027 (KR)
(72) Inventor: SONG, Yeong Ran, Chungcheongnam-do 31027 (KR); KANG, Moon Sung, Cheonan-si Chungcheongnam-do 31027 (KR); LEE, Hyung Dong, Cheonan-si, Chungcheongnam-do 31027 (KR)
(74) Representative: Isarpatent
(86) International application number: PCT/KR2023/018170
(87) International publication number: WO 2024/106877

(57) **Abstract**

The present invention provides a novel compound, an organic electrical element using same, and an electronic device thereof, the novel compound allowing light-emitting, stability and lifespan of an element to be increased.

## Description

### BACKGROUND

### [Technical Field]

The present invention relates to compounds for organic electronic elements, organic electronic elements using the same, and an electronic device thereof.

### [Background Art]

In general, organic light emitting phenomenon refers to a phenomenon that converts electric energy into light energy by using an organic material. An organic electronic element using an organic light emitting phenomenon usually has a structure including an anode, a cathode, and an organic material layer interposed therebetween. Here, in order to increase the efficiency and stability of the organic electronic element, the organic material layer is often composed of a multi-layered structure composed of different materials, and for example, may include a hole injection layer, a hole transport layer, an emitting layer, an electron transport layer, an electron injection layer etc.

A material used as an organic material layer in an organic electronic element may be classified into a light emitting material and a charge transport material, such as a hole injection material, a hole transport material, an electron transport material, an electron injection material etc. depending on its function.

The biggest issues with organic light-emitting diodes are their lifespan and efficiency, and as displays become larger in size, these efficiency and lifespan issues must be resolved.

Efficiency, lifespan and driving voltage are related to each other, and when the efficiency is increased, the driving voltage is relatively decreased, and as the driving voltage is decreased, crystallization of organic materials due to Joule heating generated during driving decreases, and consequently, the lifespan tends to increase.

However, the efficiency cannot be maximized simply by improving the organic material layer. This is because, when the energy level and T1 value between each organic material layer, and the intrinsic properties (mobility, interfacial properties, etc.) of materials are optimally combined, long lifespan and high efficiency can be achieved at the same time.

Further, recently, in organic electroluminescent devices, in order to solve the emission problem in the hole transport layer, an emitting-auxiliary layer must be present between the hole transport layer and an emitting layer, and it is necessary to develop different emitting-auxiliary layers according to each of the emitting layers (R, G, B). In general, electrons are transferred from the electron transport layer to the emitting layer, and holes are transferred from the hole transport layer to the emitting layer to generate excitons by recombination.

However, the material used for the hole transport layer has a low HOMO value and therefore has mostly low T1 value, therefore the exciton generated in the emitting layer is transferred to the hole transport layer, resulting in charge unbalance in the emitting layer, and light is emitted at the interface of the hole transport layer.

When light is emitted at the interface of the hole transport layer, the color purity and efficiency of the organic electronic element are lowered and the life span is shortened. Therefore, it is urgently required to develop an emitting-auxiliary layer having a high T1 value and a HOMO level between the HOMO energy level of the hole transport layer and the HOMO energy level of the emitting layer.

Meanwhile, it is necessary to develop a hole injection layer material having stable characteristics, that is, a high glass transition temperature, against Joule heating generated when the device is driven, while delaying penetration of the metal oxide from the anode electrode (ITO), which is one of the causes of shortening the lifespan of the organic electronic element, into the organic layer. The low glass transition temperature of the hole transport layer material has a characteristic that when the device is driven, the uniformity of the surface of the thin film is lowered, which has been reported to have a great influence on the lifespan of the device. In addition, OLED devices are mainly formed by a deposition method, and it is necessary to develop a material that can withstand long time in deposition, that is, a material having high heat resistance characteristics.

That is, in order to sufficiently exhibit the excellent characteristics of the organic electronic element, a material for forming an organic material layer in an element such as a hole injection material, a hole transport material, a light emitting material, an electron transport material, an electron injection material, an emitting-auxiliary layer material should be supported by stable and efficient materials. However, such a stable and efficient organic material layer material for an organic electronic element has not been sufficiently developed yet. Therefore, the development of new materials continues to be required, and in particular, the development of materials for the emitting-auxiliary layer is urgently required.

### DETAILED DESCRIPTION OF THE INVENTION

### [Summary]

In order to solve the problems of the background art described above, the present invention has revealed a compound having a novel structure, and that when the compound is applied to an organic electronic element, the luminous efficiency, stability and lifespan of the element are greatly improved.

Accordingly, it is an object of the present invention to provide a novel compound, an organic electronic element using the same, and an electronic device thereof.

### [Technical Solution]

The present invention provides a compound represented by Formula 1.

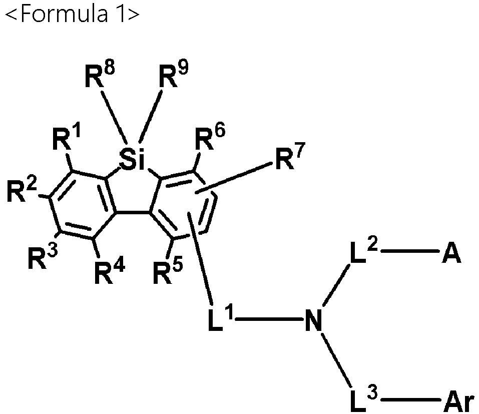

In another aspect, the present invention provides an organic electronic element comprising a compound represented by Formula 1 and an electronic device thereof.

### [Effects of the Invention]

By using the compound according to the present invention, it is possible to achieve a high luminous efficiency, a low driving voltage, and a high heat resistance of the element, and can greatly improve the color purity and lifespan of the element.

### [BRIEF DESCRIPTION OF THE DRAWINGS]

FIG. 1 to FIG. 3 illustrate an example of an organic electronic element according to the present invention.
FIG. 4 shows a Formula according to one aspect of the present invention.

| | | | |
|---|---|---|---|
| 100, 200, 300: | organic electronic element | 110 : | the first electrode |
| 120 : | hole injection layer | 130 : | hole transport layer |
| 140 : | emitting layer | 150 : | electron transport layer |
| 160 : | electron injection layer | 170 : | second electrode |
| 180 : | light efficiency enhancing Layer | 210 : | buffer layer |
| 220 : | emitting-auxiliary layer | 320 : | first hole injection layer |
| 330 : | first hole transport layer | 340 : | first emitting layer |
| 350 : | first electron transport layer | 360 : | first charge generation layer |
| 361 : | second charge generation layer | 420 : | second hole injection layer |
| 430 : | second hole transport layer | 440 : | second emitting layer |
| 450 : | second electron transport layer | CGL : | charge generation layer |
| ST1 : | first stack | ST2 : | second stack |

### [DETAILED DESCRIPTION]

Hereinafter, some embodiments of the present invention will be described in detail. Further, in the following description of the present invention, a detailed description of known functions and configurations incorporated herein will be omitted when it may make the subject matter of the present invention rather unclear.

In addition, terms, such as first, second, A, B, (a), (b) or the like may be used herein when describing components of the present invention. Each of these terminologies is not used to define an essence, order or sequence of a corresponding component but used merely to distinguish the corresponding component from other component(s). It should be noted that if a component is described as being "connected", "coupled", or "connected" to another component, the component may be directly connected or connected to the other component, but another component may be "connected ", " coupled" or "connected" between each component.

As used in the specification and the accompanying claims, unless otherwise stated, the following is the meaning of the term as follows.

Unless otherwise stated, the term "halo" or "halogen", as used herein, includes fluorine(F), bromine(Br), chlorine(Cl), or iodine(I).

Unless otherwise stated, the term "alkyl" or "alkyl group", as used herein, has a single bond of 1 to 60 carbon atoms, and means saturated aliphatic functional radicals including a linear alkyl group, a branched chain alkyl group, an alkyl group, a cycloalkyl group (alicyclic), an cycloalkyl group substituted with a alkyl or an alkyl group substituted with a cycloalkyl.

Unless otherwise stated, the term "alkenyl" or "alkynyl", as used herein, has double or triple bonds of 2 to 60 carbon atoms, but is not limited thereto, and includes a linear or a branched chain group.

Unless otherwise stated, the term "cycloalkyl", as used herein, means alkyl forming a ring having 3 to 60 carbon atoms, but is not limited thereto.

Unless otherwise stated, the term "alkoxyl group", "alkoxy group" or "alkyloxy group", as used herein, means an oxygen radical attached to an alkyl group, but is not limited thereto, and has 1 to 60 carbon atoms.

Unless otherwise stated, the term "aryloxyl group" or "aryloxy group", as used herein, means an oxygen radical attached to an aryl group, but is not limited thereto, and has 6 to 60 carbon atoms.

Unless otherwise stated, the term "aryl group" or "arylene group", as used herein, has 6 to 60 carbon atoms, but is not limited thereto. Herein, the aryl group or arylene group means a monocyclic and polycyclic aromatic group, and includes an aromatic ring formed by the participation of adjacent substituents in a bond or reaction. Examples of "aryl group" may include a phenyl group, a biphenyl group, a fluorene group, or a spirofluorene group.

The prefix "aryl" or "ar" means a radical substituted with an aryl group. For example, an arylalkyl may be an alkyl substituted with an aryl, and an arylalkenyl may be an alkenyl substituted with aryl, and a radical substituted with an aryl has a number of carbon atoms as defined herein.

Also, when prefixes are named subsequently, it means that substituents are listed in the order described first. For example, an arylalkoxy means an alkoxy substituted with an aryl, an alkoxylcarbonyl means a carbonyl substituted with an alkoxyl, and an arylcarbonylalkenyl also means an alkenyl substituted with an arylcarbonyl, wherein the arylcarbonyl may be a carbonyl substituted with an aryl.

Unless otherwise stated, the term "heterocyclic group", as used herein, contains one or more heteroatoms, but is not limited thereto, has 2 to 60 carbon atoms, includes any one of monocyclic and polycyclic rings, and may include heteroaliphatic ring and/or heteroaromatic ring. Also, the heterocyclic group may also be formed in conjunction with an adjacent group.

Unless otherwise stated, the term "heteroatom", as used herein, represents at least one of N, O, S, P, or Si.

Also, the term "heterocyclic group" may include a ring including SO₂ instead of carbon consisting of cycle. For example, "heterocyclic group" includes compound below.

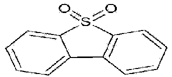

Unless otherwise stated, the term "fluorenyl group" or "fluorenylene group", as used herein, means a monovalent or divalent functional group, in which R, R' and R" are all hydrogen in the following structures, and the term "substituted fluorenyl group" or "substituted fluorenylene group" means that at least one of the substituents R, R', R" is a substituent other than hydrogen, and include those in which R and R' are bonded to each other to form a spiro compound together with the carbon to which they are bonded.

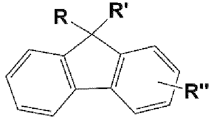

The term "spiro compound", as used herein, has a 'spiro union', and a spiro union means a connection in which 2 rings share only one atom. At this time, atoms shared in the 2 rings are called 'spiro atoms', and these compounds are called 'monospiro-', 'di-spiro-' and 'tri-spiro-', respectively, depending on the number of atoms in a compound.

Unless otherwise stated, the term "aliphatic", as used herein, means an aliphatic hydrocarbon having 1 to 60 carbon atoms, and the term "aliphatic ring", as used herein, means an aliphatic hydrocarbon ring having 3 to 60 carbon atoms.

Unless otherwise stated, the term "ring", as used herein, means an aliphatic ring having 3 to 60 carbon atoms, or an aromatic ring having 6 to 60 carbon atoms, or a hetero ring having 2 to 60 carbon atoms, or a fused ring formed by the combination of them, and includes a saturated or unsaturated ring.

Other hetero compounds or hetero radicals other than the above-mentioned hetero compounds include one or more heteroatoms, but are not limited thereto.

Unless otherwise stated, the term "substituted or unsubstituted", as used herein, means that substitution is substituted by at least one substituent selected from the group consisting of deuterium, halogen, an amino group, a nitrile group, a nitro group, a C₁-C₂₀ alkyl group, a C₁-C₂₀ alkoxyl group, a C₁-C₂₀ alkylamine group, a C₁-C₂₀ alkylthiophen group, a C₆-C₂₀ arylthiophen group, a C₂-C₂₀ alkenyl group, a C₂-C₂₀ alkynyl group, a C₃-C₂₀ cycloalkyl group, a C₆-C₂₀ aryl group, a C₆-C₂₀ aryl group substituted by deuterium, a C₈-C₂₀ arylalkenyl group, a silane group, a boron group, a germanium group, and a C₂-C₂₀ heterocyclic group, but is not limited thereto.

Unless otherwise expressly stated, the Formula used in the present invention, as used herein, is applied in the same manner as the substituent definition according to the definition of the exponent of the following Formula. 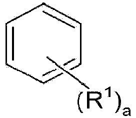 wherein, when a is an integer of 0, the substituent R¹ is absent, when a is an integer of 1, the sole substituent R¹ is linked to any one of the carbon constituting the benzene ring, when a is an integer of 2 or 3, each substituent R¹s may be the same and different, when a is an integer of 4 to 6, and is linked to the benzene ring in a similar manner, whereas the indication of hydrogen bound to the carbon forming the benzene ring is omitted.

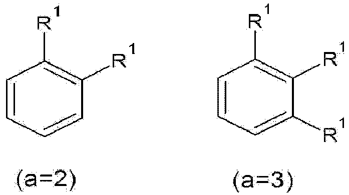

Hereinafter, a compound according to an aspect of the present invention and an organic electronic element comprising the same will be described.

The present invention provides a compound represented by Formula 1. 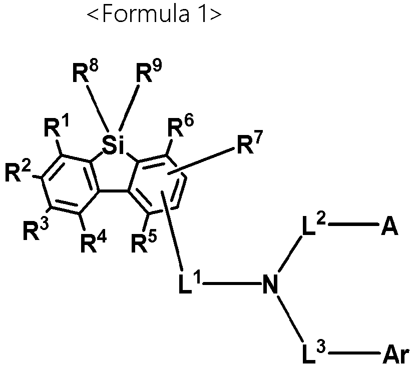 Wherein:
A is an C₃~C₆₀ cyloalkyl group,
R¹, R², R³, R⁴, R⁵, R⁶ and R⁷ are each independently selected from the group consisting of a hydrogen; deuterium; halogen; cyano group; nitro group; an C₆-C₆₀ aryl group; fluorenyl group; a C₂-C₆₀ heterocyclic group including at least one heteroatom of O, N, S, Si or P; a fused ring group of a C₃-C₆₀ aliphatic ring and a C₆-C₆₀ aromatic ring; a C₁-C₆₀ alkyl group; a C₂-C₆₀ alkenyl group; a C₂-C₆₀ alkynyl group; a C₁-C₆₀ alkoxy group; and a C₆-C₆₀ aryloxy group; or can be bonded to each other to form a ring.

Wherein when R¹, R², R³, R⁴, R⁵, R⁶ and R⁷ are an aryl group, it may be preferably a C₆-C₃₀ aryl group, and more preferably a C₆-C₂₅ aryl group, for example, it may be phenyl, biphenyl, terphenyl, naphthalene, etc,

Wherein when R¹, R², R³, R⁴, R⁵, R⁶ and R⁷ are a heterocyclic group, it may be preferably a C₂~C₃₀ heterocyclic group, and more preferably a C₂∼C₂₅ heterocyclic group, for example, pyrazine, thiophene, pyridine, pyrimidoindole, 5-phenyl-5H-pyrimido[5,4-b]indole, quinazoline, benzoquinazoline, carbazole, dibenzoquinazoline, dibenzofuran, dibenzothiophene, benzothienopyrimidine, benzofuropyrimidine, phenothiazine, phenylphenothiazine, etc.,

Wherein when R¹, R², R³, R⁴, R⁵, R⁶ and R⁷ are a fused ring group, preferably a fused ring group of a C₃-C₃₀ aliphatic ring and a C₆-C₃₀ aromatic ring, more preferably a fused ring group of a C₃-C₂₄ aliphatic ring and a C₆-C₂₄ aromatic ring.

Wherein when R¹, R², R³, R⁴, R⁵, R⁶ and R⁷ are an alkyl group, it may be preferably a C₁-C₃₀ alkyl group, and more preferably a C₁-C₂₄ alkyl group.

Wherein when R¹, R², R³, R⁴, R⁵, R⁶ and R⁷ are an alkenyl group, it may be preferably a C₂-C₃₀ alkenyl group, and more preferably a C₂-C₂₄ alkenyl group.

Wherein when R¹, R², R³, R⁴, R⁵, R⁶ and R⁷ are an alkynyl group, it may be preferably a C₂-C₃₀ alkynyl group, and more preferably a C₂-C₂₄ alkynyl group.

Wherein when R¹, R², R³, R⁴, R⁵, R⁶ and R⁷ are alkoxyl groups, it may be preferably a C₁-C₃₀ alkoxyl group, and more preferably a C₁-C₂₄ alkoxyl group.

Wherein when R¹, R², R³, R⁴, R⁵, R⁶ and R⁷ are an aryloxy group, it may be preferably a C₆-C₃₀ aryloxy group, and more preferably a C₆-C₂₄ aryloxy group.

R⁸ and R⁹ are each independently an a C₁-C₆₀ alkyl group, preferably a C₁-C₃₀ alkyl group, more preferably a C₁-C₂₄ alkyl group.

L¹, L² and L³ are each independently selected from the group consisting of a single bond; a C₆-C₆₀ arylene group; fluorenylene group; a C₂-C₆₀ heterocyclic group including at least one heteroatom of O, N, S, Si or P; and a fused ring group of a C₃-C₆₀ aliphatic ring and a C₆-C₆₀ aromatic ring;

Wherein when L¹, L² and L³ are an arylene group, it may be preferably a C₆-C₃₀ arylene group, more preferably a C₆-C₂₀ arylene group, for example, phenylene, biphenylene, naphthylene, terphenylene, etc.,

Wherein when L¹, L² and L³ are fluorenylene groups, it can be 9,9-dimethyl-9H-fluorenylene, 9,9-diphenyl-9H-fluorenylene, 9,9'-spirobifluorenylene, etc.

Wherein when L¹, L² and L³ are a heterocyclic group, it may be preferably a C₂~C₃₀ heterocyclic group, and more preferably a C₂~C₂₀ heterocyclic group, for example, pyridine, pyrimidine, quinoline, quinazoline, quinoxaline, dibenzofuran, dibenzothiophene, naphthobenzothiophene, naphthobenzofuran, benzofuran, benzothiophene, etc.,

Wherein when L¹, L² and L³ are a fused ring group, preferably a fused ring group of a C₃-C₃₀ aliphatic ring and a C₆-C₃₀ aromatic ring, more preferably a fused ring group of a C₃-C₂₄ aliphatic ring and a C₆-C₂₄ aromatic ring.

Ar is a C₁-C₆₀ alkyl group; a C₃-C₆₀ cycloalkyl group; an C₆-C₆₀ aryl group; fluorenyl group; a C₂-C₆₀ heterocyclic group including at least one heteroatom of O, N, S, Si or P; a C₃-C₆₀ aliphatic ring; and a fused ring group of a C₃-C₆₀ aliphatic ring and a C₆-C₆₀ aromatic ring;

Wherein when Ar is an alkyl group, preferably a C₁-C₃₀ alkyl group, more preferably a C₁-C₂₄ alkyl group.

Wherein when Ar is a cycloalkyl group, preferably a C₃-C₃₀ cycloalkyl group, more preferably a C₃-C₂₄ cycloalkyl group.

Wherein when Ar is an aryl group, it may be preferably a C₆-C₃₀ aryl group, and more preferably a C₆-C₂₅ aryl group, for example, it may be phenyl, biphenyl, terphenyl, naphthalene, etc,

Wherein when Ar is a heterocyclic group, it may be preferably a C₂~C₃₀ heterocyclic group, and more preferably a C₂∼C₂₅ heterocyclic group, for example, pyrazine, thiophene, pyridine, pyrimidoindole, 5-phenyl-5H-pyrimido[5,4-b]indole, quinazoline, benzoquinazoline, carbazole, dibenzoquinazoline, dibenzofuran, dibenzothiophene, benzothienopyrimidine, benzofuropyrimidine, phenothiazine, phenylphenothiazine, etc.,

Wherein when Ar is an aliphatic ring: it may be preferably a C₃-C₃₀ aliphatic ring, and more preferably a C₃-C₂₄ aliphatic ring,

Wherein when Ar is a fused ring group, it may be preferably a fused ring group of a C₃-C₃₀ aliphatic ring and a C₆-C₃₀ aromatic ring, more preferably a fused ring group of a C₃-C₂₄ aliphatic ring and a C₆-C₂₄ aromatic ring.

Wherein the aryl group, arylene group, heterocyclic group, fluorenyl group, fluorenylene group, aliphatic ring group, fused ring group, cycloalkyl group, alkyl group, alkenyl group, alkynyl group, alkoxy group and aryloxy group may be substituted with one or more substituents selected from the group consisting of deuterium; halogen; silane group; siloxane group; boron group; germanium group; cyano group; nitro group; C₁-C₂₀ alkylthio group; C₁-C₂₀ alkoxyl group; C₁-C₂₀ alkyl group; C₂-C₂₀ alkenyl group; C₂-C₂₀ alkynyl group; C₆-C₂₀ aryl group; C₆-C₂₀ aryl group substituted with deuterium; fluorenyl group; a C₂-C₂₀ heterocyclic group; a C₃-C₂₀ cycloalkyl group; a C₇-C₂₀ arylalkyl group; and C₈-C₂₀ arylalkenyl group; and also the substituents may be bonded to each other to form a saturated or unsaturated ring, wherein the term 'ring' means a C₃-C₆₀ aliphatic ring or a C₆-C₆₀ aromatic ring or a C₂-C₆₀ heterocyclic group or a fused ring formed by the combination thereof.

Also, A of Formula 1 is represented by any one of the following Formulas A-1 to A-5:

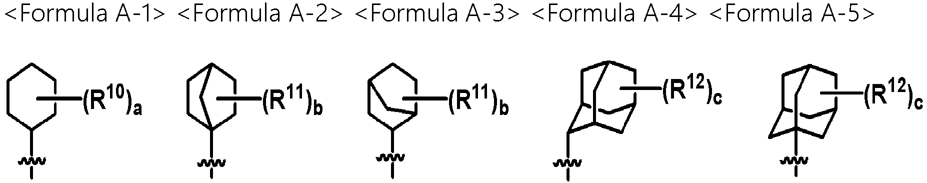

Wherein:
R¹⁰, R¹¹ and R¹² are each independently the same or different, and each independently selected from the group consisting of a hydrogen; deuterium; halogen; C₁-C₂₀ alkoxyl group; C₁-C₂₀ alkyl group; C₂-C₂₀ alkenyl group; C₂-C₂₀ alkynyl group; C₆-C₂₀ aryl group; C₆-C₂₀ aryl group substituted with deuterium; a fluorenyl group; C₂-C₂₀ heterocyclic group; C₃-C₂₀ cycloalkyl group; C₇-C₂₀ arylalkyl group; and C₈-C₂₀ arylalkenyl group;
a and b are independently integers from 0 to 11, c is an integer from 0 to 15,
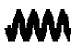 refers to the position to be bonded.

Additionally, Ar in Formula 1 is represented by the following Formula Ar-1 or Formula Ar-2 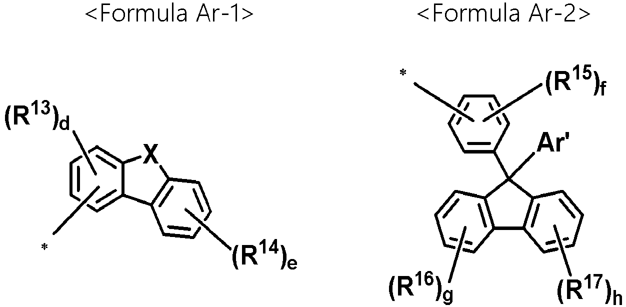 Wherein,
X is NR', O, S, CR'R" or SiR'R"
Ar' is selected from the group consisting of a C₁-C₆₀ alkyl group; an C₆-C₆₀ aryl group; fluorenyl group; a C₂-C₆₀ heterocyclic group including at least one heteroatom of O, N, S, Si or P; a C₃-C₆₀ aliphatic ring; a fused ring group of a C₃-C₆₀ aliphatic ring and a C₆-C₆₀ aromatic ring;
Wherein when Ar' is are an alkyl group, it may be preferably a C₁-C₃₀ alkyl group, and more preferably a C₁-C₂₄ alkyl group.

Wherein when Ar' is are an aryl group, it may be preferably a C₆-C₃₀ aryl group, and more preferably a C₆-C₂₅ aryl group, for example, it may be phenyl, biphenyl, terphenyl, naphthalene, etc,
Wherein when Ar' is a heterocyclic group, it may be preferably a C₂~C₃₀ heterocyclic group, and more preferably a C₂∼C₂₅ heterocyclic group, for example, pyrazine, thiophene, pyridine, pyrimidoindole, 5-phenyl-5H-pyrimido[5,4-b]indole, quinazoline, benzoquinazoline, carbazole, dibenzoquinazoline, dibenzofuran, dibenzothiophene, benzothienopyrimidine, benzofuropyrimidine, phenothiazine, phenylphenothiazine, etc.,

Wherein when Ar' is an aliphatic ring group, it may be preferably a C₃-C₃₀ aliphatic ring, and more preferably a C₃-C₂₄ aliphatic ring.

Wherein when Ar' is a fused ring group, it may be preferably a fused ring group of a C₃-C₃₀ aliphatic ring and a C₆-C₃₀ aromatic ring, more preferably a fused ring group of a C₃-C₂₄ aliphatic ring and a C₆-C₂₄ aromatic ring.

R¹³, R¹⁴, R¹⁵, R¹⁶ and R¹⁷ are the same as the definition of R¹⁰, or an adjacent plurality of R¹³s or of plurality of R¹⁴s or of plurality of R¹⁵s or of plurality of R¹⁶s or of plurality of R¹⁷s may be bonded to each other to form a ring,
d is an integer from 0 to 3, e, f, g and h are independently integers from 0 to 4,
R' and R" are each independently selected from the group consisting of a hydrogen; deuterium; a C₁-C₆₀ alkyl group; a C₁-C₆₀ alkyl group substituted with deuterium; an C₆-C₆₀ aryl group; and a C₂-C₆₀ heterocyclic group including at least one heteroatom of O, N, S, Si or P;
Or R' and R" can be bonded to each other to form a ring,

Wherein when R' and R" are an alkyl group, it may be preferably a C₁-C₃₀ alkyl group, and more preferably a C₁-C₂₄ alkyl group.

Wherein when R' and R" are an aryl group, it may be preferably a C₆-C₃₀ aryl group, and more preferably a C₆-C₂₅ aryl group, for example, it may be phenyl, biphenyl, terphenyl, naphthalene, etc,
Wherein when R' and R" are a heterocyclic group, it may be preferably a C₂~C₃₀ heterocyclic group, and more preferably a C₂∼C₂₅ heterocyclic group, for example, pyrazine, thiophene, pyridine, pyrimidoindole, 5-phenyl-5H-pyrimido[5,4-b]indole, quinazoline, benzoquinazoline, carbazole, dibenzoquinazoline, dibenzofuran, dibenzothiophene, benzothienopyrimidine, benzofuropyrimidine, phenothiazine, phenylphenothiazine, etc.,
* refers to the position to be bonded.

Also, Ar in Formula 1 is represented by any one of the following Formulas Ar-1-1 to Ar-1-4: 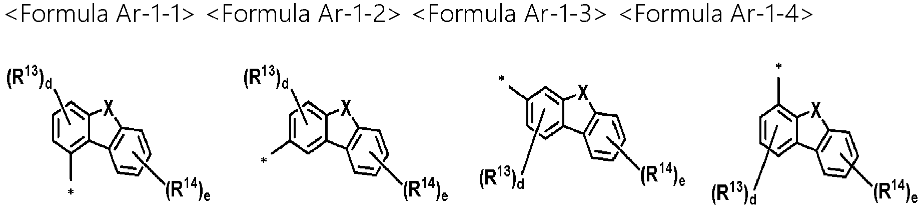 Wherein, X, R¹³, R¹⁴, d, e and * are the same as defined in Formula Ar-1.

Also, Ar in Formula 1 is represented by any one of the following Formulas Ar-1-5 to Ar-1-12: 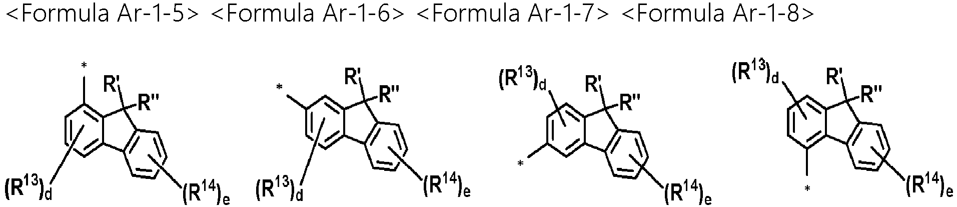 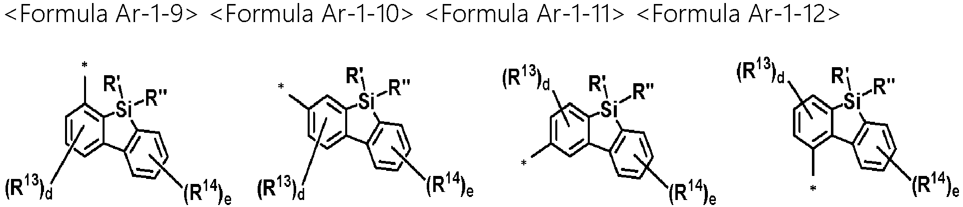 Wherein, R¹³, R¹⁴, d, e, R', R" and * are the same as defined in Formula Ar-1.

Also, Ar in Formula 1 is represented by any one of the following Formulas Ar-2-1 to Ar-2-3: 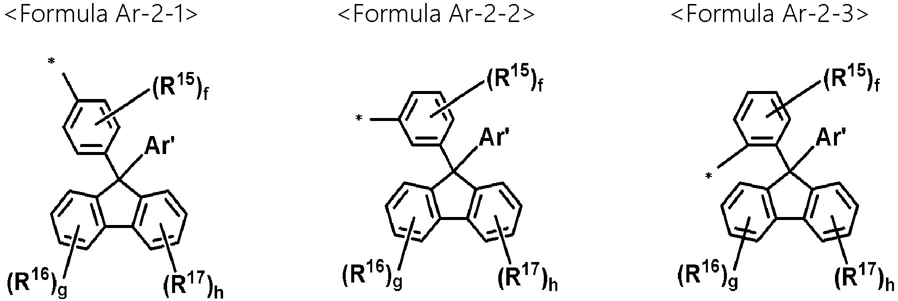 Wherein, R¹⁵, R¹⁶, R¹⁷, f, g, h, Ar' and * are the same as defined in Formula Ar-2.

Specifically, the compound represented by Formula 1 may be any one of the following compounds P-1 to P-184, but is not limited thereto.

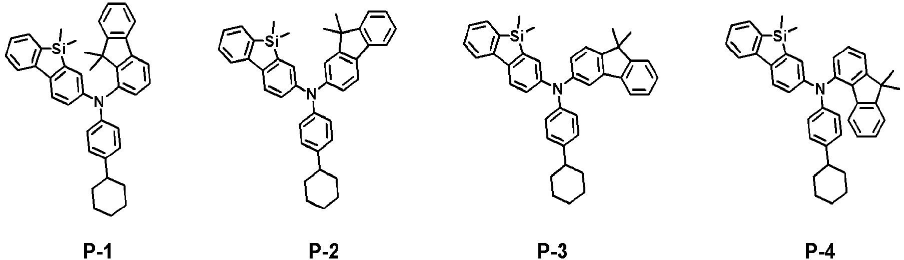

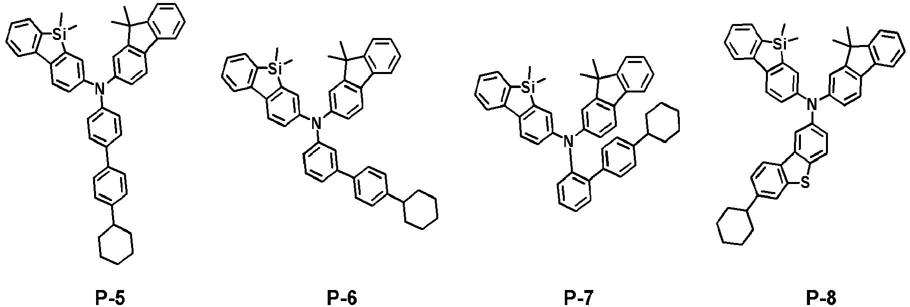

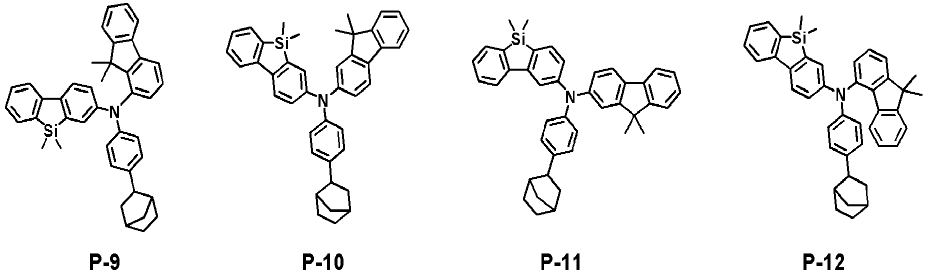

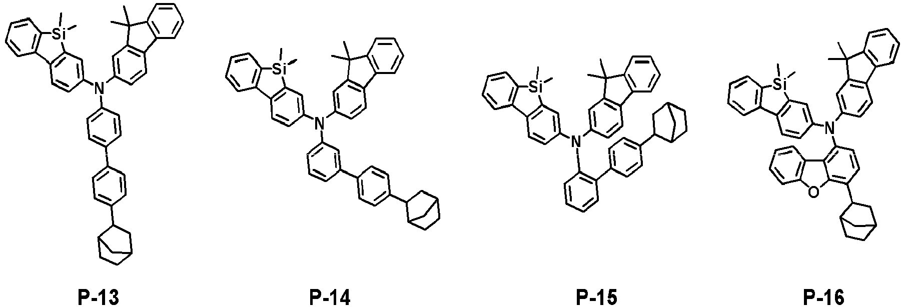

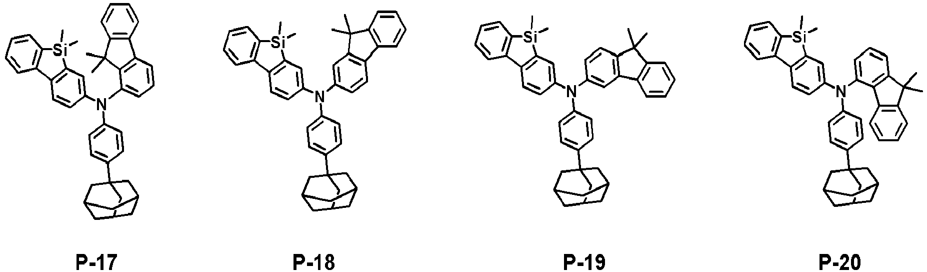

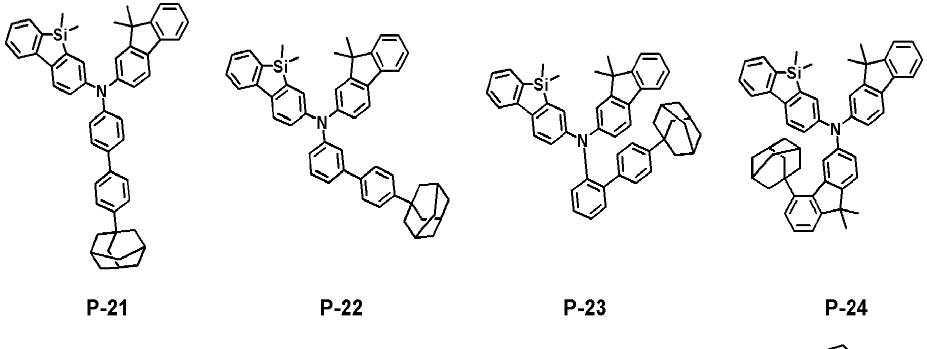

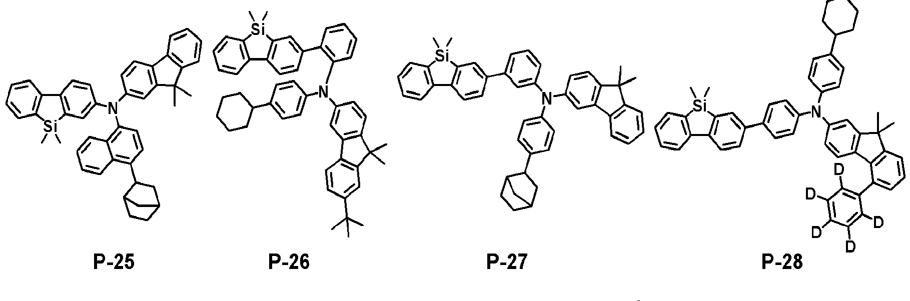

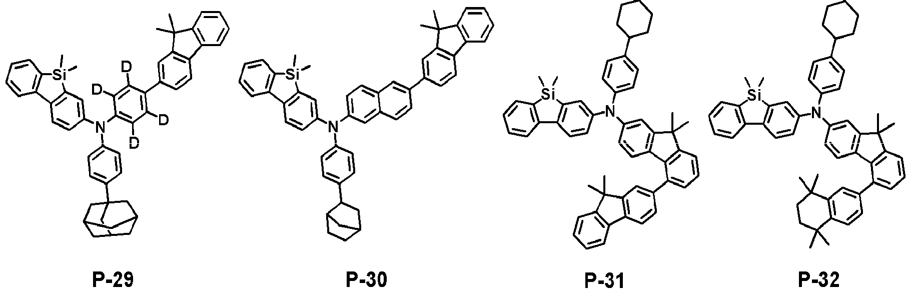

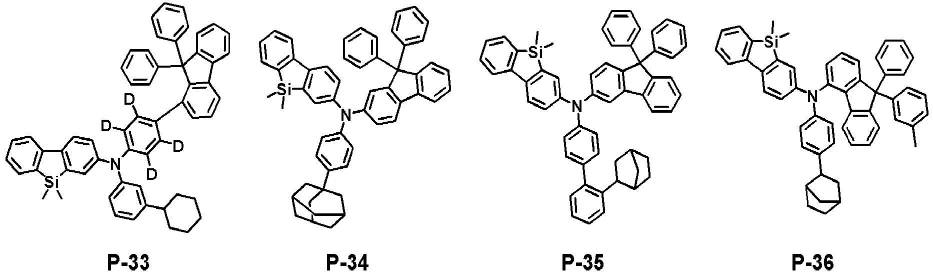

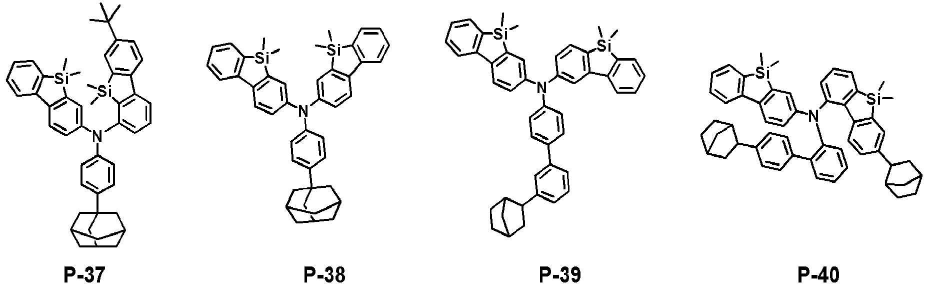

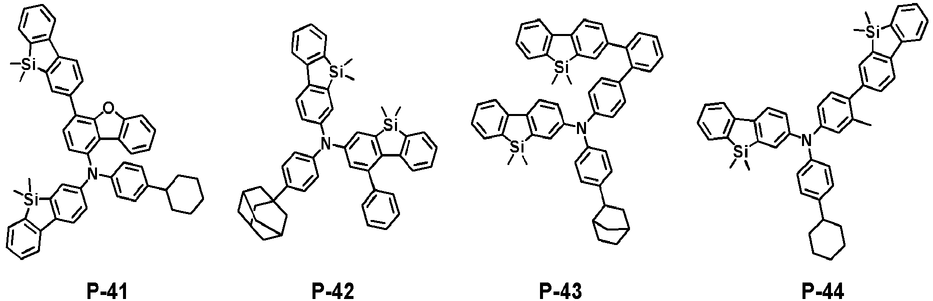

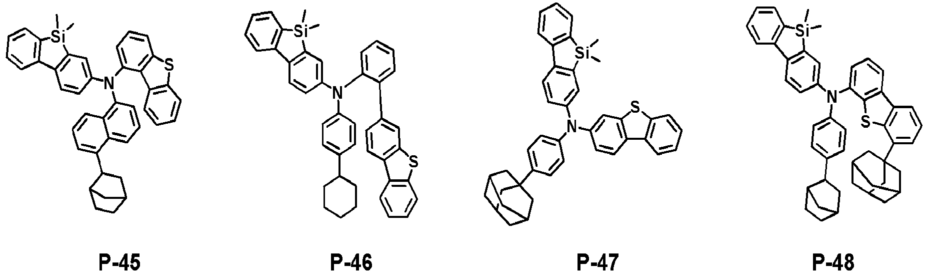

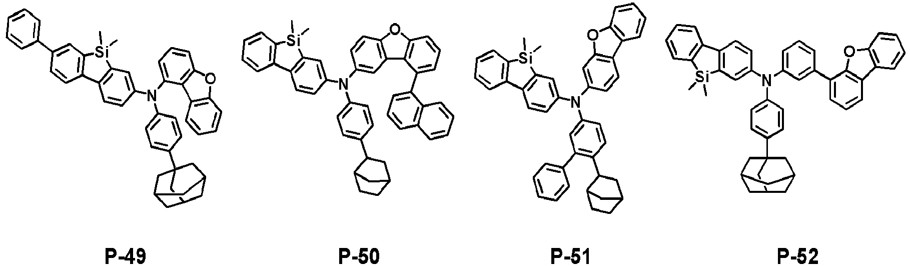

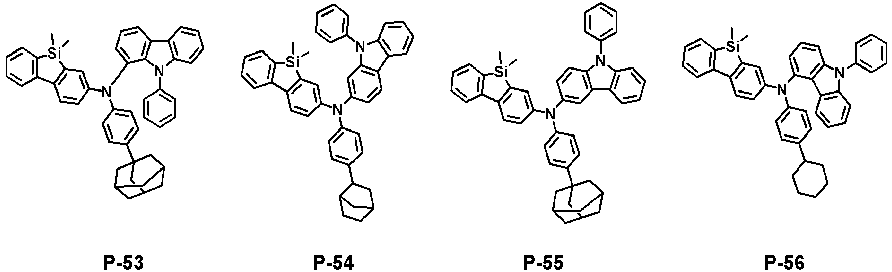

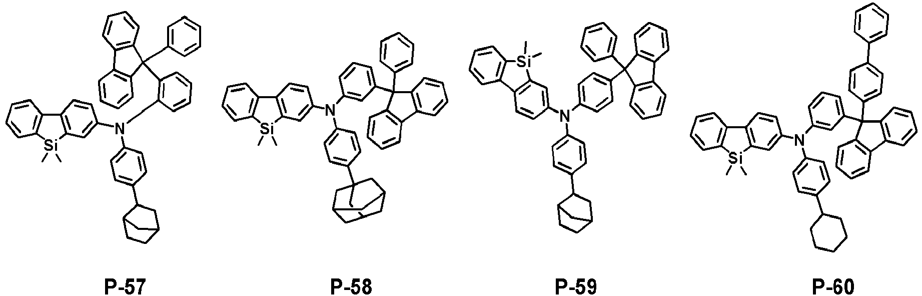

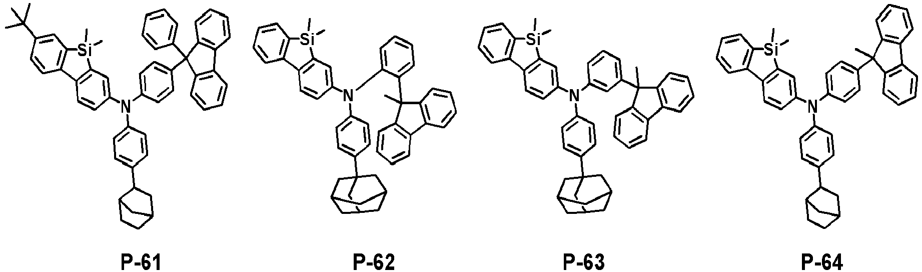

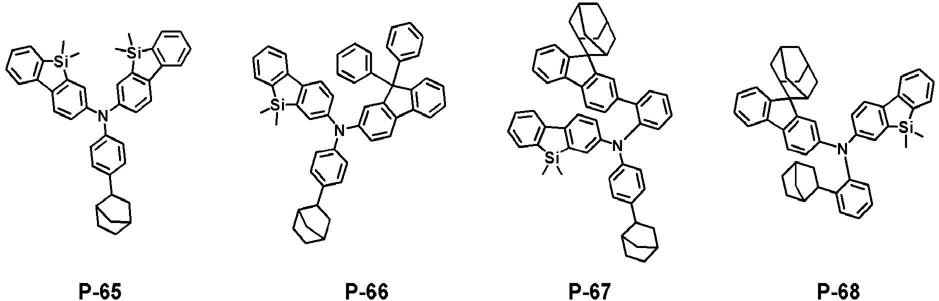

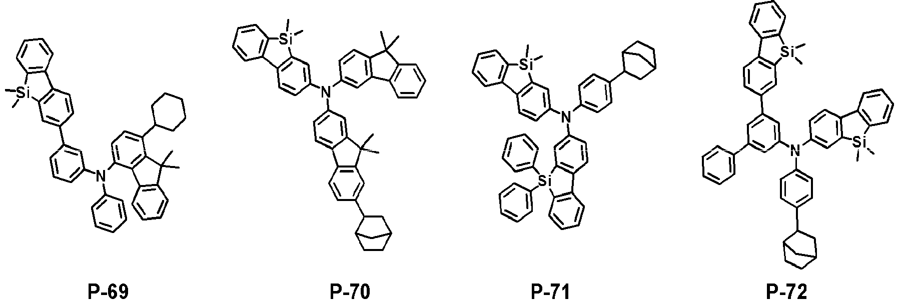

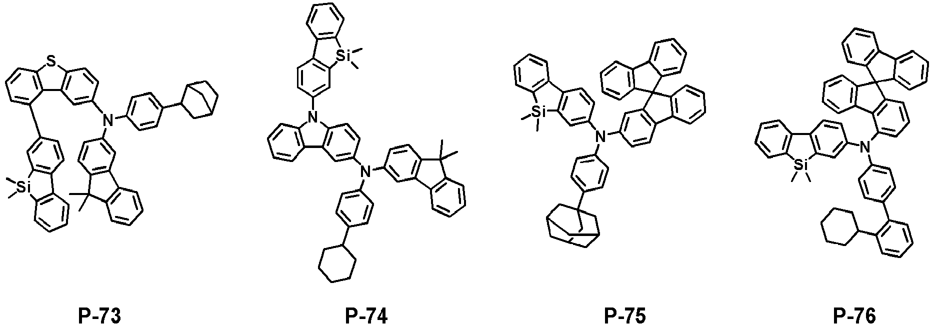

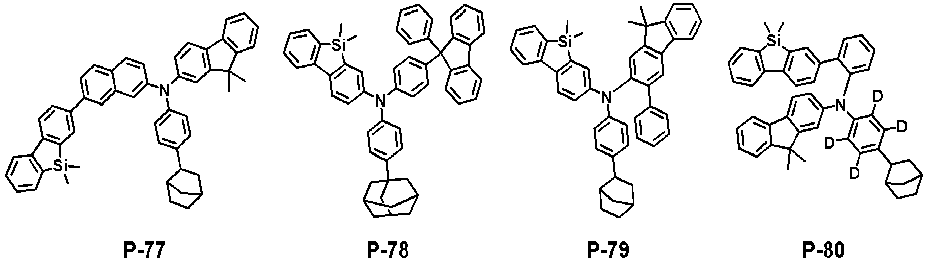

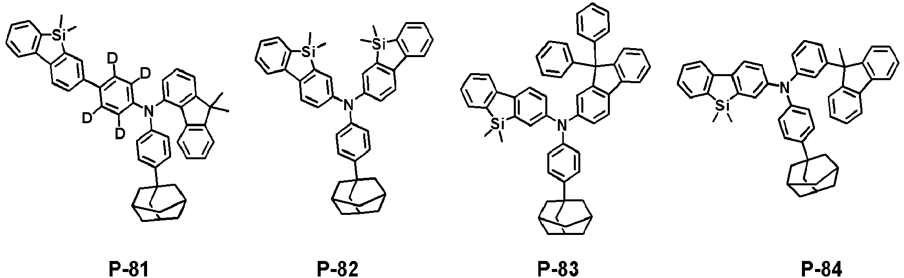

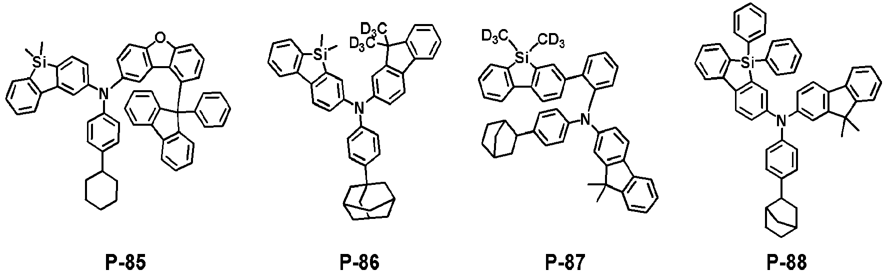

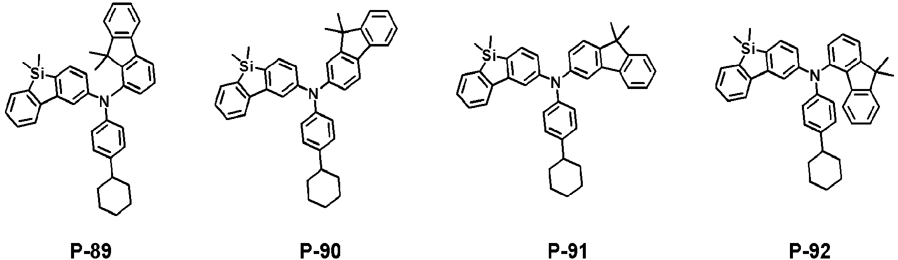

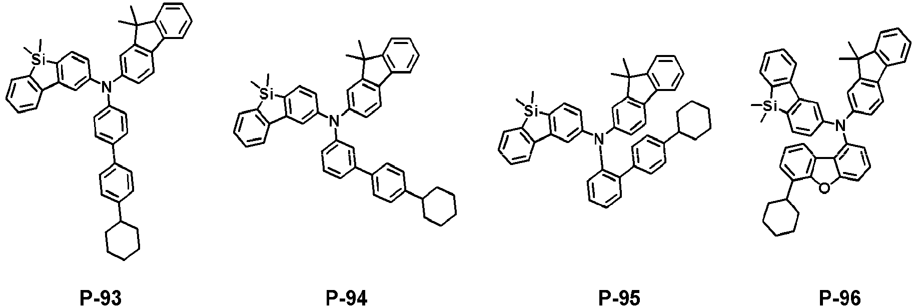

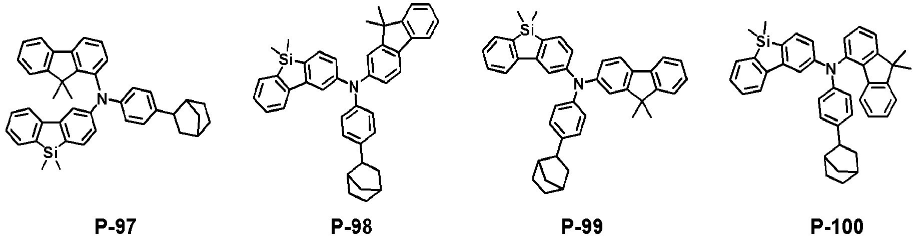

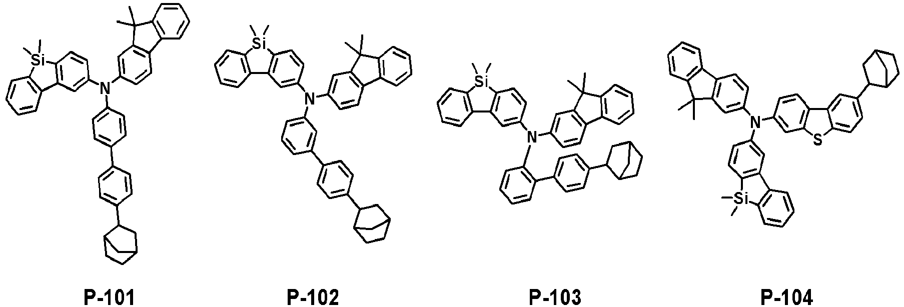

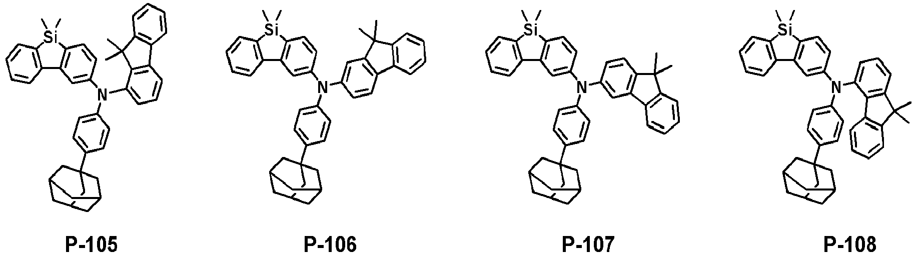

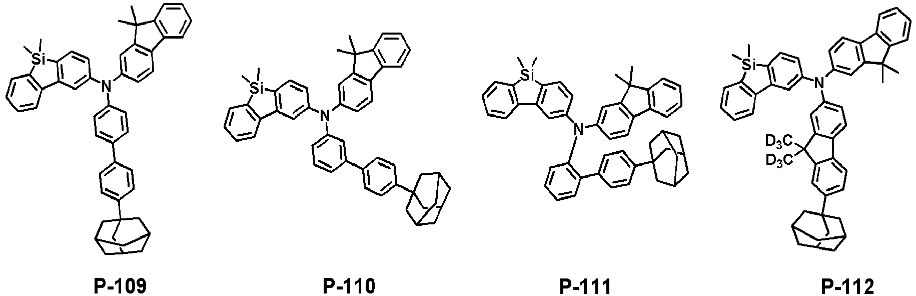

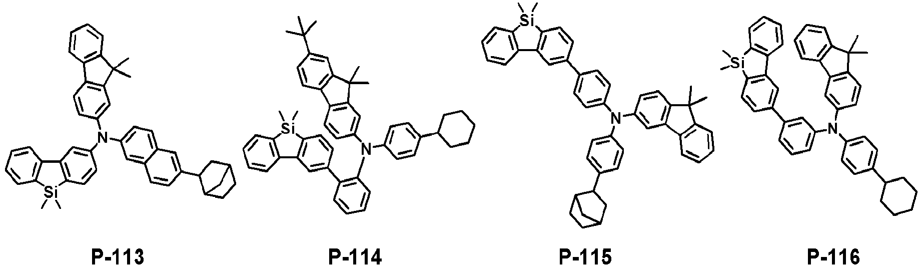

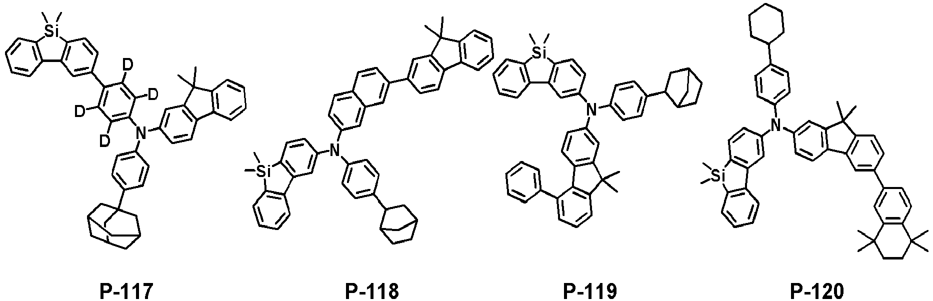

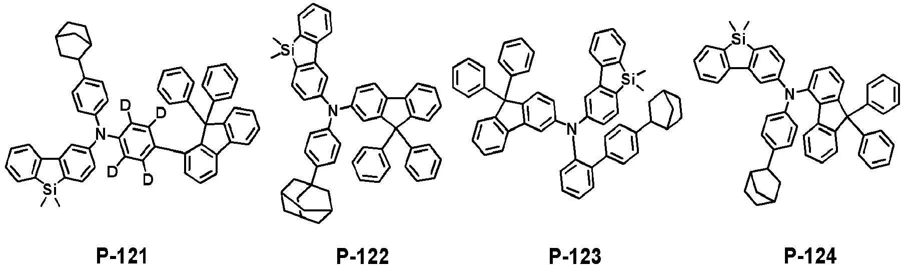

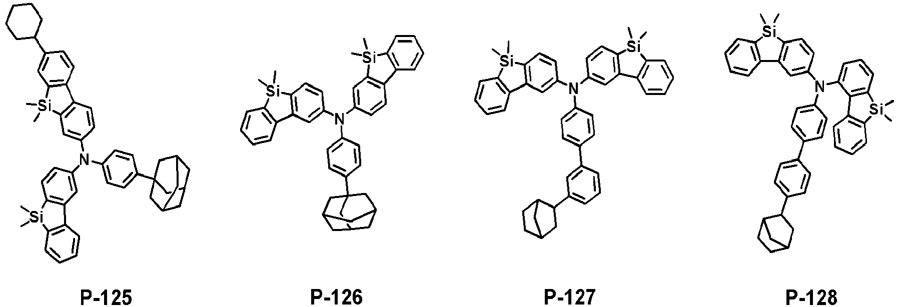

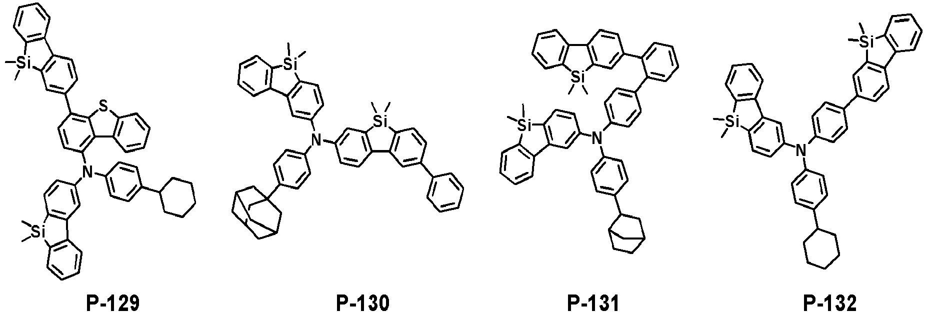

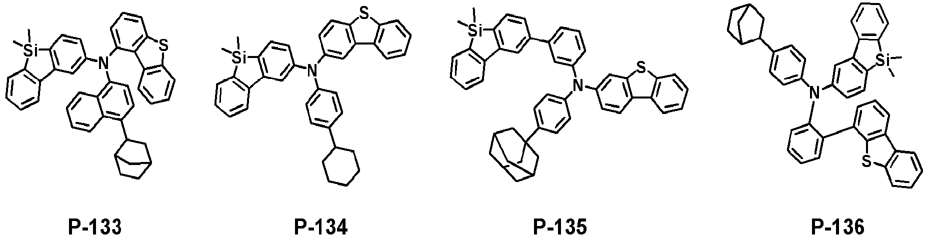

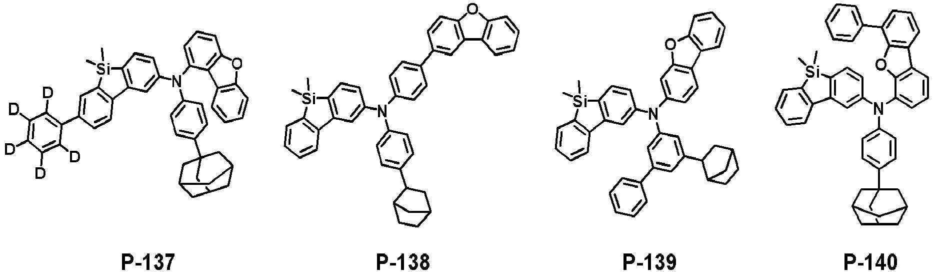

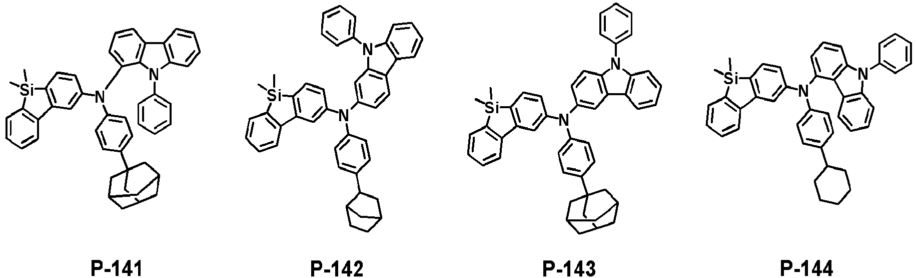

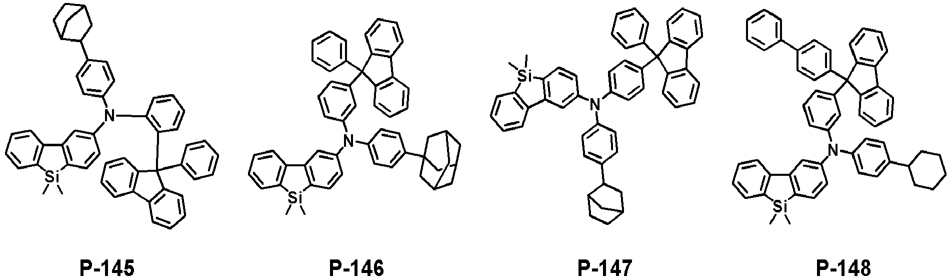

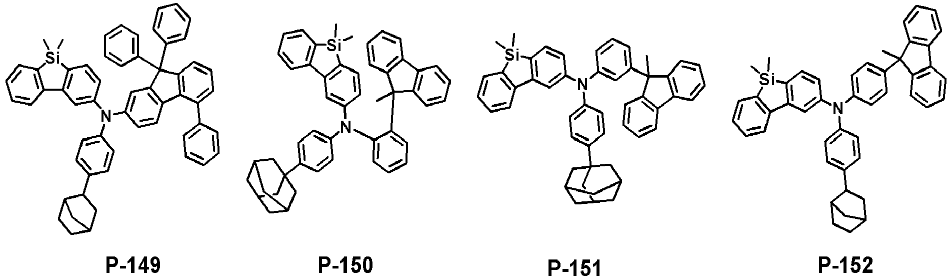

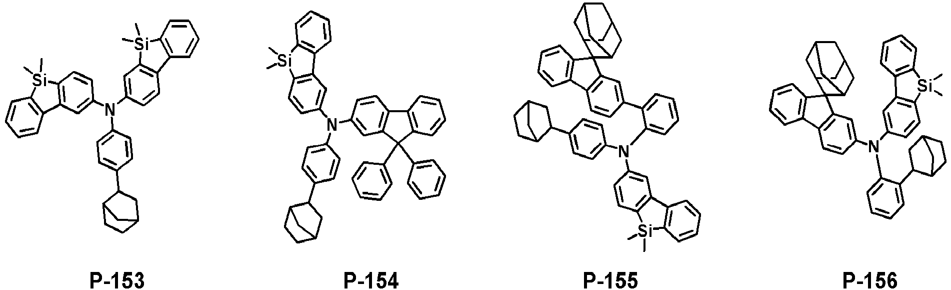

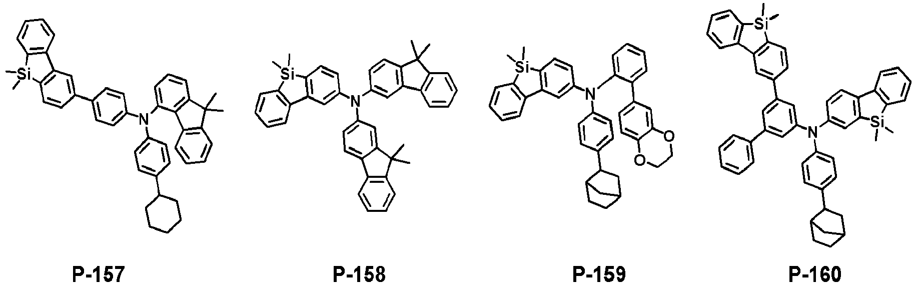

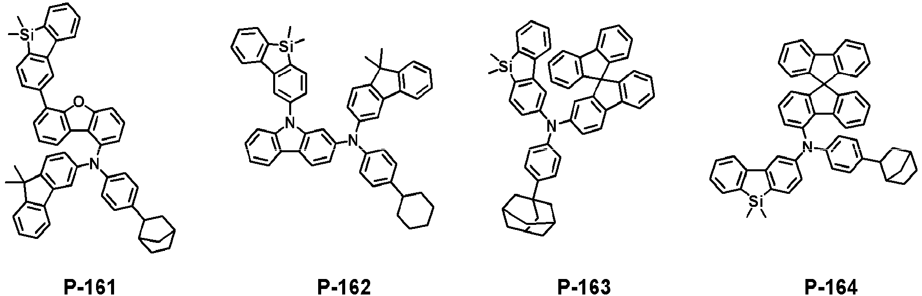

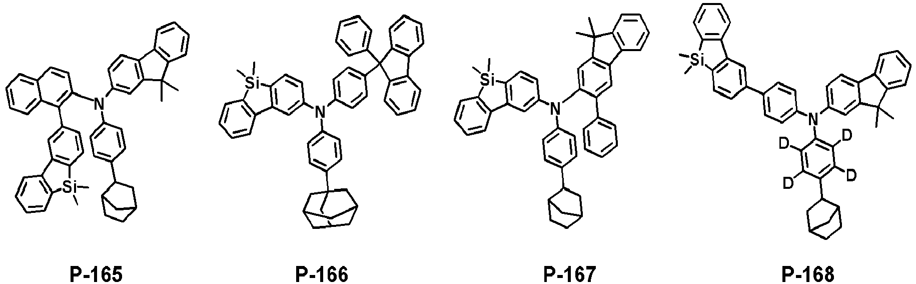

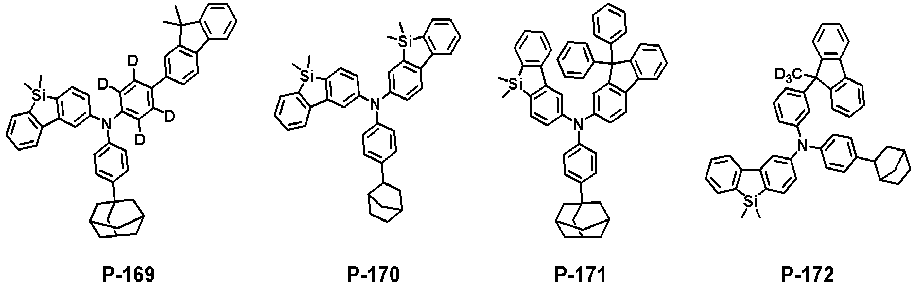

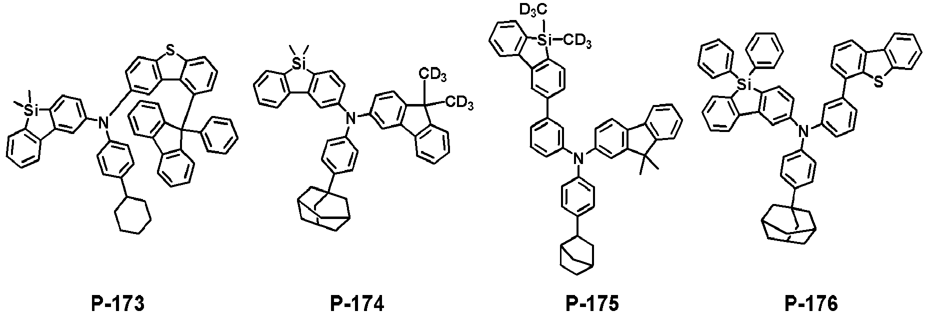

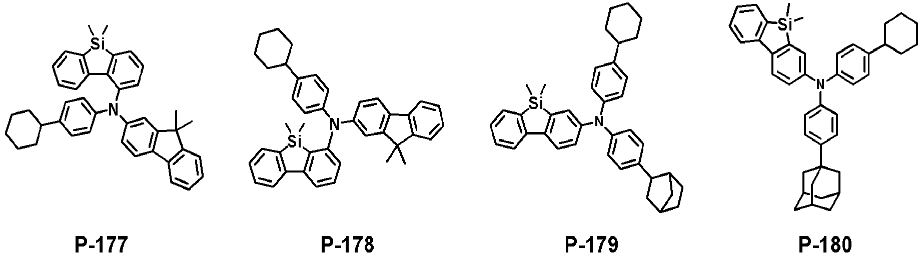

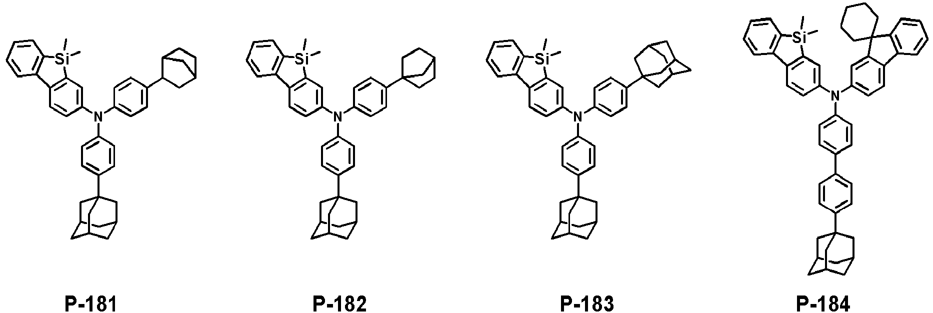

In another aspect, the present invention provides a method for reusing a compound of Formula 1 comprising:
recovering a crude organic light emitting material comprising the compound of Formula 1 from a deposition apparatus used in the process for depositing the organic emitting material to prepare an organic light emitting device;
removing impurities from the crude organic light emitting material;
recovering the organic light emitting material after the impurities are removed; and purifying the recovered organic light emitting material to have a purity of 99.9% or higher.

The step of removing impurities from the crude organic light emitting material recovered from the deposition apparatus may preferably comprise performing a pre-purification process to obtain a purity of 98% or more by recrystallization in a recrystallization solvent.

The recrystallization solvent may be preferably a polar solvent having a polarity index (PI) of 5.5 to 7.2.

The recrystallization solvent may preferably be used by mixing a polar solvent having a polarity value of 5.5 to 7.2 and a non-polar solvent having a polarity value of 2.0 to 4.7.

When a mixture of a polar solvent and a non-polar solvent is used, the recrystallization solvent may be used in an amount of 15% (v/v) or less of the non-polar solvent compared to the polar solvent.

The recrystallization solvent is preferably a single solvent of N-Methylpyrrolidone (NMP); or a polar solvent mixed any one selected from the group consisting of 1,3-Dimethyl-2-imidazolidinone, 2-pyrrolidone, N,N-Dimethyl formamide, Dimethyl acetamide, and Dimethyl sulfoxide to the N-Methylpyrrolidone; or alone; or mixed non-polar solvents; selected from the group consisting of Toluene, Dichloromethane (DCM), Dichloroethane (DCE), Tetrahydrofuran (THF), Chloroform, Ethyl acetate and Butanone; or a mixture of a polar solvent and a non-polar solvent.

The pre-purification process may comprise a step of precipitating crystals of by cooling to 0° C. to 5° C. after dissolving the crude organic light emitting material recovered from the deposition apparatus in a polar solvent at 90° C. to 120° C.

The pre-purification process may comprise a step of precipitating crystals by cooling to 35°C to 40°C, adding a non-polar solvent, and then cooling to 0°C to 5°C. after dissolving the crude organic light emitting material recovered from the deposition apparatus in a polar solvent at 90° C. to 120° C.

The pre-purification process may comprise a step of precipitating crystals while concentrating the solvent and removing the non-polar solvent, after dissolving the crude organic light emitting material recovered from the deposition apparatus in a non-polar solvent.

The pre-purification process may comprise a step of recrystallizing again with a non-polar solvent after recrystallizing first with a polar solvent.

The step of purifying the recovered impurities to a purity of 99.9% or higher may comprise performing an adsorption separation process to adsorb and remove impurities by adsorbing on the adsorbent.

The adsorbent may be activated carbon, silica gel, alumina, or a material for known adsorption purposes.

The step of purifying the recovered impurities to a purity of 99.9% or higher may comprise performing sublimation purification.

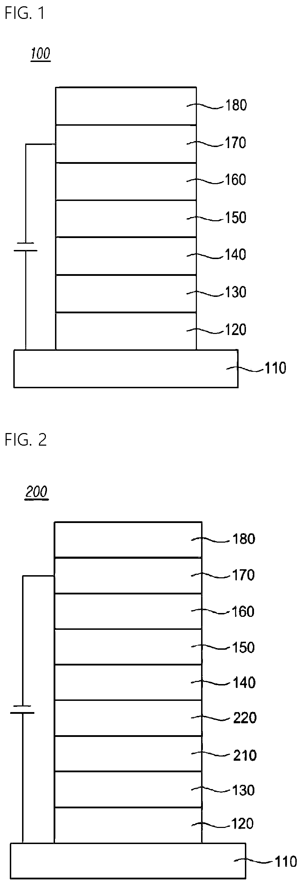

Referring to FIG. 1, the organic electronic element (100) according to the present invention comprises a first electrode (110), a second electrode (170), an organic material layer comprising single compound or 2 or more compounds represented by Formula 1 between the first electrode (110) and the second electrode (170). Wherein, the first electrode (110) may be an anode or a positive electrode, and the second electrode (170) may be a cathode or a negative electrode. In the case of an inverted organic electronic element, the first electrode may be a cathode, and the second electrode may be an anode.

The organic material layer may sequentially comprise a hole injection layer (120), a hole transport layer (130), an emitting layer (140), an electron transport layer(150), and an electron injection layer (160) on the first electrode(110). Here, the remaining layers except the emitting layer (140) may not be formed. The organic material layer may further comprise a hole blocking layer, an electron blocking layer, an emitting-auxiliary layer (220), a buffer layer (210), etc., and the electron transport layer (150), etc. may serve as a hole blocking layer (see FIG. 2).

Also, the organic electronic element according to an embodiment of the present invention may further include a protective layer or a light efficiency enhancing layer (180). Wherein the light efficiency enhancing layer is formed on one of both surfaces of the first electrode that is not in contact with the organic material layer or on one of both surfaces of the second electrode that is not in contact with the organic material layer. The compound according to an embodiment of the present invention applied to the organic material layer may be used as a material for a hole injection layer (120), a hole transport layer (130), an emitting-auxiliary layer (220), an electron transport au xiliary layer, an electron transport layer (150), an electron injection layer (160), a host or dopant of an emitting layer (140), or the light efficiency enhancing layer. Preferably, for example, a compound according to Formula 1 of the present invention can be used as a material of an emitting-auxiliary layer.

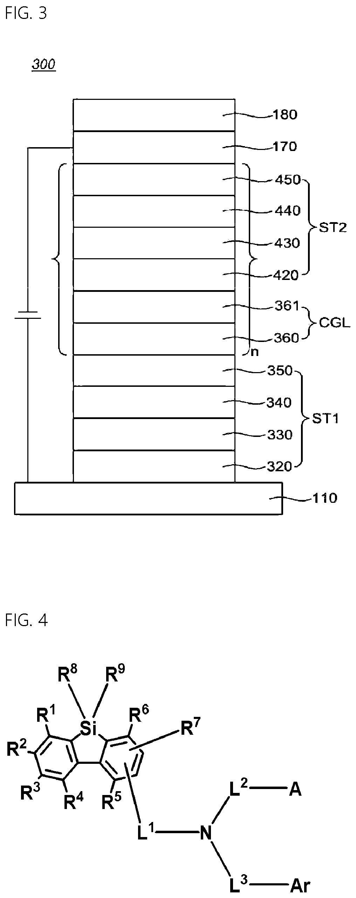

The organic material layer may comprise 2 or more stacks comprising a hole transport layer, an emitting layer and an electron transport layer sequentially formed on the anode, and may further comprise a charge generation layer formed between the 2 or more stacks (see FIG. 3).

Otherwise, even if the same core is used, the band gap, the electrical characteristics, the interface characteristics, etc. may vary depending on which substituent is bonded at which position, therefore the choice of core and the combination of sub-substituents associated therewith is also very important, and in particular, when the optimal combination of energy levels and T1 values, and unique properties of materials(mobility, interfacial characteristics, etc.) of each organic material layer is achieved, a long life span and high efficiency can be achieved at the same time.

The organic electroluminescent device according to an embodiment of the present invention may be manufactured using a PVD (physical vapor deposition) method. For example, a metal or a metal oxide having conductivity or an alloy thereof is deposited on a substrate to form a cathode, and the organic material layer including the hole injection layer(120), the hole transport layer(130), the emitting layer(140), the electron transport layer(150), and the electron injection layer(160) is formed thereon, and then a material that can be used as a cathode is deposited thereon.

Also, the present invention provides the organic electronic element wherein the organic material layer is formed by one of a spin coating process, a nozzle printing process, an inkjet printing process, a slot coating process, a dip coating process or a roll-to-roll process, and the organic material layer comprises the compound as an electron transport material.

As another specific example, a compound of the same or different types represented by Formula 1 is mixed and used in the organic material layer.

Additionally, the present invention provides an emitting-auxiliary layer composition comprising a compound represented by Formula 1, and provides an organic electronic element comprising the emitting-auxiliary layer.

Also, the present invention also provides an electronic device comprising a display device comprising the organic electronic element; and a control unit for driving the display device.

According to another aspect, the present invention provides a display device wherein the organic electronic element is at least one of an OLED, an organic solar cell, an organic photo conductor, an organic transistor (organic TFT) and an element for monochromic or white illumination. Here, the electronic device may be a wired/wireless communication terminal which is currently used or will be used in the future, and covers all kinds of electronic devices including a mobile communication terminal such as a cellular phone, a personal digital assistant(PDA), an electronic dictionary, a point-to-multipoint(PMP), a remote controller, a navigation unit, a game player, various kinds of TVs, and various kinds of computers.

Hereinafter, Synthesis examples of the compound represented by Formula 1 of the present invention, and preparation examples of the organic electronic element of the present invention will be described in detail by way of example, but are not limited to the following examples.

### [Synthesis Example 1]

The compound represented by Formula 1 according to the present invention (final product) is synthesized by reacting Sub1 and Sub2 as shown in the following reaction scheme 1, but is not limited thereto.

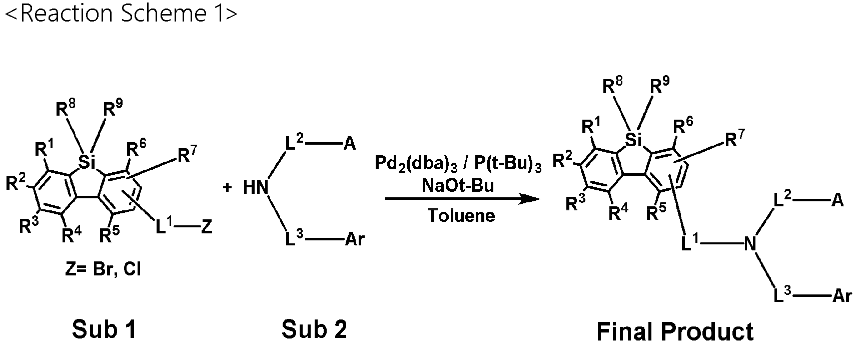

### I. Synthesis of Sub 1

Sub 1 of the reaction scheme 1 can be synthesized by the reaction path of the reaction scheme 2, but is not limited thereto.

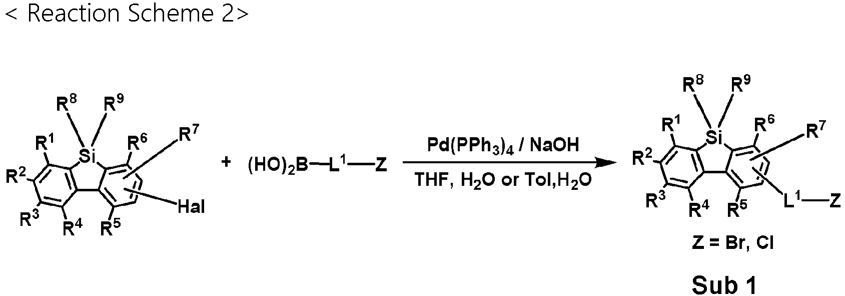

### 1. Synthesis example of Sub1-2

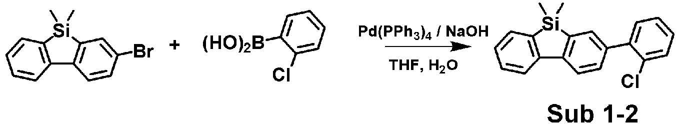

After dissolving 2-Bromo-9,9-dimethyl-9*H*-9-silafluorene (40 g, 138.9 mmol) in THF (360 ml) in a round-bottom flask, (2-chlorophenyl)boronic acid (26.0 g, 166.7 mmol), Pd(PPh₃)₄ (4.8 g, 4.2 mmol), NaOH (16.7 g, 416.7 mmol), water (120 mL) were added and stirred at 75°C. When the reaction was completed, extraction was performed with an organic solvent and moisture was removed with MgSO₄. The solvent was concentrated, and the resulting compound was purified by column chromatography and recrystallization to obtain the product (36.5 g, yield: 82%).

### 2. Synthesis example of Sub1-8

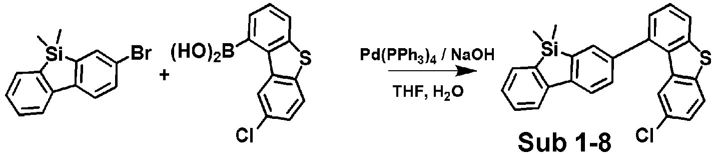

The product (24.4 g, yield: 66%) was obtained using the synthetic method of Sub 1-2 by adding 2-Bromo-9,9-dimethyl-9*H*-9-silafluorene (25.0 g, 86.8 mmol), (8-chlorodibenzo[b,d]thiophen-1-yl)boronic acid (27.3 g, 104.2 mmol), Pd(PPh₃)₄ (3.0 g, 2.6 mmol), NaOH (10.4 g, 260.4 mmol) in a round-bottom flask.

### 3. Synthesis example of Sub1-19

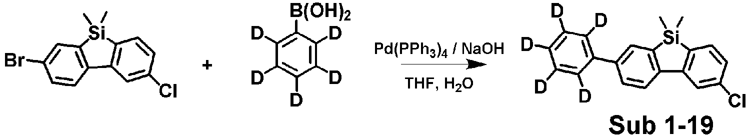

The product (23 g, yield: 76%) was obtained using the synthetic method of Sub 1-2 by adding 7-bromo-3-chloro-9,9-dimethyl-9H-dibenzo[b,d]silole (30.0 g, 93.2 mmol), (phenyl-d5)boronic acid (14.2 g, 295.9 mmol), Pd(PPh₃)₄ (3.2 g, 2.8 mmol), NaOH (11.2 g, 279.5 mmol) in a round-bottom flask.

### 4. Synthesis example of Sub1-23

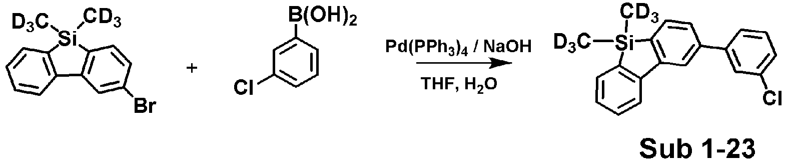

The product (21.4 g, yield: 77%) was obtained using the synthetic method of Sub 1-2 by adding 3-bromo-9,9-bis(methyl-d3)-9H-dibenzo[b,d]silole (25 g, 85.0 mmol), (3-chlorophenyl)boronic acid (15.9 g, 102 mmol), Pd(PPh₃)₄ (2.9 g, 2.6 mmol), NaOH (10.2 g, 255.1 mmol) in a round-bottom flask.

Meanwhile, compounds belonging to Sub 1 may be, but are not limited to, the compounds below, and Table 1 shows the FD-MS (Field Desorption-Mass Spectrometry) values of compounds belonging to Sub 1.

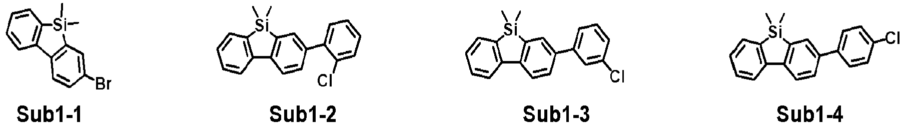

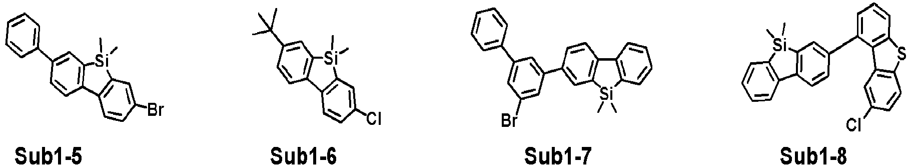

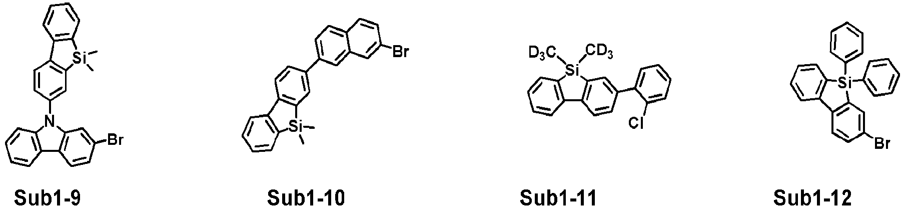

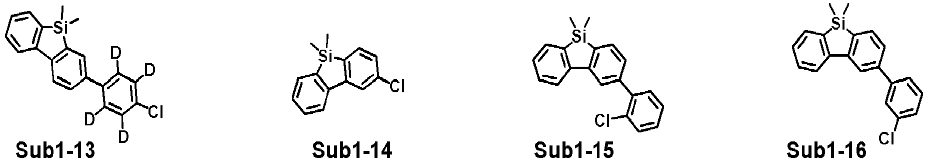

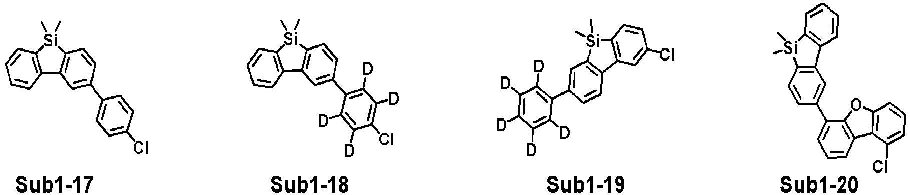

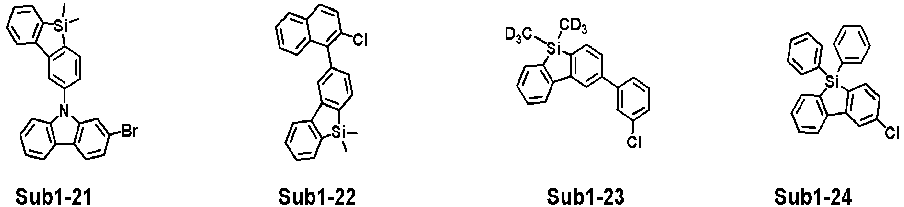

**[Table 1]**

| compound | FD-MS | compound | FD-MS |
|---|---|---|---|
| Sub 1-1 | m/z=288(C₁₄H₁₃BrSi=289.25) | Sub 1-2 | m/z=320.08(C₂₀H₁₇ClSi=320.89) |
| Sub 1-3 | m/z=320.08(C₂₀H₁₇ClSi=320.89) | Sub 1-4 | m/z=320.08(C₂₀H₁₇ClSi=320.89) |
| Sub 1-5 | m/z=364.03(C₂₀H₁₇BrSi=365.34) | Sub 1-6 | m/z=300.11(C₁₈H₂₁ClSi=300.9) |
| Sub 1-7 | m/z=440.06(C₂₆H₂₁BrSi=441.44) | Sub 1-8 | m/z=426.07(C₂₆H₁₉ClSSi=427.03) |
| Sub 1-9 | m/z=453.05(C₂₆H₂₀BrNSi=454.44) | Sub 1-10 | m/z=414.04(C₂₄H₁₉BrSi=415.4) |
| Sub 1-11 | m/z=326.12(C₂₀H₁₁D₆ClSi=326.93) | Sub 1-12 | m/z=412.03(C₂₄H₁₇BrSi=413.39) |
| Sub 1-13 | m/z=324.1(C₂₀H₁₃D₄ClSi=324.92) | Sub 1-14 | m/z=244.05(C₁₄H₁₃ClSi=244.79) |
| Sub 1-15 | m/z=320.08(C₂₀H₁₇ClSi=320.89) | Sub 1-16 | m/z=320.08(C₂₀H₁₇ClSi=320.89) |
| Sub 1-17 | m/z=320.08(C₂₀H₁₇ClSi=320.89) | Sub 1-18 | m/z=324.1(C₂₀H₁₃D₄ClSi=324.92) |
| Sub 1-19 | m/z=325.11(C₂₀H₁₂D₅ClSi=325.92) | Sub 1-20 | m/z=410.09(C₂₆H₁₉ClOSi=410.97) |
| Sub 1-21 | m/z=453.05(C₂₆H₂₀BrNSi=454.44) | Sub 1-22 | m/z=370.09(C₂₄H₁₉ClSi=370.95) |
| Sub 1-23 | m/z=326.12(C₂₀H₁₁D₆ClSi=326.93) | Sub 1-24 | m/z=368.08(C₂₄H₁₇ClSi=368.94) |

### II. Synthesis of Sub 2

Sub 2 of Reaction Scheme 1 is the same as Reaction Scheme 3 or Reaction Scheme 4, but is not limited thereto.

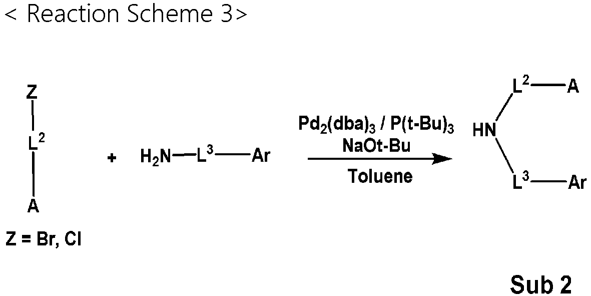

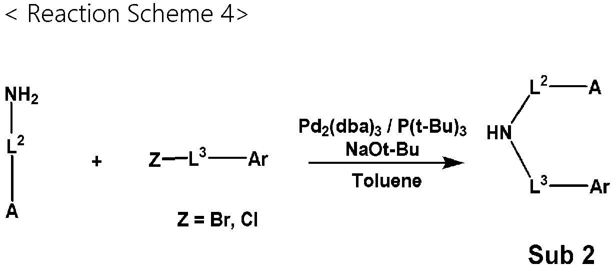

Synthetic examples of specific compounds belonging to Sub 2 are as follows.

### 1. Synthesis example of Sub 2-2

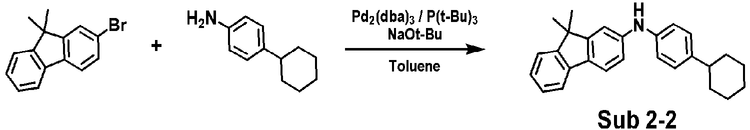

After dissolving 2-bromo-9,9-dimethyl-9H-fluorene (20.0 g, 73.5 mmol) in toluene (250 ml) in a round bottom flask, 4-cyclohexylaniline (15.5 g, 88.2 mmol), Pd₂(dba)₃ (2.0 g, 2.2 mmol), 50% P(t-Bu)₃ (1.8 ml, 4.4 mmol), NaOt-Bu (14.1 g, 147.0 mmol) were added and stirred at 110 °C. When the reaction was completed, the mixture was extracted with an organic solvent and water, the organic layer was dried over MgSO₄ and concentrated, and the resulting compound was subjected to column chromatography and recrystallization to obtain the product (18.9 g, yield: 70%).

### 2. Synthesis example of Sub 2-51

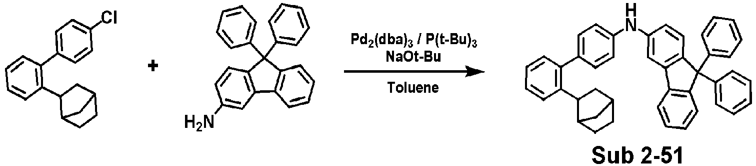

2-(4'-chloro-[1,1'-biphenyl]-2-yl)bicyclo[2.2.1]heptane (15.0 g, 53.2 mmol), 9,9-diphenyl-9H-fluoren-3-amine (21.3 g, 63.8 mmol), Pd₂(dba)₃ (1.5 g, 1.6 mmol), 50% P(t-Bu)₃ (1.3 ml, 3.2 mmol), NaOt-Bu (10.2 g, 106.3 mmol) were added to a round-bottom flask using the synthetic method of Sub 2-2 to obtain the product (25.6 g, yield: 83%).

### 3. Synthesis example of Sub 2-54

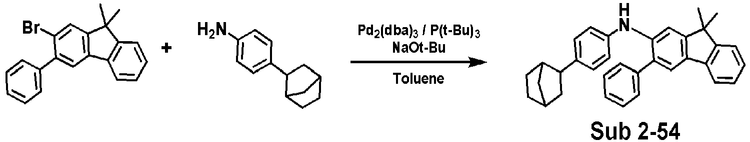

2-bromo-9,9-dimethyl-3-phenyl-9H-fluorene (20.0 g, 57.5 mmol), 4-(bicyclo[2.2.1]heptan-2-yl)aniline (12.9 g, 69.0 mmol), Pd₂(dba)₃ (1.6 g, 1.7 mmol), 50% P(t-Bu)₃ (1.4 ml, 3.4 mmol), NaOt-Bu (11.0 g, 114.9 mmol) were added to a round-bottom flask using the synthetic method of Sub 2-2 to obtain the product (23 g, yield: 88%).

### 4. Synthesis example of Sub 2-62

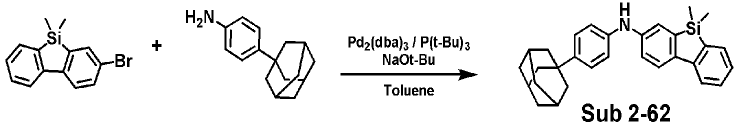

2-Bromo-9,9-dimethyl-9H-9-silafluorene (15.0 g, 52.1 mmol), 4-(adamantan-1-yl)aniline (14.2 g, 62.5 mmol), Pd₂(dba)₃ (1.4 g, 1.6 mmol), 50% P(t-Bu)₃ (1.3 ml, 3.1 mmol), NaOt-Bu (10.0 g, 104.2 mmol) were added to a round-bottom flask using the synthetic method of Sub 2-2 to obtain the product (18.4 g, yield: 81%).

### 5. Synthesis example of Sub 2-81

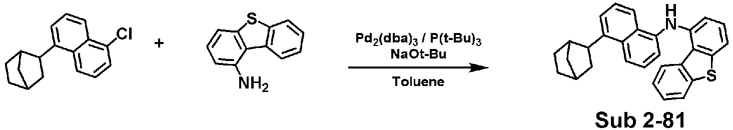

1-(bicyclo[2.2.1]heptan-2-yl)-5-chloronaphthalene (20.0 g, 78.1 mmol), dibenzo[b,d]thiophen-1-amine (18.7 g, 93.7 mmol), Pd₂(dba)₃ (2.1 g, 2.3 mmol), 50% P(t-Bu)₃ (1.9 ml, 4.7 mmol), NaOt-Bu (15.0 g, 156.2 mmol) were added to a round-bottom flask using the synthetic method of Sub 2-2 to obtain the product (25.2 g, yield: 77%).

### 6. Synthesis example of Sub 2-95

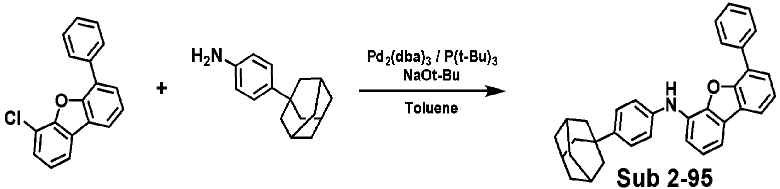

4-chloro-6-phenyldibenzo[b,d]furan (20.0 g, 71.9 mmol), 4-(adamantan-1-yl)aniline (19.6 g, 86.3 mmol), Pd₂(dba)₃ (2.0 g, 2.2 mmol), 50% P(t-Bu)₃ (1.7 ml, 4.3mmol), NaOt-Bu (13.8 g, 143.9 mmol) were added to a round-bottom flask using the synthetic method of Sub 2-2 to obtain the product (27 g, yield: 80%).

### 7. Synthesis example of Sub 2-99

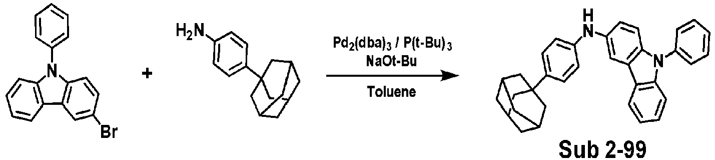

3-bromo-9-phenyl-9H-carbazole (18.0 g, 56.1 mmol), 4-(adamantan-1-yl)aniline (15.3 g, 67.3 mmol), Pd₂(dba)₃ (1.5 g, 1.7 mmol), 50% P(t-Bu)₃ (1.4 ml, 3.4 mmol), NaOt-Bu (10.8 g, 112.1 mmol) were added to a round-bottom flask using the synthetic method of Sub 2-2 to obtain the product (23.4 g, yield: 86%).

### 8. Synthesis example of Sub 2-101

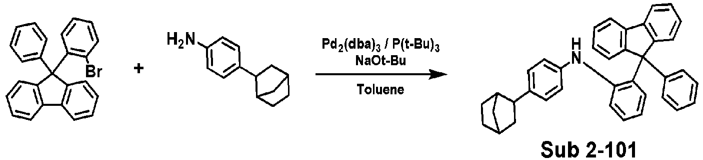

9-(2-bromophenyl)-9-phenyl-9H-fluorene (20.0 g, 50.5 mmol), 4-(bicyclo[2.2.1]heptan-2-yl)aniline (11.3 g, 60.6 mmol), Pd₂(dba)₃ (1.4 g, 1.5 mmol), 50% P(t-Bu)₃ (1.2 ml, 3.0 mmol), NaOt-Bu (9.7 g, 101.0 mmol) were added to a round-bottom flask using the synthetic method of Sub 2-2 to obtain the product (20.6 g, yield: 81%).

Compounds belonging to Sub 2 may include, but are not limited to, the compounds below, and Table 2 shows the FD-MS (Field Desorption-Mass Spectrometry) values of compounds belonging to Sub 2.

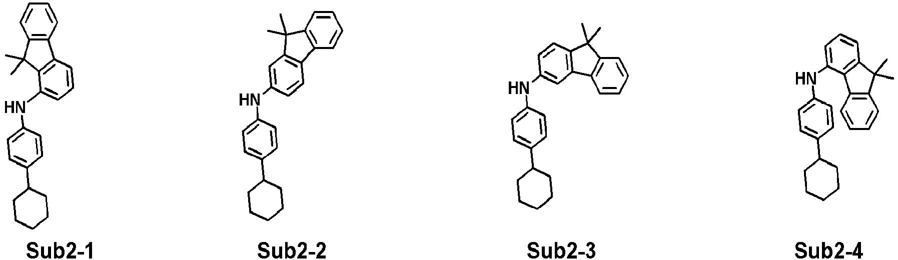

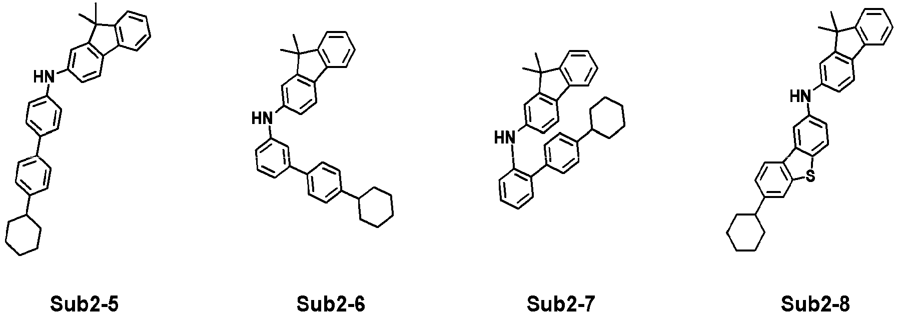

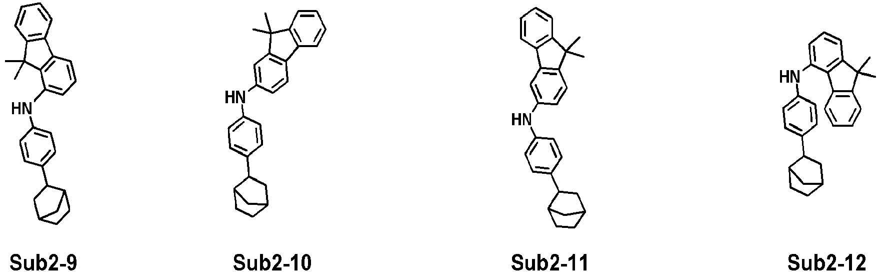

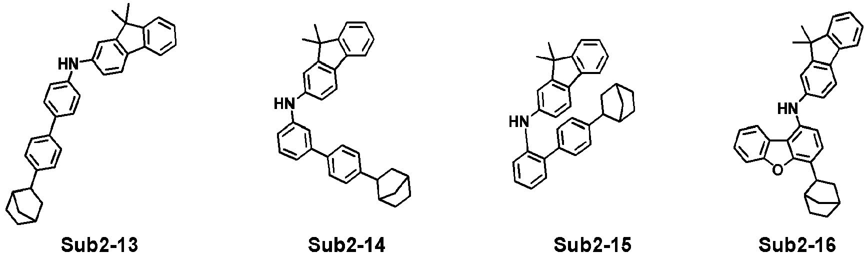

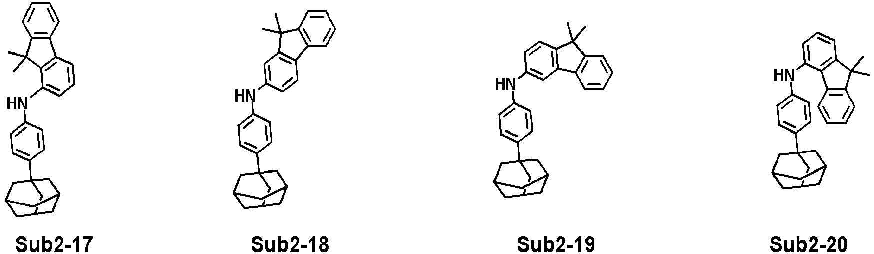

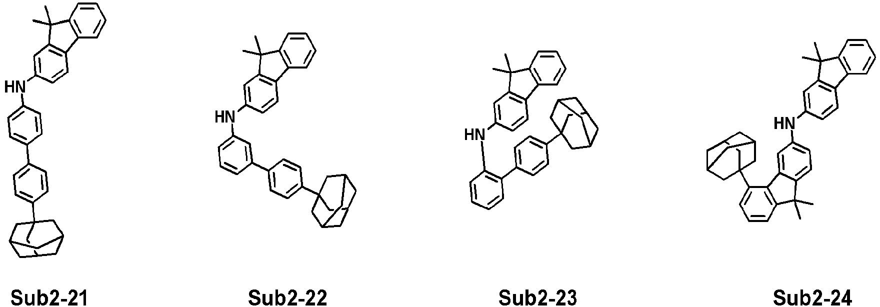

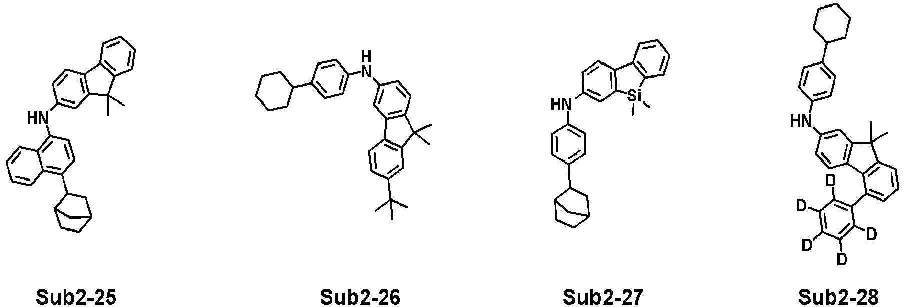

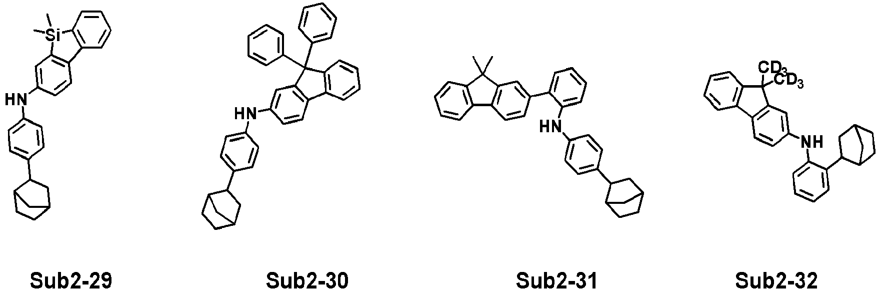

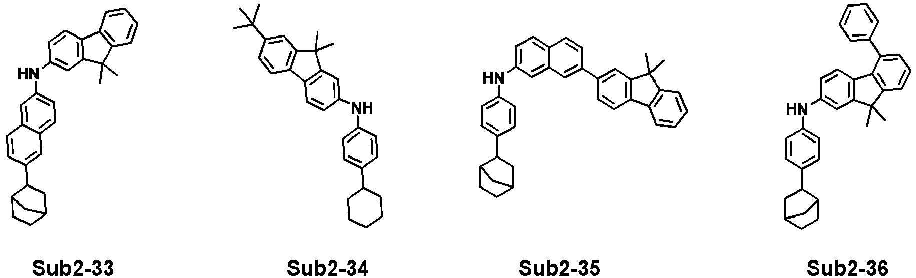

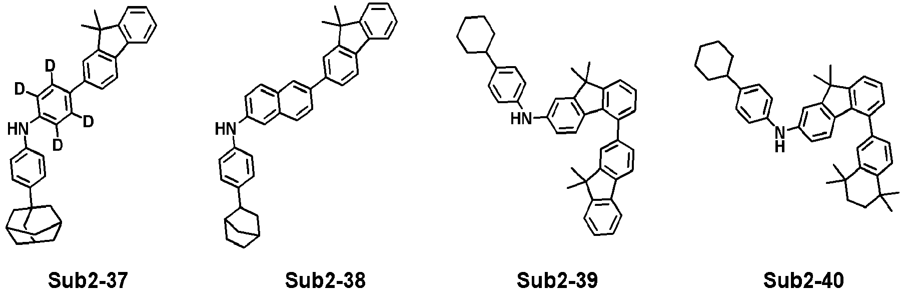

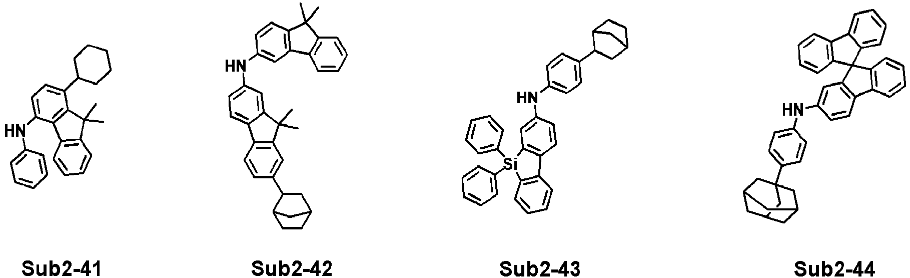

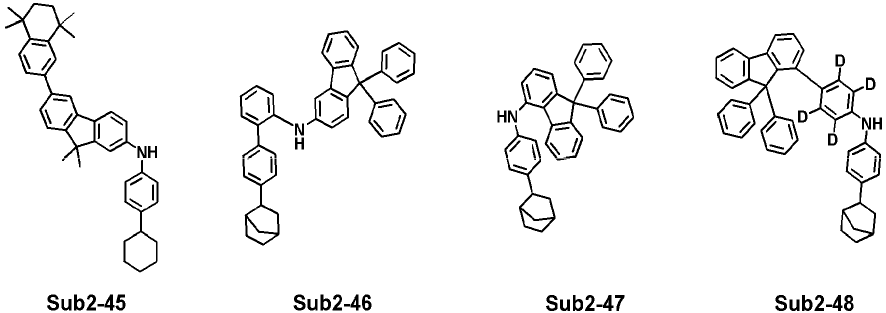

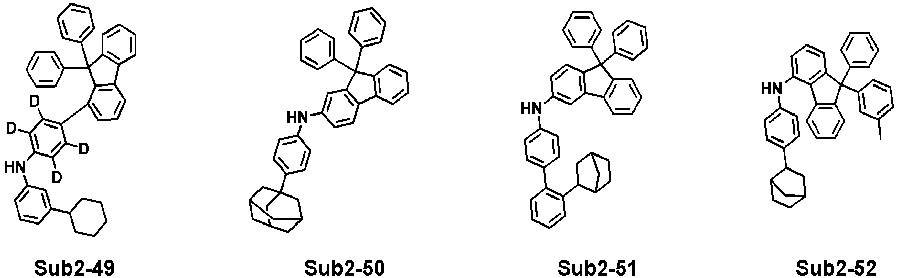

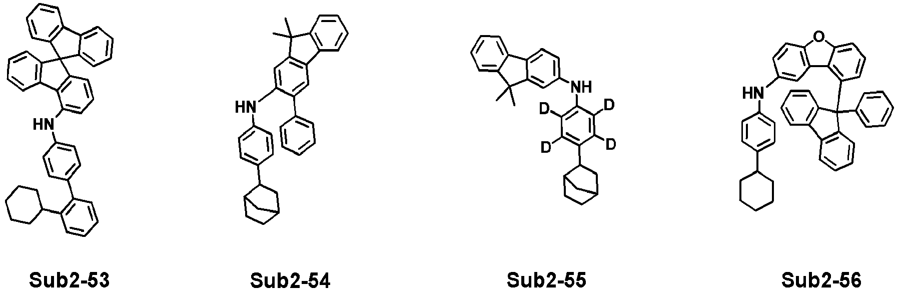

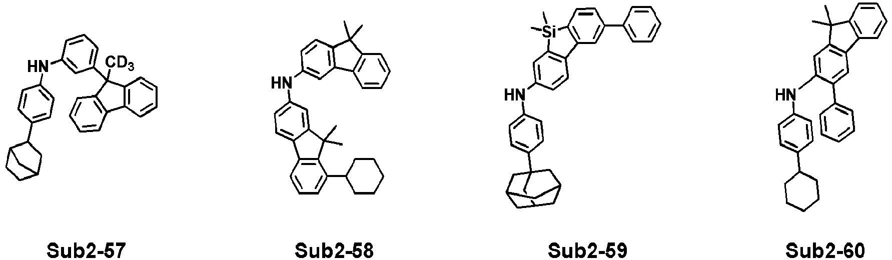

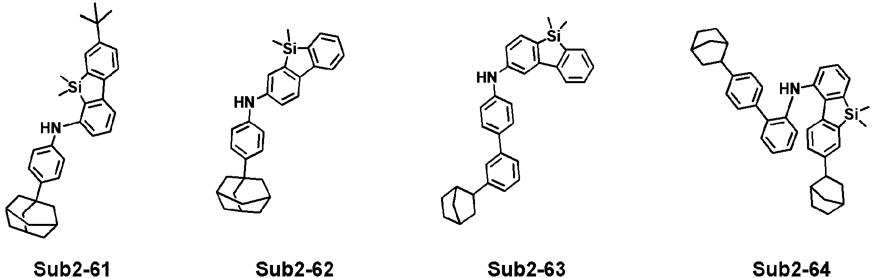

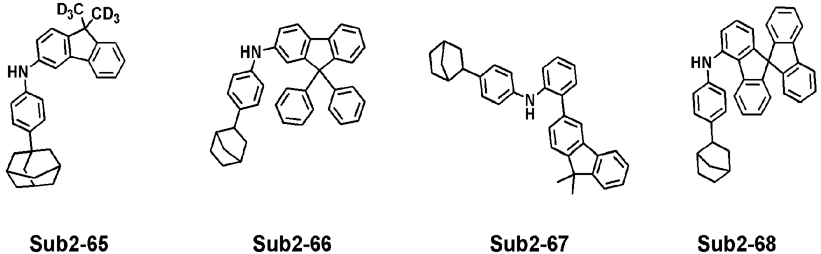

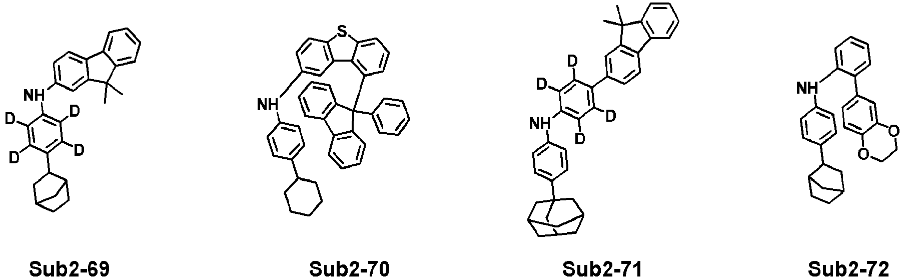

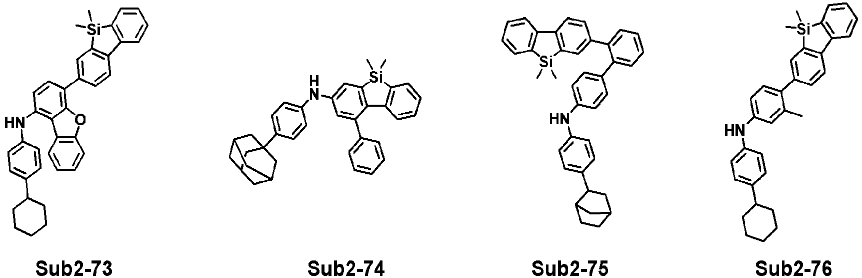

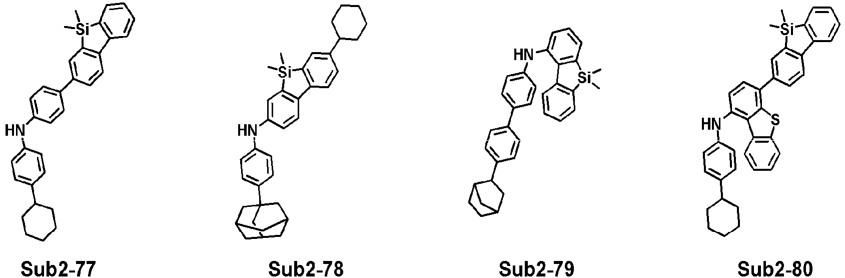

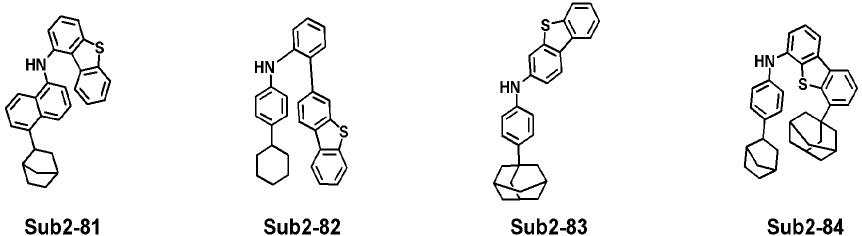

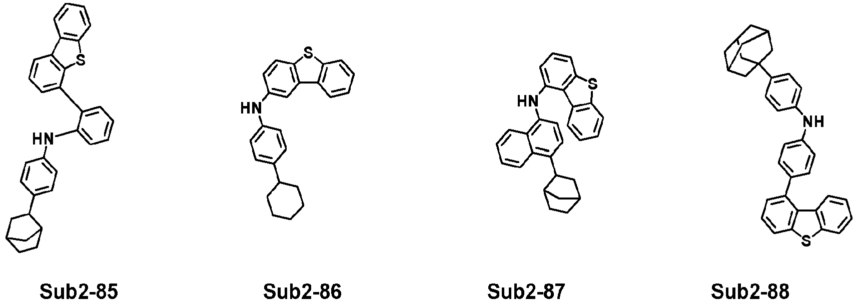

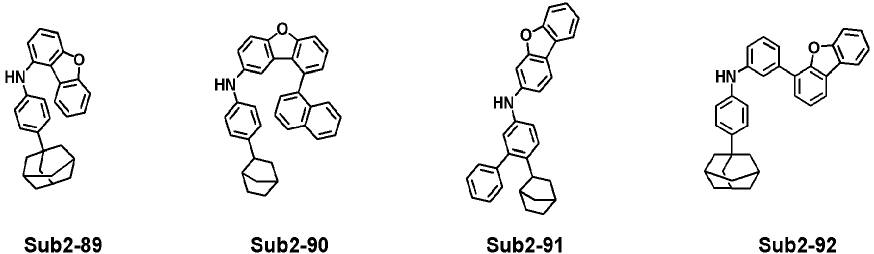

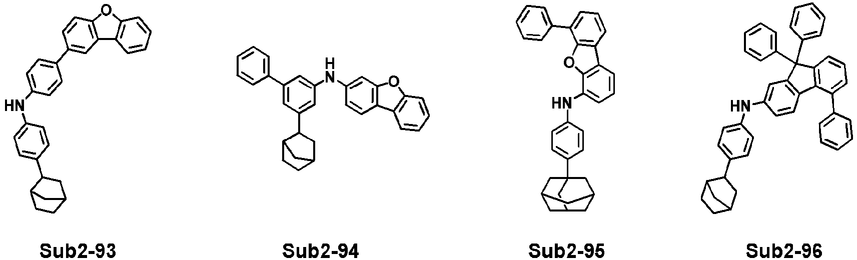

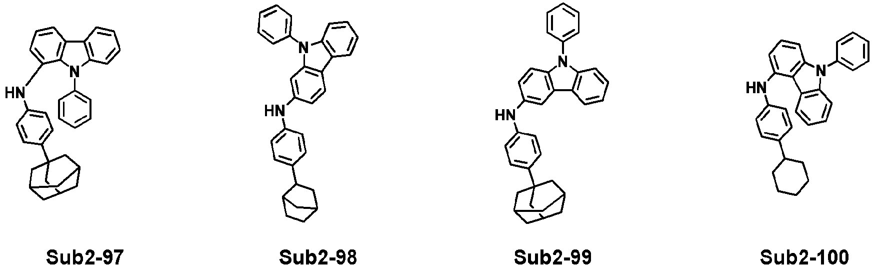

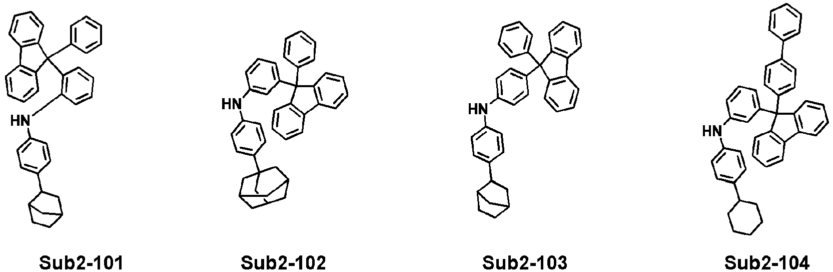

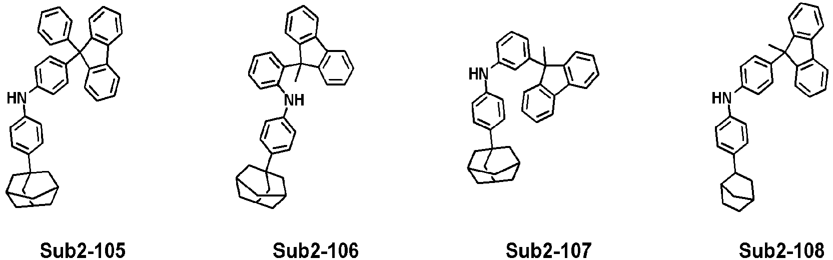

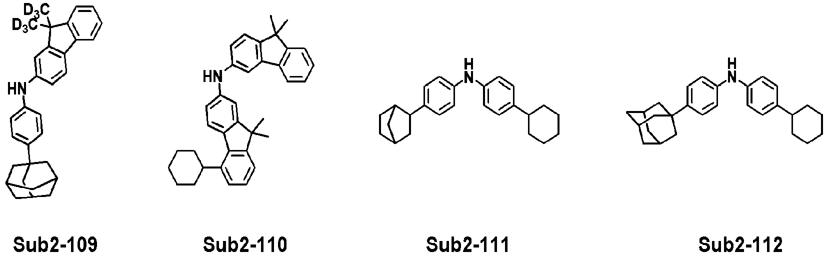

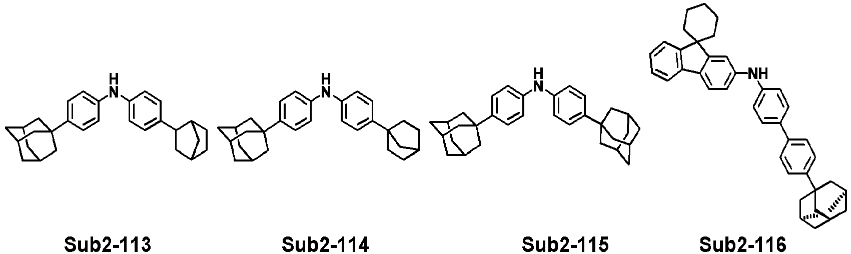

**[Table 2]**

| compound | FD-MS | compound | FD-MS |
|---|---|---|---|
| Sub 2-1 | m/z=367.23(C₂₇H₂₉N=367.54) | Sub 2-2 | m/z=367.23(C₂₇H₂₉N=367.54) |
| Sub 2-3 | m/z=367.23(C₂₇H₂₉N=367.54) | Sub 2-4 | m/z=367.23(C₂₇H₂₉N=367.54) |
| Sub 2-5 | m/z=443.26(C₃₃H₃₃N=443.63) | Sub 2-6 | m/z=443.26(C₃₃H₃₃N=443.63) |
| Sub 2-7 | m/z=443.26(C₃₃H₃₃N=443.63) | Sub 2-8 | m/z=473.22(C₃₃H₃₁NS=473.68) |
| Sub 2-9 | m/z=379.23(C₂₈H₂₉N=379.55) | Sub 2-10 | m/z=379.23(C₂₈H₂₉N=379.55) |
| Sub 2-11 | m/z=379.23(C₂₈H₂₉N=379.55) | Sub 2-12 | m/z=379.23(C₂₈H₂₉N=379.55) |
| Sub 2-13 | m/z=455.26(C₃₄H₃₃N=455.64) | Sub 2-14 | m/z=455.26(C₃₄H₃₃N=455.64) |
| Sub 2-15 | m/z=455.26(C₃₄H₃₃N=455.64) | Sub 2-16 | m/z=469.24(C₃₄H₃₁NO=469.63) |
| Sub 2-17 | m/z=419.26(C₃₁H₃₃N=419.61) | Sub 2-18 | m/z=419.26(C₃₁H₃₃N=419.61) |
| Sub 2-19 | m/z=419.26(C₃₁H₃₃N=419.61) | Sub 2-20 | m/z=419.26(C₃₁H₃₃N=419.61) |
| Sub 2-21 | m/z=495.29(C₃₇H₃₇N=495.71) | Sub 2-22 | m/z=495.29(C₃₇H₃₇N=495.71) |
| Sub 2-23 | m/z=495.29(C₃₇H₃₇N=495.71) | Sub 2-24 | m/z=535.32(C₄₀H₄₁N=535.77) |
| Sub 2-25 | m/z=429.25(C₃₂H₃₁N=429.61) | Sub 2-26 | m/z=423.29(C₃₁H₃₇N=423.64) |
| Sub 2-27 | m/z=395.21(C₂₇H₂₉NSi=395.62) | Sub 2-28 | m/z=448.29(C₃₃H₂₈D₅N=448.66) |
| Sub 2-29 | m/z=395.21(C₂₇H₂₉NSi=395.62) | Sub 2-30 | m/z=503.26(C₃₈H₃₃N=503.69) |
| Sub 2-31 | m/z=455.26(C₃₄H₃₃N=455.64) | Sub 2-32 | m/z=385.27(C₂₈H₂₃D₆N=385.58) |
| Sub 2-33 | m/z=429.25(C₃₂H₃₁N=429.61) | Sub 2-34 | m/z=423.29(C₃₁H₃₇N=423.64) |
| Sub 2-35 | m/z=505.28(C₃₈H₃₅N=505.7) | Sub 2-36 | m/z=455.26(C₃₄H₃₃N=455.64) |
| Sub 2-37 | m/z=499.32(C₃₇H₃₃D₄N=499.73) | Sub 2-38 | m/z=505.28(C₃₈H₃₅N=505.7) |
| Sub 2-39 | m/z=559.32(C₄₂H₄₁N=559.8) | Sub 2-40 | m/z=553.37(C₄₁H₄₇N=553.83) |
| Sub 2-41 | m/z=367.23(C₂₇H₂₉N=367.54) | Sub 2-42 | m/z=495.29(C₃₇H₃₇N=495.71) |
| Sub 2-43 | m/z=519.24(C₃₇H₃₃NSi=519.76) | Sub 2-44 | m/z=541.28(C₄₁H₃₅N=541.74) |
| Sub 2-45 | m/z=553.37(C₄₁H₄₇N=553.83) | Sub 2-46 | m/z=579.29(C₄₄H₃₇N=579.79) |
| Sub 2-47 | m/z=503.26(C₃₈H₃₃N=503.69) | Sub 2-48 | m/z=583.32(C₄₄H₃₃D₄N=583.81) |
| Sub 2-49 | m/z=571.32(C₄₃H₃₃D₄N=571.8) | Sub 2-50 | m/z=543.29(C₄₁H₃₇N=543.75) |
| Sub 2-51 | m/z=579.29(C₄₄H₃₇N=579.79) | Sub 2-52 | m/z=517.28(C₃₉H₃₅N=517.72) |
| Sub 2-53 | m/z=565.28(C₄₃H₃₅N=565.76) | Sub 2-54 | m/z=455.26(C₃₄H₃₃N=455.64) |
| Sub 2-55 | m/z=383.26(C₂₈H₂₅D₄N=383.57) | Sub 2-56 | m/z=581.27(C₄₃H₃₅NO=581.76) |
| Sub 2-57 | m/z=444.26(C₃₃H₂₈D₃N=444.64) | Sub 2-58 | m/z=483.29(C₃₆H₃₇N=483.7) |
| Sub 2-59 | m/z=511.27(C₃₆H₃₇NSi=511.78) | Sub 2-60 | m/z=443.26(C₃₃H₃₃N=443.63) |
| Sub 2-61 | m/z=491.3(C₃₄H₄₁NSi=491.79) | Sub 2-62 | m/z=435.24(C₃₀H₃₃NSi=435.69) |
| Sub 2-63 | m/z=471.24(C₃₃H₃₃NSi=471.72) | Sub 2-64 | m/z=565.32(C₄₀H₄₃NSi=565.88) |
| Sub 2-65 | m/z=425.3(C₃₁H₂₇D₆N=425.65) | Sub 2-66 | m/z=503.26(C₃₈H₃₃N=503.69) |
| Sub 2-67 | m/z=455.26(C₃₄H₃₃N=455.64) | Sub 2-68 | m/z=501.25(C₃₈H₃₁N=501.67) |
| Sub 2-69 | m/z=383.26(C₂₈H₂₅D₄N=383.57) | Sub 2-70 | m/z=597.25(C₄₃H₃₅NS=597.82) |
| Sub 2-71 | m/z=499.32(C₃₇H₃₃D₄N=499.73) | Sub 2-72 | m/z=397.2(C₂₇H₂₇NO₂=397.52) |
| Sub 2-73 | m/z=549.25(C₃₈H₃₅NOSi=549.79) | Sub 2-74 | m/z=511.27(C₃₆H₃₇NSi=511.78) |
| Sub 2-75 | m/z=547.27(C₃₉H₃₇NSi=547.82) | Sub 2-76 | m/z=473.25(C₃₃H₃₅NSi=473.74) |
| Sub 2-77 | m/z=459.24(C₃₂H₃₃NSi=459.71) | Sub 2-78 | m/z=517.32(C₃₆H₄₃NSi=517.83) |
| Sub 2-79 | m/z=471.24(C₃₃H₃₃NSi=471.72) | Sub 2-80 | m/z=565.23(C₃₈H₃₅NSSi=565.85) |
| Sub 2-81 | m/z=419.17(C₂₉H₂₅NS=419.59) | Sub 2-82 | m/z=433.19(C₃₀H₂₇NS=433.61) |
| Sub 2-83 | m/z=409.19(C₂₈H₂₇NS=409.59) | Sub 2-84 | m/z=503.26(C₃₅H₃₇NS=503.75) |
| Sub 2-85 | m/z=445.19(C₃₁H₂₇NS=445.62) | Sub 2-86 | m/z=357.16(C₂₄H₂₃NS=357.52) |
| Sub 2-87 | m/z=419.17(C₂₉H₂₅NS=419.59) | Sub 2-88 | m/z=485.22(C₃₄H₃₁NS=485.69) |
| Sub 2-89 | m/z=393.21(C₂₈H₂₇NO=393.53) | Sub 2-90 | m/z=479.22(C₃₅H₂₉NO=479.62) |
| Sub 2-91 | m/z=429.21(C₃₁H₂₇NO=429.56) | Sub 2-92 | m/z=469.24(C₃₄H₃₁NO=469.63) |
| Sub 2-93 | m/z=429.21(C₃₁H₂₇NO=429.56) | Sub 2-94 | m/z=429.21(C₃₁H₂₇NO=429.56) |
| Sub 2-95 | m/z=469.24(C₃₄H₃₁NO=469.63) | Sub 2-96 | m/z=579.29(C₄₄H₃₇N=579.79) |
| Sub 2-97 | m/z=468.26(C₃₄H₃₂N₂=468.64) | Sub 2-98 | m/z=428.23(C₃₁H₂₈N₂=428.58) |
| Sub 2-99 | m/z=468.26(C₃₄H₃₂N₂=468.64) | Sub 2-100 | m/z=416.23(C₃₀H₂₈N₂=416.57) |
| Sub 2-101 | m/z=503.26(C₃₈H₃₃N=503.69) | Sub 2-102 | m/z=543.29(C₄₁H₃₇N=543.75) |
| Sub 2-103 | m/z=503.26(C₃₈H₃₃N=503.69) | Sub 2-104 | m/z=567.29(C₄₃H₃₇N=567.78) |
| Sub 2-105 | m/z=543.29(C₄₁H₃₇N=543.75) | Sub 2-106 | m/z=481.28(C₃₆H₃₅N=481.68) |
| Sub 2-107 | m/z=481.28(C₃₆H₃₅N=481.68) | Sub 2-108 | m/z=441.25(C₃₃H₃₁N=441.62) |
| Sub 2-109 | m/z=425.30(C₃₁H₂₇D₆N=425.65) | Sub 2-110 | m/z=483.29(C₃₆H₃₇N=483.70) |
| Sub2-111 | m/z=345.25(C₂₅H₃₁N=345.53) | Sub2-112 | m/z=385.28(C₂₈H₃₅N=385.59) |
| Sub2-113 | m/z=397.28(C₂₉H₃₅N=397.61) | Sub2-114 | m/z=397.28(C₂₉H₃₅N=397.61) |
| Sub2-115 | m/z=437.31(C₃₂H₃₉N=437.67) | Sub2-116 | m/z=535.77(C₄₀H₄₁N=535.77) |

### Synthesis example of Final Product

### 1. Synthesis example of P-10

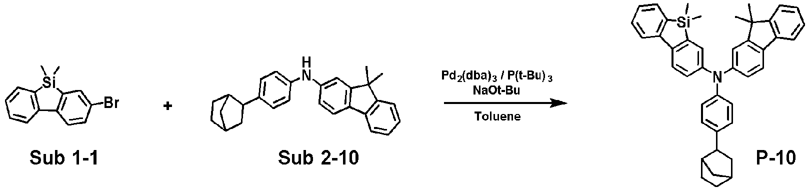

After dissolving Sub 1-1 (15.0 g, 52.1 mmol) in toluene (175 ml) in a round bottom flask, Sub 2-10 (19.8 g, 52.1 mmol), Pd₂(dba)₃ (1.4 g, 1.6 mmol), 50% P(t-Bu)₃ (1.3 ml, 3.1 mmol), NaOt-Bu (10.0 g, 104.2 mmol) were added and stirred at 110 °C. When the reaction was completed, the mixture was extracted with an organic solvent and water, the organic layer was dried over MgSO₄ and concentrated, and the resulting compound was subjected to column chromatography and recrystallization to obtain the product (25.4 g, yield: 83%).

### 2. Synthesis example of P-52

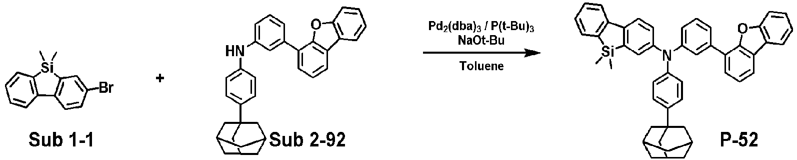

Sub 1-1 (12.0 g, 41.7 mmol), Sub 2-92 (19.6 g, 41.7 mmol), Pd₂(dba)₃ (1.1 g, 1.3 mmol), 50% P(t-Bu)₃ (1.0 ml, 2.5 mmol), NaOt-Bu (8.0 g, 83.3 mmol) were added to a round-bottom flask, and 28.2 g of the product (yield: 80%) was obtained using the synthetic method of P-10.

### 3. Synthesis example of P-70

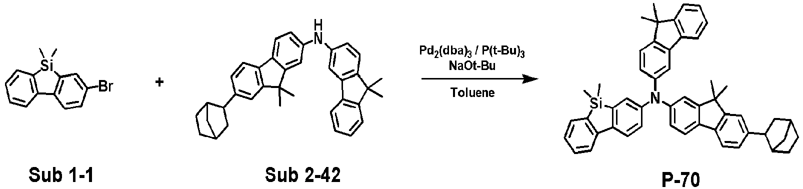

Sub 1-1 (10.0 g, 34.7 mmol), Sub 2-42 (17.2 g, 34.7 mmol), Pd₂(dba)₃ (1.0 g, 1.0 mmol), 50% P(t-Bu)₃ (0.8 ml, 2.1 mmol), NaOt-Bu (6.7 g, 69.4 mmol) were added to a round-bottom flask, and 18.1 g of the product (yield: 74%) was obtained using the synthetic method of P-10.

### 4. Synthesis example of P-73

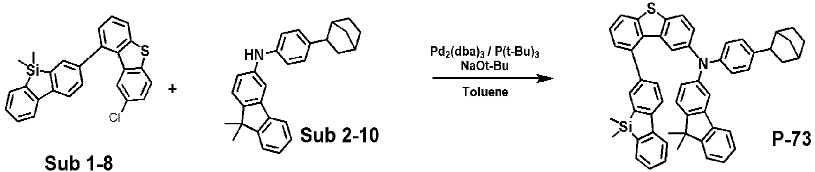

Sub 1-8 (15.0 g, 35.1 mmol), Sub 2-10 (16.0 g, 44.2 mmol), Pd₂(dba)₃ (1.0 g, 1.1 mmol), 50% P(t-Bu)₃ (0.9 ml, 2.1 mmol), NaOt-Bu (6.8 g, 70.3 mmol) were added to a round-bottom flask, and 18.4 g of the product (yield: 68%) was obtained using the synthetic method of P-10.

### 5. Synthesis example of P-80

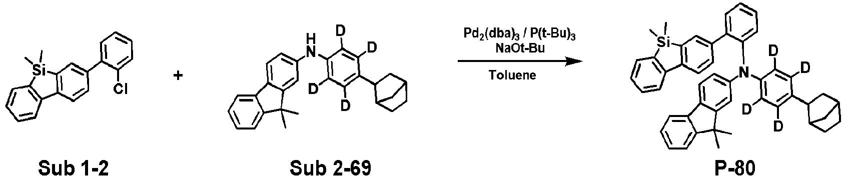

Sub 1-2 (10.0 g, 31.2 mmol), Sub 2-69 (12.0 g, 31.2 mmol), Pd₂(dba)₃ (0.9 g, 0.9 mmol), 50% P(t-Bu)₃ (0.8 ml, 1.9 mmol), NaOt-Bu (6.0 g, 62.5 mmol) were added to a round-bottom flask, and 16.3 g of the product (yield: 78%) was obtained using the synthetic method of P-10.

### 6. Synthesis example of P-86

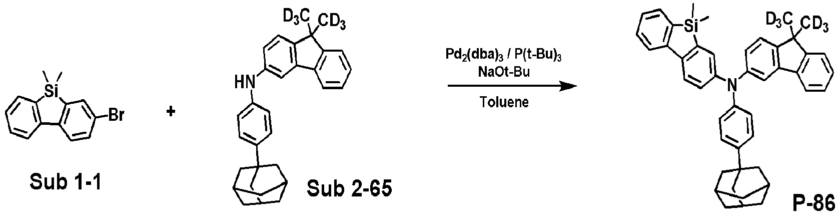

Sub 1-1 (10.0 g, 34.6 mmol), Sub 2-65 (17.7 g, 41.5 mmol), Pd₂(dba)₃ (0.9 g, 1.0 mmol), 50% P(t-Bu)₃ (0.8 ml, 2.1 mmol), NaOt-Bu (6.6 g, 69.1 mmol) were added to a round-bottom flask, and 16.2 g of the product (yield: 74%) was obtained using the synthetic method of P-10.

### 7. Synthesis example of P-95

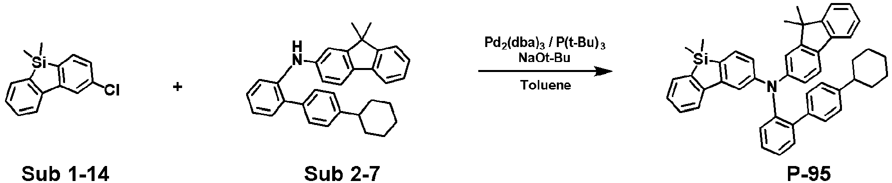

Sub 1-14 (9.0 g, 36.9 mmol), Sub 2-7 (16.3 g, 36.9 mmol), Pd₂(dba)₃ (1.0 g, 1.1 mmol), 50% P(t-Bu)₃ (0.9 ml, 2.2 mmol), NaOt-Bu (7.1 g, 73.8 mmol) were added to a round-bottom flask, and 19.5 g of the product (yield: 73%) was obtained using the synthetic method of P-10.

### 8. Synthesis example of P-130

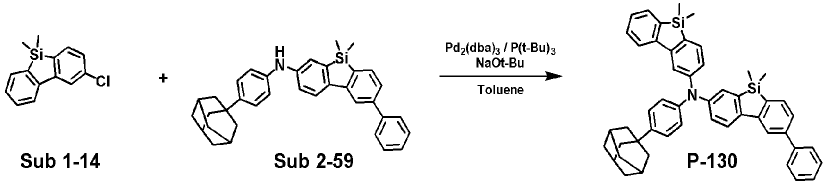

Sub 1-14 (8.0 g, 32.8 mmol), Sub 2-59 (16.8 g, 32.8 mmol), Pd₂(dba)₃ (0.9 g, 1.0 mmol), 50% P(t-Bu)₃ (0.8 ml, 2.0 mmol), NaOt-Bu (6.3 g, 65.6 mmol) were added to a round-bottom flask, and 17.7 g of the product (yield: 75%) was obtained using the synthetic method of P-10.

### 9. Synthesis example of P-147

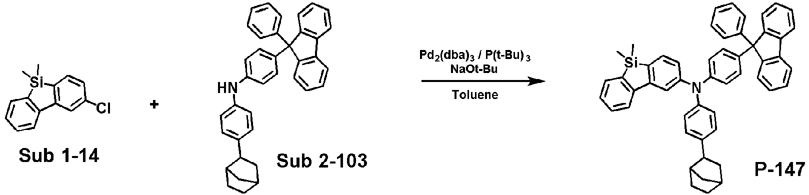

Sub 1-14 (18.0 g, 73.5 mmol), Sub 2-103 (44.4 g, 32.8 mmol), Pd₂(dba)₃ (2.0 g, 2.2 mmol), 50% P(t-Bu)₃ (1.8 ml, 4.4 mmol), NaOt-Bu (14.1 g, 147.1 mmol) were added to a round-bottom flask, and 38.2 g of the product (yield: 73%) was obtained using the synthetic method of P-10.

### 10. Synthesis example of P-149

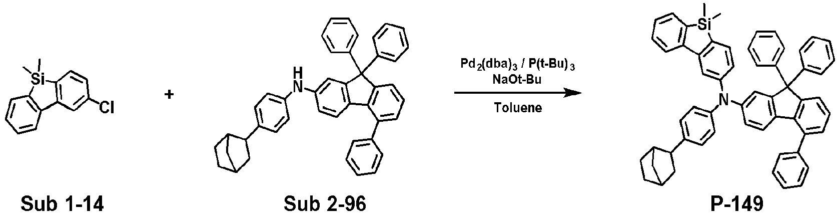

Sub 1-14 (8.0 g, 32.8 mmol), Sub 2-96 (19.0 g, 32.8 mmol), Pd₂(dba)₃ (0.9 g, 1.0 mmol), 50% P(t-Bu)₃ (0.8 ml, 3.2 mmol), NaOt-Bu (6.3 g, 65.6 mmol) were added to a round-bottom flask, and 18.6 g of the product (yield: 72%) was obtained using the synthetic method of P-10.

### 11. Synthesis example of P-162

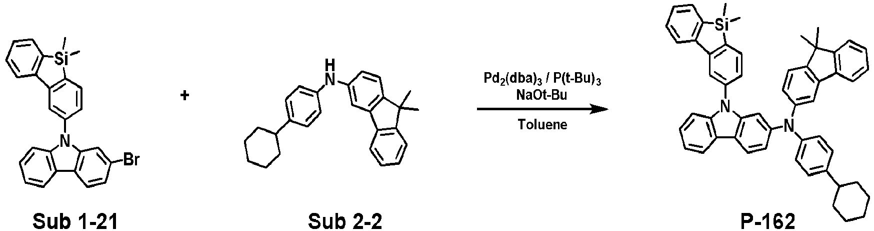

Sub 1-21 (10.0 g, 22.0 mmol), Sub 2-2 (8.1 g, 22.0 mmol), Pd₂(dba)₃ (0.6 g, 0.7 mmol), 50% P(t-Bu)₃ (0.6 ml, 1.3 mmol), NaOt-Bu (4.2 g, 44.0 mmol) were added to a round-bottom flask, and 11.4 g of the product (yield: 70%) was obtained using the synthetic method of P-10.

### 12. Synthesis example of P-176

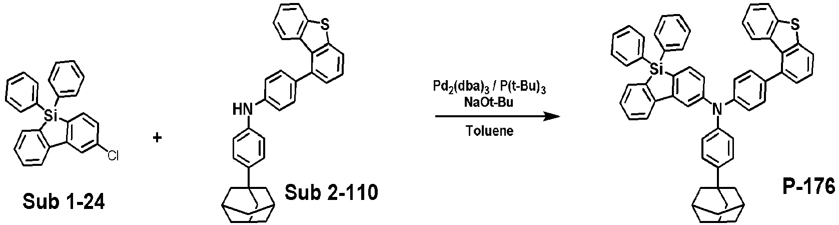

Sub 1-24 (15.0 g, 40.7 mmol), Sub 2-110 (23.7g, 48.8 mmol), Pd₂(dba)₃ (1.1 g, 1.2 mmol), 50% P(t-Bu)₃ (1.0 ml, 2.4 mmol), NaOt-Bu (7.8 g, 81.3 mmol) were added to a round-bottom flask, and 25.3 g of the product (yield: 76%) was obtained using the synthetic method of P-10.

Meanwhile, the FD-MS values of compounds P-1 to P-184 of the present invention manufactured according to the above synthetic examples are as shown in Table 3.

**[Table 3]**

| compound | FD-MS | compound | FD-MS |
|---|---|---|---|
| P-1 | m/z=575.3(C₄₁H₄₁NSi=575.87) | P-2 | m/z=575.3(C₄₁H₄₁NSi=575.87) |
| P-3 | m/z=575.3(C₄₁H₄₁NSi=575.87) | P-4 | m/z=575.3(C₄₁H₄₁NSi=575.87) |
| P-5 | m/z=651.33(C₄₇H₄₅NSi=651.97) | P-6 | m/z=651.33(C₄₇H₄₅NSi=651.97) |
| P-7 | m/z=651.33(C₄₇H₄₅NSi=651.97) | P-8 | m/z=681.29(C₄₇H₄₃NSSi=682.01) |
| P-9 | m/z=587.3(C₄₂H₄₁NSi=587.88) | P-10 | m/z=587.3(C₄₂H₄₁NSi=587.88) |
| P-11 | m/z=587.3(C₄₂H₄₁NSi=587.88) | P-12 | m/z=587.3(C₄₂H₄₁NSi=587.88) |
| P-13 | m/z=663.33(C₄₈H₄₅NSi=663.98) | P-14 | m/z=663.33(C₄₈H₄₅NSi=663.98) |
| P-15 | m/z=663.33(C₄₈H₄₅NSi=663.98) | P-16 | m/z=677.31(C₄₈H₄₃NOSi=677.96) |
| P-17 | m/z=627.33(C₄₅H₄₅NSi=627.95) | P-18 | m/z=627.33(C₄₅H₄₅NSi=627.95) |
| P-19 | m/z=627.33(C₄₅H₄₅NSi=627.95) | P-20 | m/z=627.33(C₄₅H₄₅NSi=627.95) |
| P-21 | m/z=703.36(C₅₁H₄₉NSi=704.04) | P-22 | m/z=703.36(C₅₁H₄₉NSi=704.04) |
| P-23 | m/z=703.36(C₅₁H₄₉NSi=704.04) | P-24 | m/z=743.39(C₅₄H₅₃NSi=744.11) |
| P-25 | m/z=637.32(C₄₆H₄₃NSi=637.94) | P-26 | m/z=707.39(C₅₁H₅₃NSi=708.08) |
| P-27 | m/z=663.33(C₄₈H₄₅NSi=663.98) | P-28 | m/z=732.39(C₅₃H₄₄D₅NSi=733.1) |
| P-29 | m/z=707.39(C₅₁H₄₅D4NSi=708.07) | P-30 | m/z=713.35(C₅₂H₄₇NSi=714.04) |
| P-31 | m/z=767.39(C₅₆H₅₃NSi=768.13) | P-32 | m/z=761.44(C₅₅H₅₉NSi=762.17) |
| P-33 | m/z=779.39(C₅₇H₄₅D₄NSi=780.14) | P-34 | m/z=751.36(C₅₅H₄₉NSi=752.09) |
| P-35 | m/z=787.36(C₅₈H₄₉NSi=788.12) | P-36 | m/z=725.35(C₅₃H₄₇NSi=726.05) |
| P-37 | m/z=699.37(C₄₈H₅₃NSi₂=700.13) | P-38 | m/z=643.31(C₄₄H₄₅NSi₂=644.02) |
| P-39 | m/z=679.31(C₄₇H₄₅NSi₂=680.05) | P-40 | m/z=773.39(C₅₄H₅₅NSi₂=774.21) |
| P-41 | m/z=757.32(C₅₂H₄₇NOSi₂=758.12) | P-42 | m/z=719.34(C₅₀H₄₉NSi₂=720.12) |
| P-43 | m/z=755.34(C₅₃H₄₉NSi₂=756.15) | P-44 | m/z=681.32(C₄₇H₄₇NSi₂=682.07) |
| P-45 | m/z=627.24(C₄₃H₃₇NSSi=627.92) | P-46 | m/z=641.26(C₄₄H₃₉NSSi=641.95) |
| P-47 | m/z=617.26(C₄₂H₃₉NSSi=617.93) | P-48 | m/z=711.34(C₄₉H₄₉NSSi=712.08) |
| P-49 | m/z=677.31(C₄₈H₄₃NOSi=677.96) | P-50 | m/z=687.3(C₄₉H₄₁NOSi=687.96) |
| P-51 | m/z=637.28(C₄₅H₃₉NOSi=637.9) | P-52 | m/z=677.31(C₄₈H₄₃NOSi=677.96) |
| P-53 | m/z=676.33(C₄₈H₄₄N₂Si=676.98) | P-54 | m/z=636.3(C₄₅H₄₀N₂Si=636.91) |
| P-55 | m/z=676.33(C₄₈H₄₄N₂Si=676.98) | P-56 | m/z=624.3(C₄₄H₄₀N₂Si=624.9) |
| P-57 | m/z=711.33(C₅₂H₄₅NSi=712.02) | P-58 | m/z=751.36(C₅₅H₄₉NSi=752.09) |
| P-59 | m/z=711.33(C₅₂H₄₅NSi=712.02) | P-60 | m/z=775.36(C₅₇H₄₉NSi=776.11) |
| P-61 | m/z=767.39(C₅₆H₅₃NSi=768.13) | P-62 | m/z=689.35(C₅₀H₄₇NSi=690.02) |
| P-63 | m/z=689.35(C₅₀H₄₇NSi=690.02) | P-64 | m/z=649.32(C₄₇H₄₃NSi=649.95) |
| P-65 | m/z=603.28(C₄₁H₄₁NSi₂=603.96) | P-66 | m/z=711.33(C₅₂H₄₅NSi=712.02) |
| P-67 | m/z=755.39(C₅₅H₅₃NSi=756.12) | P-68 | m/z=679.36(C₄₉H₄₉NSi=680.02) |
| P-69 | m/z=651.33(C₄₇H₄₅NSi=651.97) | P-70 | m/z=703.36(C₅₁H₄₉NSi=704.04) |
| P-71 | m/z=727.31(C₅₁H₄₅NSi₂=728.1) | P-72 | m/z=755.34(C₅₃H₄₉NSi₂=756.15) |
| P-73 | m/z=769.32(C₅₄H₄₇NSSi=770.12) | P-74 | m/z=740.36(C₅₃H₄₈N₂Si=741.07) |
| P-75 | m/z=749.35(C₅₅H₄₇NSi=750.07) | P-76 | m/z=773.35(C₅₇H₄₇NSi=774.09) |
| P-77 | m/z=713.35(C₅₂H₄₇NSi=714.04) | P-78 | m/z=751.36(C₅₅H₄₉NSi=752.09) |
| P-79 | m/z=663.33(C₄₈H₄₅NSi=663.98) | P-80 | m/z=667.36(C₄₈H₄₁D₄NSi=668) |
| P-81 | m/z=707.39(C₅₁H₄₅D₄NSi=708.07) | P-82 | m/z=643.31(C₄₄H₄₅NSi₂=644.02) |
| P-83 | m/z=751.36(C₅₅H₄₉NSi=752.09) | P-84 | m/z=689.35(C₅₀H₄₇NSi=690.02) |
| P-85 | m/z=789.34(C₅₇H₄₇NOSi=790.09) | P-86 | m/z=633.37(C₄₅H₃₉D₆NSi=633.98) |
| P-87 | m/z=669.37(C₄₈H₃₉D₆NSi=670.02) | P-88 | m/z=711.33(C₅₂H₄₅NSi=712.02) |
| P-89 | m/z=575.3(C₄₁H₄₁NSi=575.87) | P-90 | m/z=575.3(C₄₁H₄₁NSi=575.87) |
| P-91 | m/z=575.3(C₄₁H₄₁NSi=575.87) | P-92 | m/z=575.3(C₄₁H₄₁NSi=575.87) |
| P-93 | m/z=651.33(C₄₇H₄₅NSi=651.97) | P-94 | m/z=651.33(C₄₇H₄₅NSi=651.97) |
| P-95 | m/z=651.33(C₄₇H₄₅NSi=651.97) | P-96 | m/z=665.31(C₄₇H₄₃NOSi=665.95) |
| P-97 | m/z=587.3(C₄₂H₄₁NSi=587.88) | P-98 | m/z=587.3(C₄₂H₄₁NSi=587.88) |
| P-99 | m/z=587.3(C₄₂H₄₁NSi=587.88) | P-100 | m/z=587.3(C₄₂H₄₁NSi=587.88) |
| P-101 | m/z=663.33(C₄₈H₄₅NSi=663.98) | P-102 | m/z=663.33(C₄₈H₄₅NSi=663.98) |
| P-103 | m/z=663.33(C₄₈H₄₅NSi=663.98) | P-104 | m/z=693.29(C₄₈H₄₃NSSi=694.02) |
| P-105 | m/z=627.33(C₄₅H₄₅NSi=627.95) | P-106 | m/z=627.33(C₄₅H₄₅NSi=627.95) |
| P-107 | m/z=627.33(C₄₅H₄₅NSi=627.95) | P-108 | m/z=627.33(C₄₅H₄₅NSi=627.95) |
| P-109 | m/z=703.36(C₅₁H₄₉NSi=704.04) | P-110 | m/z=703.36(C₅₁H₄₉NSi=704.04) |
| P-111 | m/z=703.36(C₅₁H₄₉NSi=704.04) | P-112 | m/z=749.43(C₅₄H₄₇D₆NSi=750.15) |
| P-113 | m/z=637.32(C₄₆H₄₃NSi=637.94) | P-114 | m/z=707.39(C₅₁H₅₃NSi=708.08) |
| P-115 | m/z=663.33(C₄₈H₄₅NSi=663.98) | P-116 | m/z=651.33(C₄₇H₄₅NSi=651.97) |
| P-117 | m/z=707.39(C₅₁H₄₅D₄NSi=708.07) | P-118 | m/z=713.35(C₅₂H₄₇NSi=714.04) |
| P-119 | m/z=663.33(C₄₈H₄₅NSi=663.98) | P-120 | m/z=761.44(C₅₅H₅₉NSi=762.17) |
| P-121 | m/z=791.39(C₅₈H₄₅D₄NSi=792.15) | P-122 | m/z=751.36(C₅₅H₄₉NSi=752.09) |
| P-123 | m/z=787.36(C₅₈H₄₉NSi=788.12) | P-124 | m/z=711.33(C₅₂H₄₅NSi=712.02) |
| P-125 | m/z=725.39(C₅₀H₅₅NSi₂=726.17) | P-126 | m/z=643.31(C₄₄H₄₅NSi₂=644.02) |
| P-127 | m/z=679.31(C₄₇H₄₅NSi₂=680.05) | P-128 | m/z=679.31(C₄₇H₄₅NSi₂=680.05) |
| P-129 | m/z=773.3(C₅₂H₄₇NSSi₂=774.18) | P-130 | m/z=719.34(C₅₀H₄₉NSi₂=720.12) |
| P-131 | m/z=755.34(C₅₃H₄₉NSi₂=756.15) | P-132 | m/z=667.31(C₄₆H₄₅NSi₂=668.04) |
| P-133 | m/z=627.24(C₄₃H₃₇NSSi=627.92) | P-134 | m/z=565.23(C₃₈H₃₅NSSi=565.85) |
| P-135 | m/z=693.29(C₄₈H₄₃NSSi=694.02) | P-136 | m/z=653.26(C₄₅H₃₉NSSi=653.96) |
| P-137 | m/z=682.34(C₄₈H₃₈D₅NOSi=682.99) | P-138 | m/z=637.28(C₄₅H₃₉NOSi=637.9) |
| P-139 | m/z=637.28(C₄₅H₃₉NOSi=637.9) | P-140 | m/z=677.31(C₄₈H₄₃NOSi=677.96) |
| P-141 | m/z=676.33(C₄₈H₄₄N₂Si=676.98) | P-142 | m/z=636.3(C₄₅H₄₀N₂Si=636.91) |
| P-143 | m/z=676.33(C₄₈H₄₄N₂Si=676.98) | P-144 | m/z=624.3(C₄₄H₄₀N₂Si=624.9) |
| P-145 | m/z=711.33(C₅₂H₄₅NSi=712.02) | P-146 | m/z=751.36(C₅₅H₄₉NSi=752.09) |
| P-147 | m/z=711.33(C₅₂H₄₅NSi=712.02) | P-148 | m/z=775.36(C₅₇H₄₉NSi=776.11) |
| P-149 | m/z=787.36(C₅₈H₄₉NSi=788.12) | P-150 | m/z=689.35(C₅₀H₄₇NSi=690.02) |
| P-151 | m/z=689.35(C₅₀H₄₇NSi=690.02) | P-152 | m/z=649.32(C₄₇H₄₃NSi=649.95) |
| P-153 | m/z=603.28(C₄₁H₄₁NSi₂=603.96) | P-154 | m/z=711.33(C₅₂H₄₅NSi=712.02) |
| P-155 | m/z=663.33(C₄₈H₄₅NSi=663.98) | P-156 | m/z=593.34(C₄₂H₃₅D₆NSi=593.92) |
| P-157 | m/z=651.33(C₄₇H₄₅NSi=651.97) | P-158 | m/z=609.29(C₄₄H₃₉NSi=609.89) |
| P-159 | m/z=605.28(C₄₁H₃₉NO₂Si=605.85) | P-160 | m/z=755.34(C₅₃H₄₉NSi₂=756.15) |
| P-161 | m/z=753.34(C₅₄H₄₇NOSi=754.06) | P-162 | m/z=740.36(C₅₃H₄₈N₂Si=741.07) |
| P-163 | m/z=749.35(C₅₅H₄₇NSi=750.07) | P-164 | m/z=709.32(C₅₂H₄₃NSi=710.01) |
| P-165 | m/z=713.35(C₅₂H₄₇NSi=714.04) | P-166 | m/z=751.36(C₅₅H₄₉NSi=752.09) |
| P-167 | m/z=663.33(C₄₈H₄₅NSi=663.98) | P-168 | m/z=667.36(C₄₈H₄₁D4NSi=668) |
| P-169 | m/z=707.39(C₅₁H₄₅D₄NSi=708.07) | P-170 | m/z=603.28(C₄₁H₄₁NSi₂=603.96) |
| P-171 | m/z=751.36(C₅₅H₄₉NSi=752.09) | P-172 | m/z=652.34(C₄₇H₄₀D₃NSi=652.97) |
| P-173 | m/z=805.32(C₅₇H₄₇NSSi=806.15) | P-174 | m/z=633.37(C₄₅H₃₉D₆NSi=633.98) |
| P-175 | m/z=669.37(C₄₈H₃₉D₆NSi=670.02) | P-176 | m/z=817.32(C₅₈H₄₇NSSi=818.17) |
| P-177 | m/z=575.30(C₄₁H₄₁NSi=575.87) | P-178 | m/z=575.30(C₄₁H₄₁NSi=575.87) |
| P-179 | m/z=553.32(C₃₉H₄₃NSi=553.87) | P-180 | m/z=593.35(C₄₂H₄₇NSi=593.93) |
| P-181 | m/z=605.35(C₄₃H₄₇NSi=605.94) | P-182 | m/z=605.35(C₄₃H₄₇NSi=605.94) |
| P-183 | m/z=645.38(C₄₆H₅₁NSi=646.01) | P-184 | m/z=743.39(C₅₄H₅₃NSi=744.11) |

### Manufacturing Evaluation of Organic Electroluminescent Devices

### [Example 1] Red Organic Electroluminescent Device (Emitting-Auxiliary Layer)

First, 4,4',4"-Tris[2-naphthyl(phenyl)amino]triphenylamine (hereinafter abbreviated as 2-TNATA) was vacuum-deposited to a thickness of 70 nm on the ITO layer (anode) formed on a glass substrate to form a hole injection layer, and then N,N'-bis(1-naphthalenyl)-N,N'-bis-phenyl-(1,1'-biphenyl)-4,4'-diamine (hereinafter, NPB) was vacuum-deposited as a hole transport compound to a thickness of 70 nm on the hole injection layer to form a hole transport layer. Subsequently, compound P-2 of the present invention was vacuum deposited on the hole transport layer to a thickness of 20 nm to form an emitting-auxiliary layer. Next, an emitting layer was formed by vacuum deposition to a thickness of 40 nm by doping 4,4'-N,N'-dicarbazole-biphenyl (hereinafter abbreviated as CBP) as a host material and bis-(1-phenylisoquinolyl)iridium(III)acetylacetonate (hereinafter abbreviated as (piq)₂Ir(acac)) as a dopant material on the emitting-auxiliary layer at a weight ratio of 95:5. Next, (1,1'-biphenyl-4-olato)bis(2-methyl-8-quinolinolato)aluminum (hereinafter abbreviated as BAlq) is vacuum-deposited to a thickness of 10 nm on the emitting layer to form a hole blocking layer and bis(10-hydroxybenzo[h]quinolinato)beryllium (hereinafter abbreviated as "BeBq₂") was vacuum deposited to a thickness of 40 nm on the hole blocking layer to form an electron transport layer. Afterwards, LiF, a halogenated alkali metal, was deposited to a thickness of 0.2 nm on the electron transport layer to form an electron injection layer, and then an organic light-emitting device was manufactured by forming a cathode by depositing Al with a thickness of 150 nm on the electron injection layer.

### [Example 2] to [Example 16]

An organic electroluminescent device was manufactured in the same manner as in Example 1, except that the compound of the present invention described in Table 4 was used instead of the compound P-2 of the present invention as an emitting-auxiliary layer material.

### [Comparative Example 1] or [Comparative Example 2]

An organic electroluminescent device was manufactured in the same manner as Example 1, except that Comparative Compounds A or B were used instead of Compound P-2 of the present invention as an emitting-auxiliary layer material.

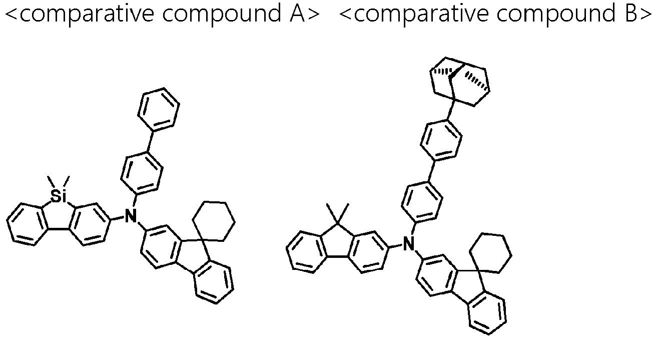

The electroluminescence (EL) characteristics of the organic electroluminescent devices manufactured in this manner were measured using a PR-650 from Photoresearch by applying a forward bias DC voltage to the devices. As a result of the measurement, the T95 lifespan was measured using a lifespan measuring device manufactured by Max Science at a standard luminance of 2500 cd/m². Table 4 shows the results of the device fabrication and evaluation.

**[Table 4]**

| | compound | Driving Voltage (V) | Current Density (mA/cm²) | Brightness (cd/m²) | Efficiency (cd/A) | T(95) |
|---|---|---|---|---|---|---|
| comparative example(1) | comparative compound A | 5.2 | 10.5 | 2500.0 | 23.8 | 91.4 |
| comparative example(2) | comparative compound B | 5.4 | 11.0 | 2500.0 | 22.6 | 101.2 |
| example(1) | compound(P-2) | 4.9 | 7.8 | 2500.0 | 32.0 | 109.2 |
| example(2) | compound(P-10) | 4.8 | 8.0 | 2500.0 | 31.4 | 112.6 |
| example(3) | compound(P-18) | 5.0 | 7.9 | 2500.0 | 31.7 | 118.1 |
| example(4) | compound(P-27) | 4.8 | 7.8 | 2500.0 | 32.1 | 113.8 |
| example(5) | compound(P-38) | 4.9 | 8.1 | 2500.0 | 30.9 | 109.3 |
| example(6) | compound(P-47) | 4.9 | 8.2 | 2500.0 | 30.6 | 115.9 |
| example(7) | compound(P-55) | 5.0 | 8.3 | 2500.0 | 30.3 | 110.4 |
| example(8) | compound(P-58) | 5.0 | 7.8 | 2500.0 | 31.9 | 114.6 |
| example(9) | compound(P-87) | 4.8 | 7.7 | 2500.0 | 32.4 | 118.3 |
| example(10) | compound(P-90) | 4.9 | 8.1 | 2500.0 | 30.8 | 111.5 |
| example(11) | compound(P-107) | 5.0 | 8.0 | 2500.0 | 31.2 | 117.0 |
| example(12) | compound(P-143) | 5.1 | 8.4 | 2500.0 | 29.7 | 109.4 |
| example(13) | compound(P-174) | 5.0 | 7.9 | 2500.0 | 31.6 | 121.6 |
| example(14) | compound(P-179) | 4.8 | 8.0 | 2500.0 | 31.1 | 109.5 |
| example(15) | compound (P-181) | 5.0 | 7.9 | 2500.0 | 31.5 | 114.8 |
| example(16) | compound(P-184) | 5.0 | 7.9 | 2500.0 | 31.8 | 112.2 |

As can be seen from the results in Table 4, when a red organic electroluminescent device is manufactured using a material for an organic electroluminescent device, it can be confirmed that the luminescence efficiency of the organic electroluminescent device is significantly improved in the examples using the compound of the present invention compared to the comparative examples using comparative compound A or comparative compound B as an emitting-auxiliary layer. To explain in more detail, there is a difference between Comparative Compound A and the compound of the present invention in the presence or absence of substitution of a cycloalkyl group with a substituent of an amine group. When a cycloalkyl group is introduced as a substituent, the refractive index may be lowered compared to a general aryl group, and this appears to result in an increase in the external quantum efficiency of the device.

Additionally, when comparing the comparative compound B and the compound of the present invention, there is a difference in the presence or absence of dibenzosilole.

The calculated Reorganization Energy (RE) values of comparative compounds B and P-184 are described in Table 5.

The RE values listed in Table 5 represent the values calculated from RE_{Hole}.

**[Table 5]**

| compound | Reorganization Energy (RE) |
|---|---|
| Comparative compound B | 0.123 |
| P-184 | 0.134 |

As can be seen from the above, it can be confirmed that the RE value of compound P-184 of the present invention is lower than that of comparative compound B. As can be seen in Comparative Example 2 and Example 16 in Table 4, the driving voltage of Example 16 is faster, so the hole transport characteristics of the compound of the present invention appear to be good, but the hole injection characteristics appear to be poor due to the low RE value. Due to the unique hole transport and hole injection characteristics of the dibenzosilole group, the turn-on voltage of the element is pushed down, causing light to be emitted in a narrow region of the interface between the emitting-auxiliary layer and the host. It is thought that this narrow light-emitting region actually has the effect of increasing light-emitting efficiency. That is, as can be seen from the above, it can be confirmed that the presence or absence of a cycloalkyl group and dibenzosilole has a great influence on the performance of the device. When the cycloalkyl group and dibenzosilole are substituted, the driving voltage or efficiency of the device is greatly affected, and it appears that the device performance of the compound of the present invention is maximized due to this.

In the case of an emitting-auxiliary layer, the relationship between the hole transport layer and the emitting layer (host) must be understood. Therefore, even if a similar core is used, it would be very difficult for even a person skilled in the art to infer the characteristics exhibited in the emitting-auxiliary layer in which the compound of the present invention is used.

Moreover, the evaluation results of the above-described device fabrication explained the device characteristics in which the compound of the present invention was applied only to the emitting-auxiliary layer, but the compound of the present invention can be used by applying it to the hole transport layer or by applying it to both the hole transport layer and the emitting-auxiliary layer.

Although exemplary embodiments of the present invention have been described for illustrative purposes, those skilled in the art will appreciate that various modifications, additions and substitutions are possible, without departing from the scope and spirit of the invention as disclosed in the accompanying claims. Therefore, the embodiment disclosed in the present invention is intended to illustrate the scope of the technical idea of the present invention, and the scope of the present invention is not limited by the embodiment. The scope of the present invention shall be construed on the basis of the accompanying claims, and it shall be construed that all of the technical ideas included within the scope equivalent to the claims belong to the present invention.

### [Industrial availability]

According to the present invention, it is possible to manufacture an organic device having excellent device characteristics of high luminance, high light emission and long life, and thus has industrial applicability.

## Claims

1. A compound represented by Formula 1: 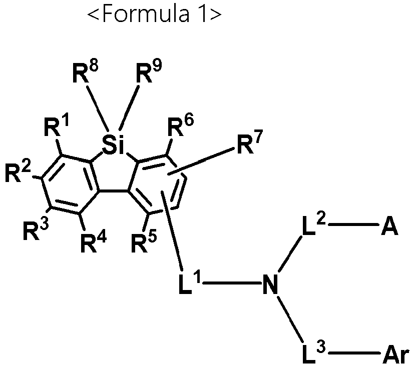 Wherein:
A is an C₃~C₆₀ cyloalkyl group,
R¹, R², R³, R⁴, R⁵, R⁶ and R⁷ are each independently selected from the group consisting of a hydrogen; deuterium; halogen; cyano group; nitro group; an C₆-C₆₀ aryl group;
fluorenyl group; a C₂-C₆₀ heterocyclic group including at least one heteroatom of O, N, S, Si or P; a fused ring group of a C₃-C₆₀ aliphatic ring and a C₆-C₆₀ aromatic ring; a C₁-C₆₀ alkyl group; a C₂-C₆₀ alkenyl group; a C₂-C₆₀ alkynyl group; a C₁-C₆₀ alkoxy group;
and a C₆-C₆₀ aryloxy group; or can be bonded to each other to form a ring.
R⁸ and R⁹ are each independently a C₁-C₆₀ alkyl group,
L¹, L² and L³ are each independently selected from the group consisting of a single bond; a C₆-C₆₀ arylene group; fluorenylene group; a C₂-C₆₀ heterocyclic group including at least one heteroatom of O, N, S, Si or P; and a fused ring group of a C₃-C₆₀ aliphatic ring and a C₆-C₆₀ aromatic ring;
Ar is a C₁-C₆₀ alkyl group; a C₃-C₆₀ cycloalkyl group; an C₆-C₆₀ aryl group; fluorenyl group; a C₂-C₆₀ heterocyclic group including at least one heteroatom of O, N, S, Si or P; a C₃-C₆₀ aliphatic ring; and a fused ring group of a C₃-C₆₀ aliphatic ring and a C₆-C₆₀ aromatic ring;
Wherein the aryl group, arylene group, heterocyclic group, fluorenyl group, fluorenylene group, aliphatic ring group, fused ring group, cycloalkyl group, alkyl group, alkenyl group, alkynyl group, alkoxy group and aryloxy group may be substituted with one or more substituents selected from the group consisting of deuterium; halogen; silane group; siloxane group; boron group; germanium group; cyano group; nitro group; C₁-C₂₀ alkylthio group; C₁-C₂₀ alkoxyl group; C₁-C₂₀ alkyl group; C₂-C₂₀ alkenyl group; C₂-C₂₀ alkynyl group; C₆-C₂₀ aryl group; C₆-C₂₀ aryl group substituted with deuterium; fluorenyl group; a C₂-C₂₀ heterocyclic group; a C₃-C₂₀ cycloalkyl group; a C₇-C₂₀ arylalkyl group; and C₈-C₂₀ arylalkenyl group; and also the substituents may be bonded to each other to form a saturated or unsaturated ring, wherein the term 'ring' means a C₃-C₆₀ aliphatic ring or a C₆-C₆₀ aromatic ring or a C₂-C₆₀ heterocyclic group or a fused ring formed by the combination thereof.

2. The compound according to claim 1, wherein A is represented by any one of the following Formulas A-1 to A-5: 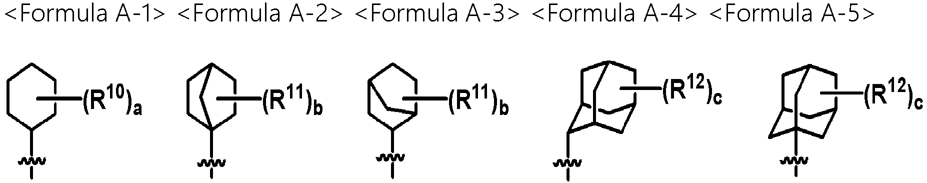 Wherein:
R¹⁰, R¹¹ and R¹² are each independently the same or different, and each independently selected from the group consisting of a hydrogen; deuterium; halogen; C₁-C₂₀ alkoxyl group; C₁-C₂₀ alkyl group; C₂-C₂₀ alkenyl group; C₂-C₂₀ alkynyl group; C₆-C₂₀ aryl group;
C₆-C₂₀ aryl group substituted with deuterium; a fluorenyl group; C₂~C₂₀ heterocyclic group; C₃-C₂₀ cycloalkyl group; C₇-C₂₀ arylalkyl group; and C₈-C₂₀ arylalkenyl group;
a and b are independently integers from 0 to 11, c is an integer from 0 to 15,
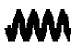 refers to the position to be bonded.

3. The compound according to claim 1, wherein Ar is represented by the following Formula Ar-1 or Formula Ar-2: 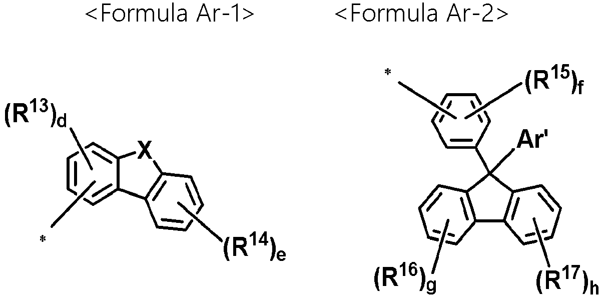 Wherein;
X is NR', O, S, CR'R" or SiR'R"
Ar' is selected from the group consisting of a C₁-C₆₀ alkyl group; an C₆-C₆₀ aryl group; fluorenyl group; a C₂-C₆₀ heterocyclic group including at least one heteroatom of O, N, S, Si or P; a C₃-C₆₀ aliphatic ring; a fused ring group of a C₃-C₆₀ aliphatic ring and a C₆-C₆₀ aromatic ring;
R¹³, R¹⁴, R¹⁵, R¹⁶ and R¹⁷ are the same as the definition of R¹⁰ of the claim 2 or an adjacent plurality of R¹³s or of plurality of R¹⁴s or of plurality of R¹⁵s or of plurality of R¹⁶s or of plurality of R¹⁷s may be bonded to each other to form a ring,
d is an integer from 0 to 3, e, f, g and h are independently integers from 0 to 4,
R' and R" are each independently selected from the group consisting of a hydrogen; deuterium; a C₁-C₆₀ alkyl group; a C₁-C₆₀ alkyl group substituted with deuterium; an C₆-C₆₀ aryl group; and a C₂-C₆₀ heterocyclic group including at least one heteroatom of O, N, S, Si or P;
Or R' and R" can be bonded to each other to form a ring,
* refers to the position to be bonded.

4. The compound according to claim 1, wherein the compound represented by Formula 1 may be any one of the following compounds P-1 to P-184:

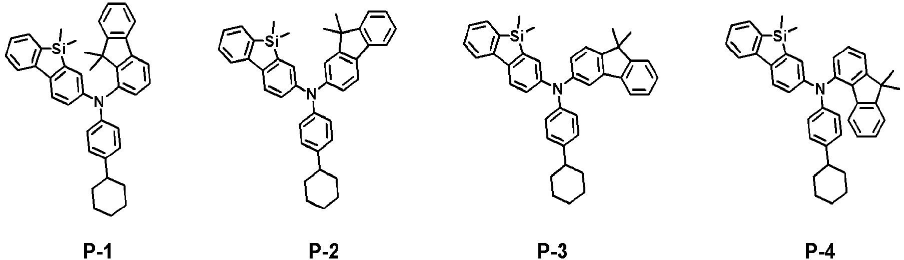

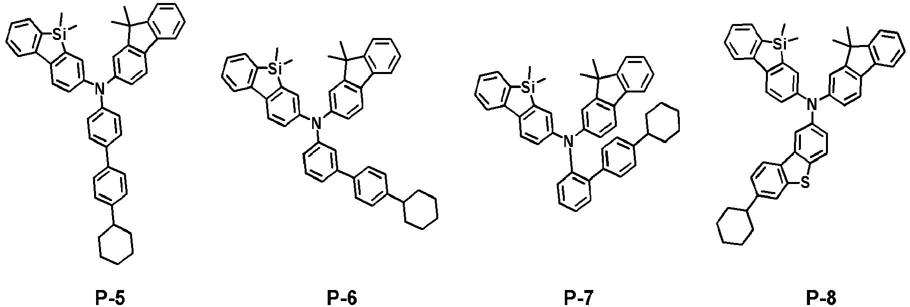

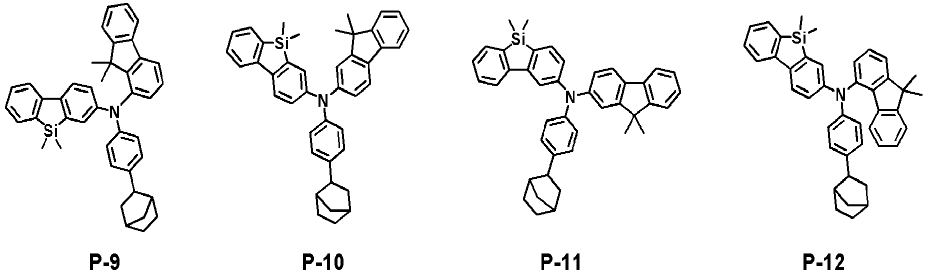

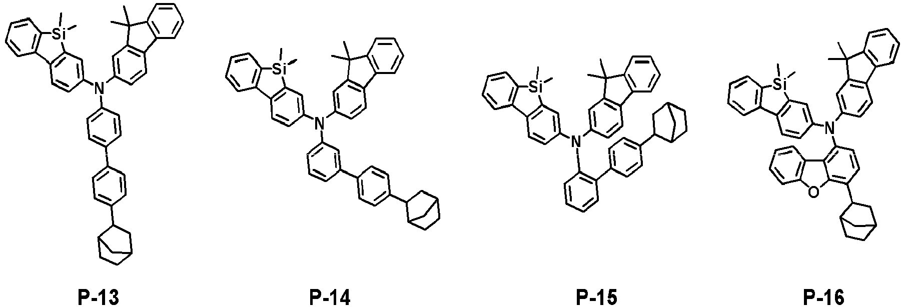

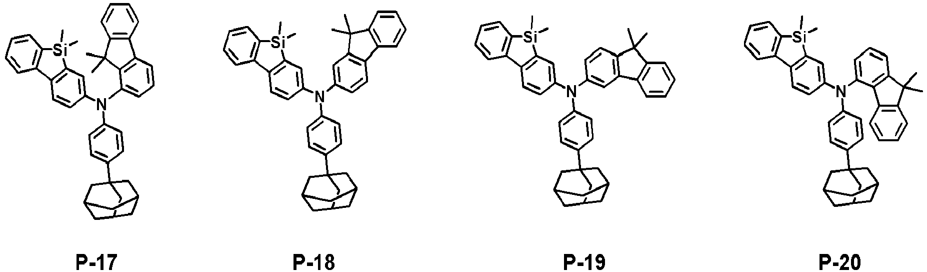

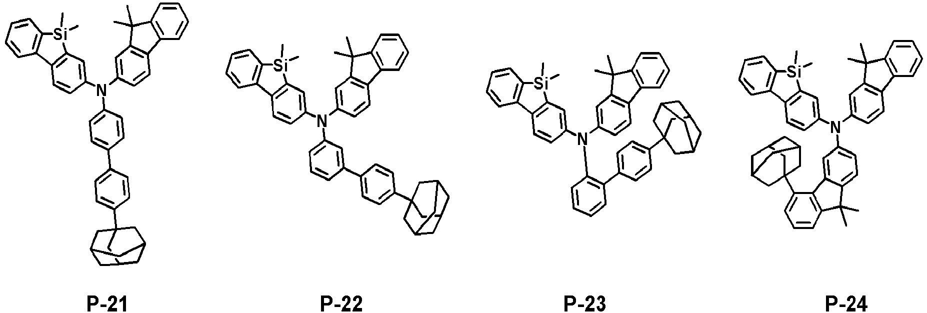

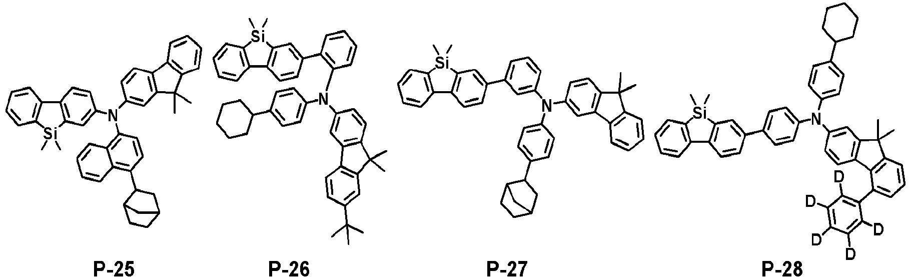

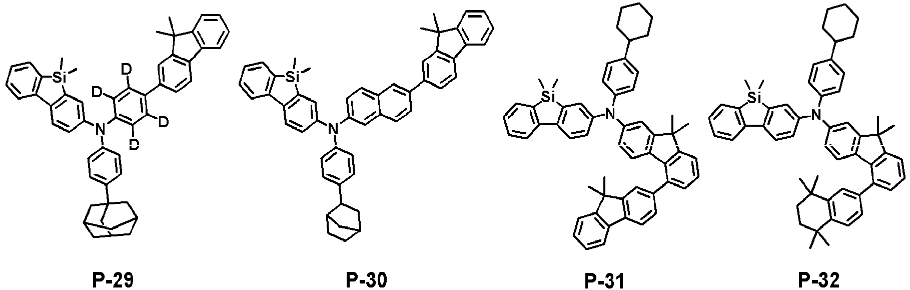

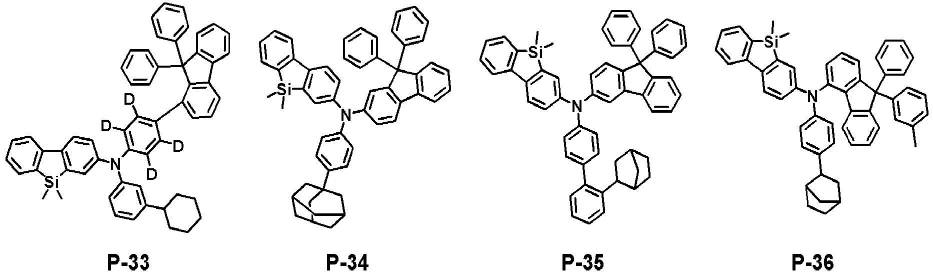

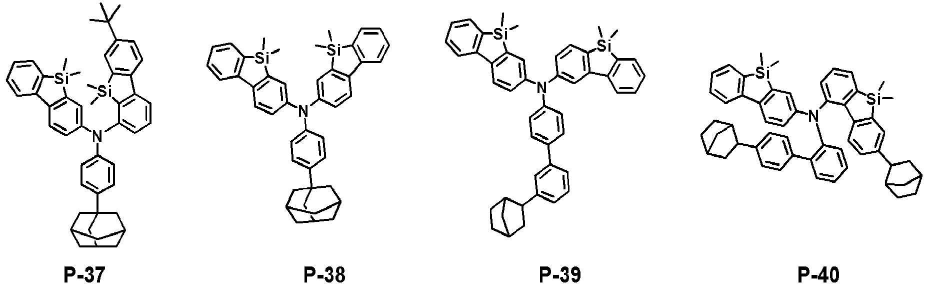

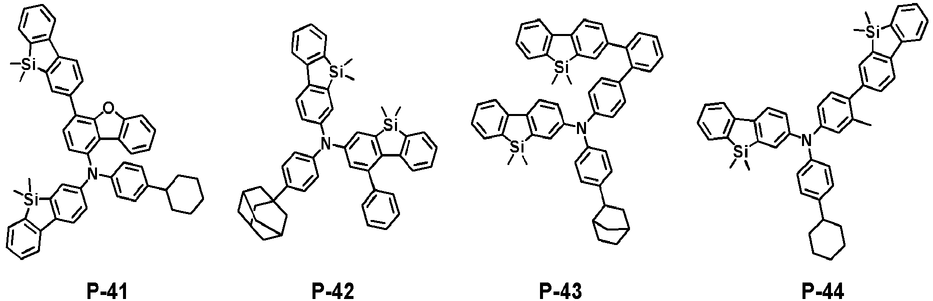

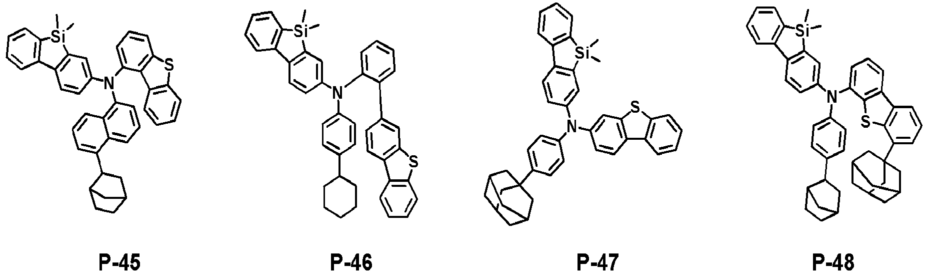

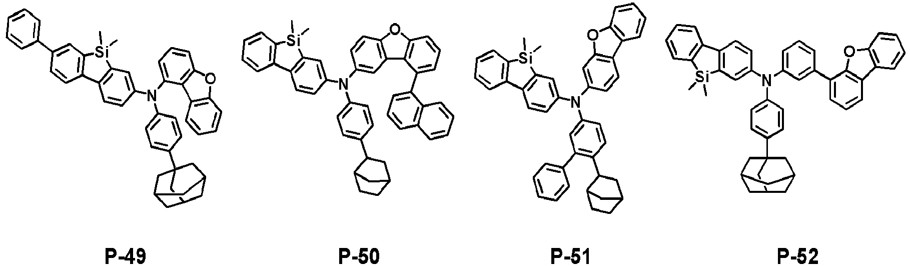

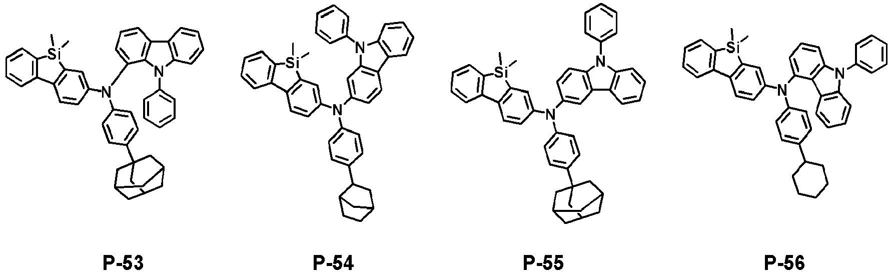

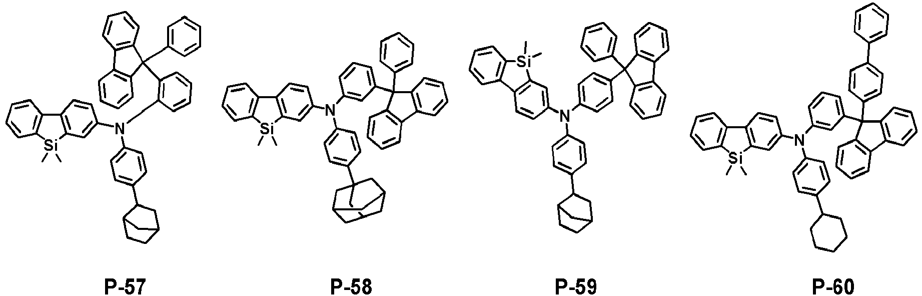

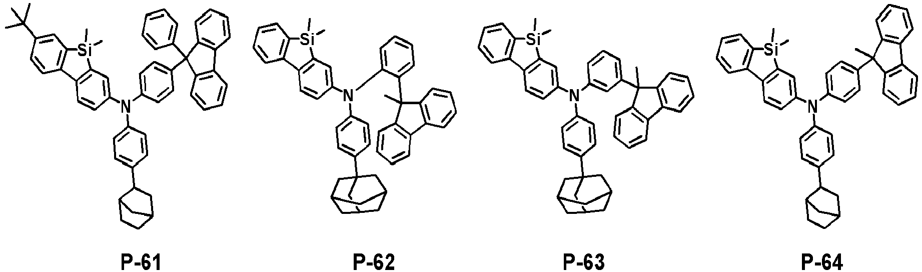

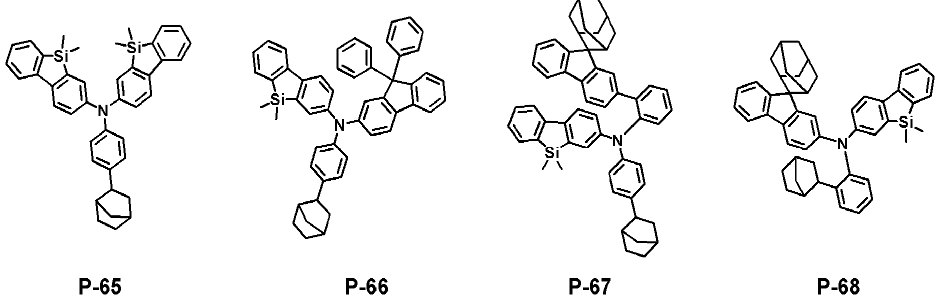

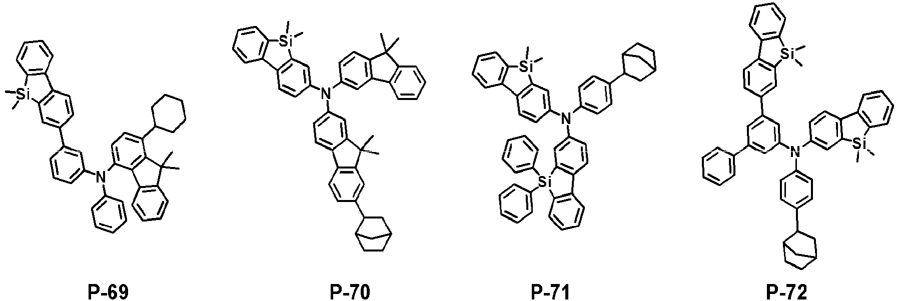

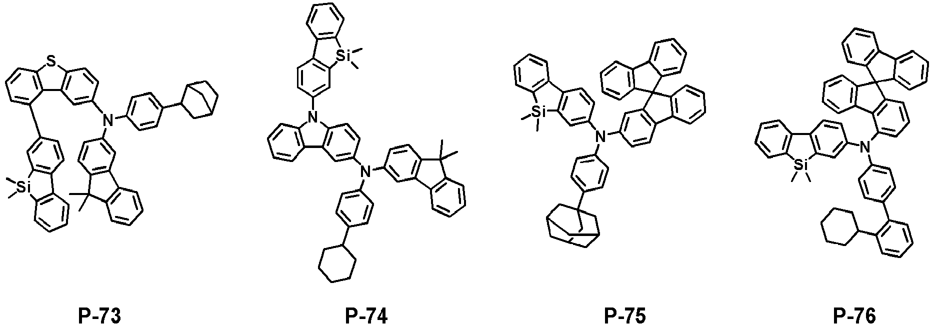

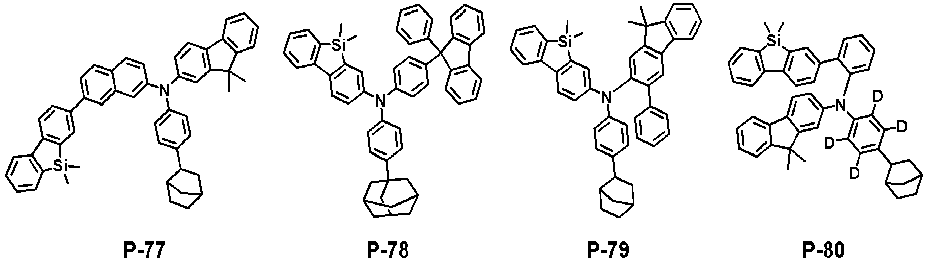

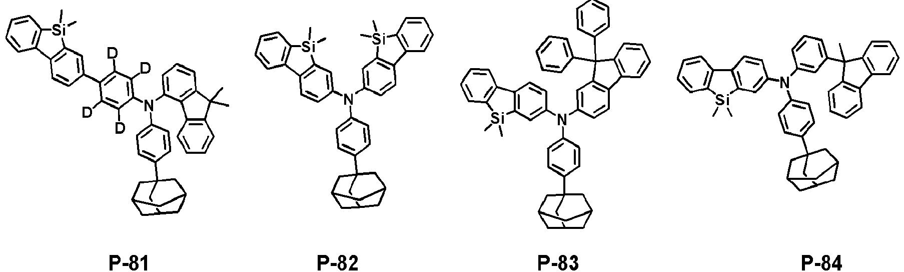

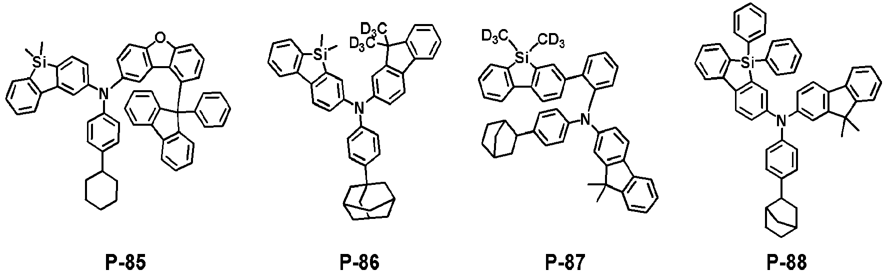

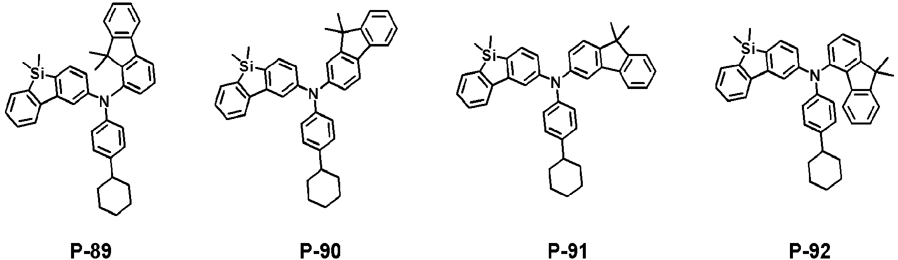

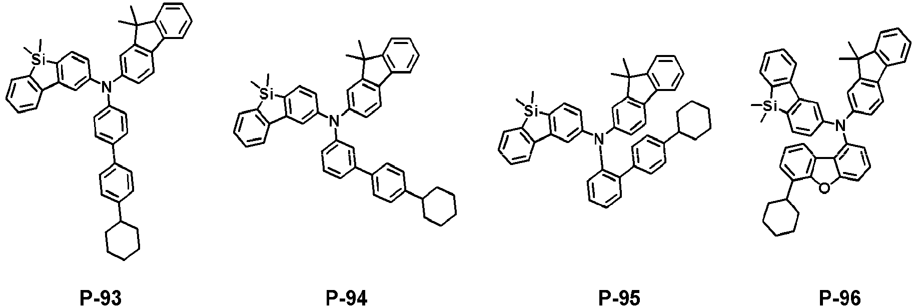

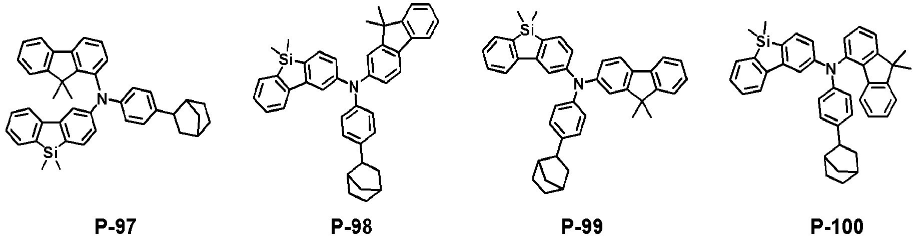

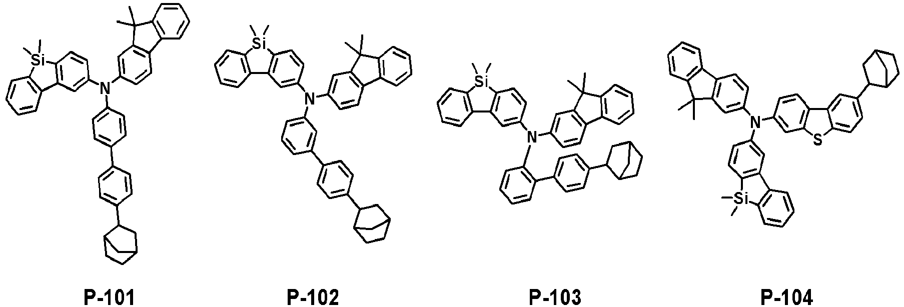

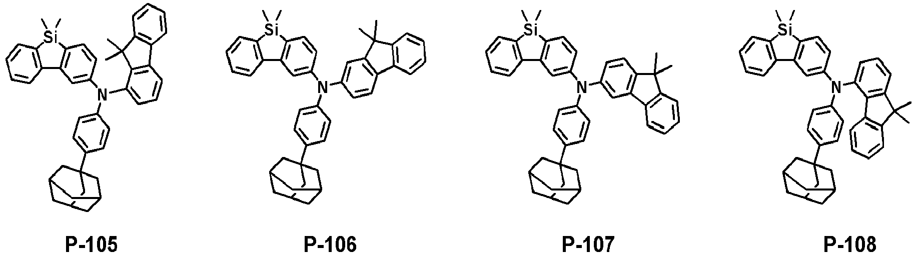

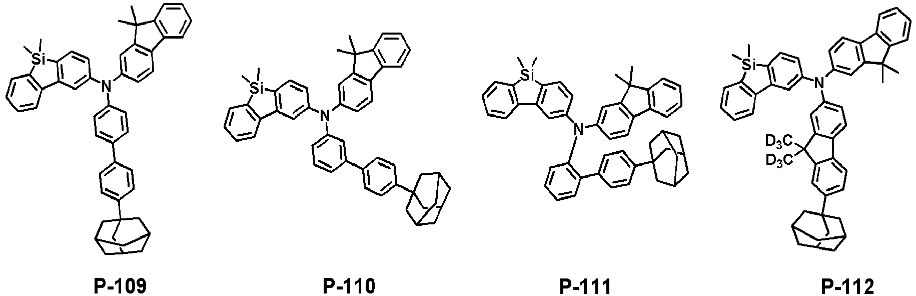

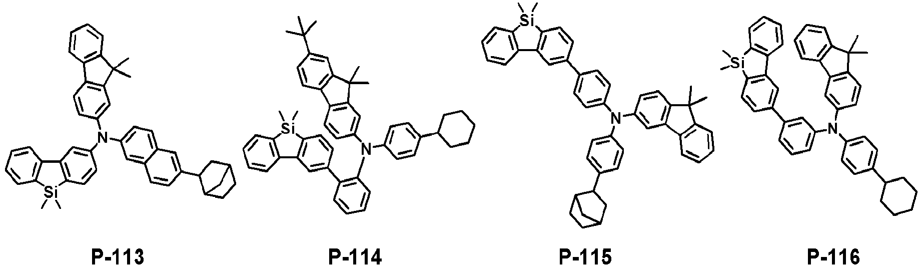

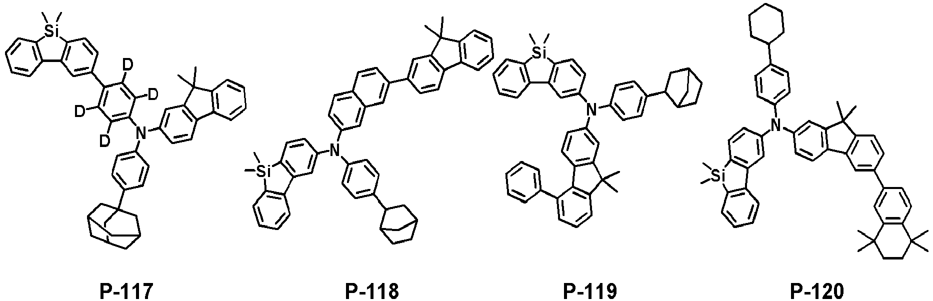

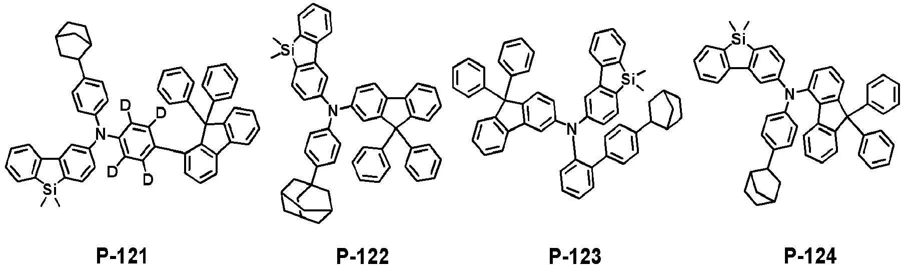

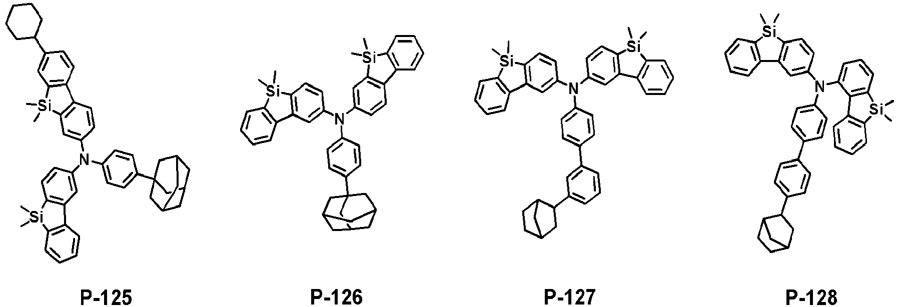

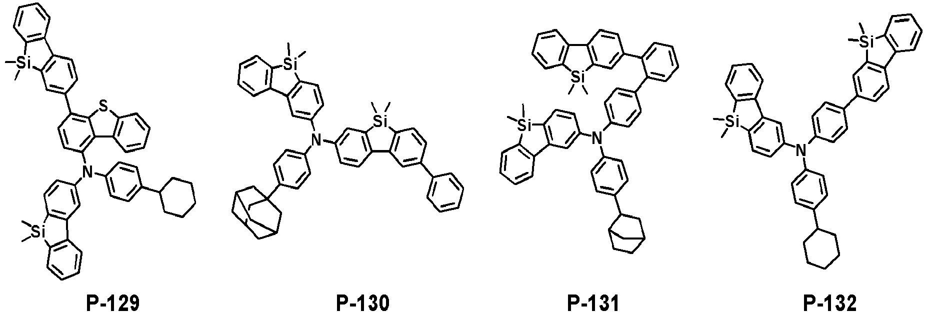

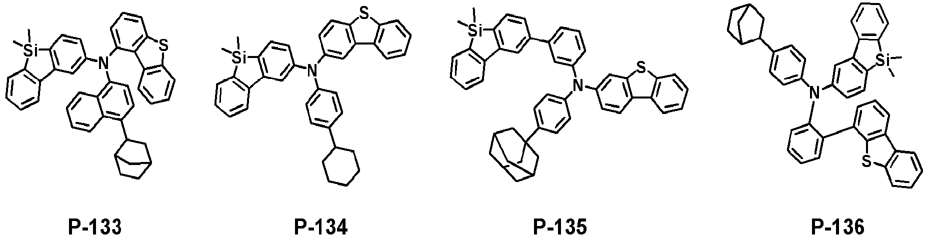

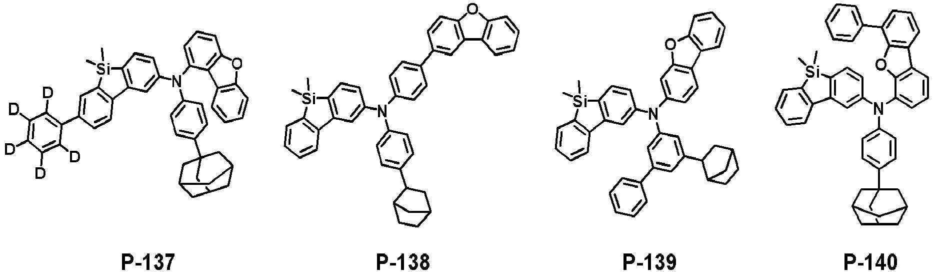

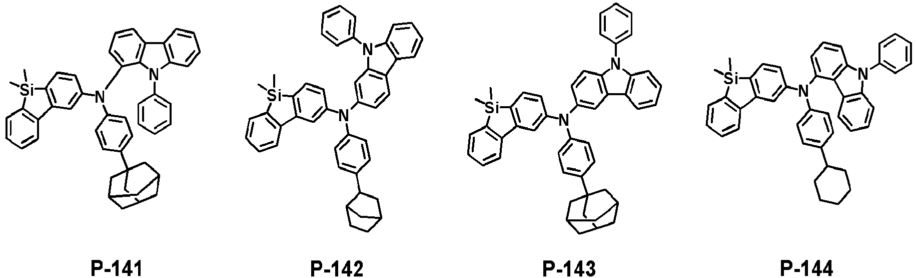

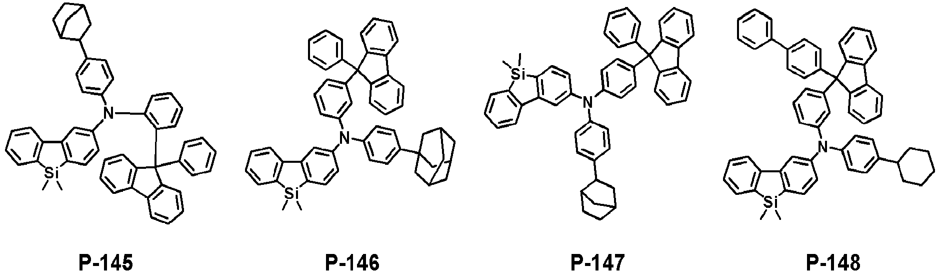

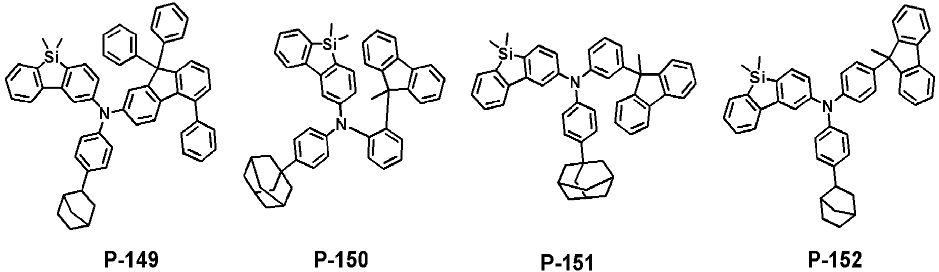

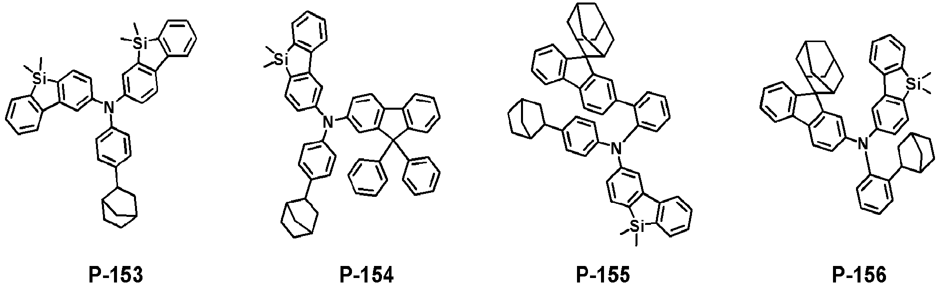

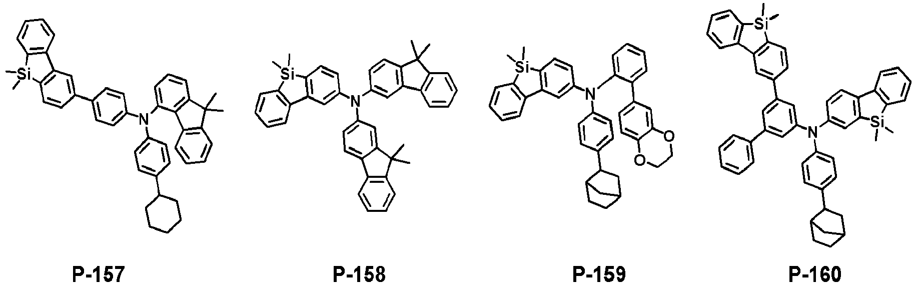

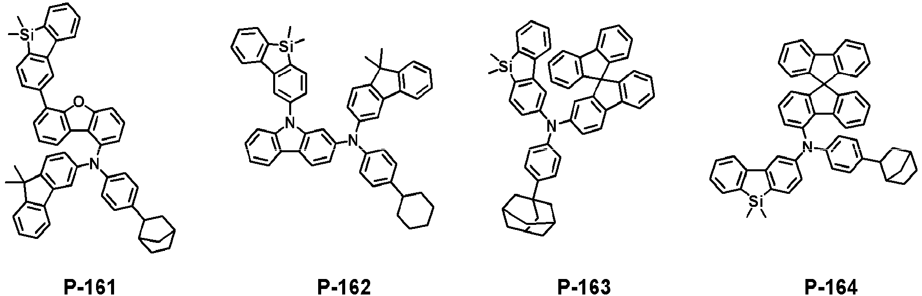

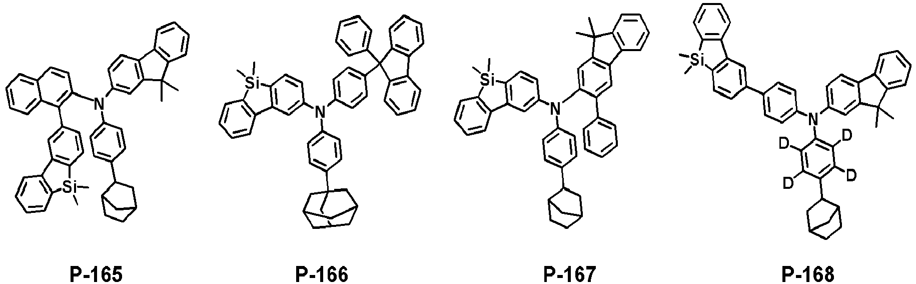

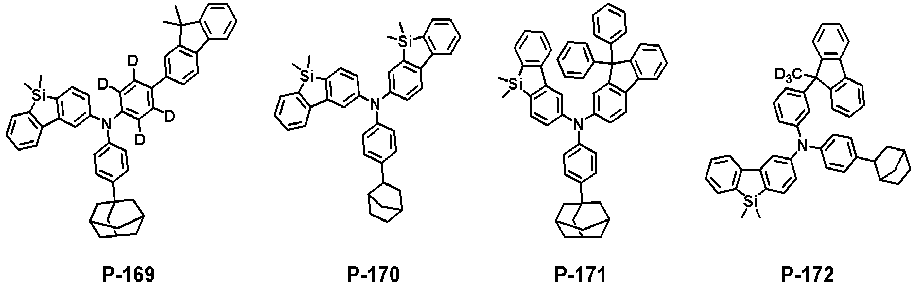

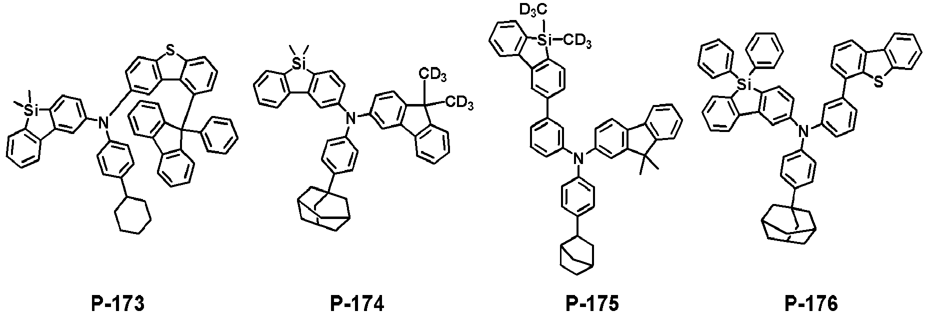

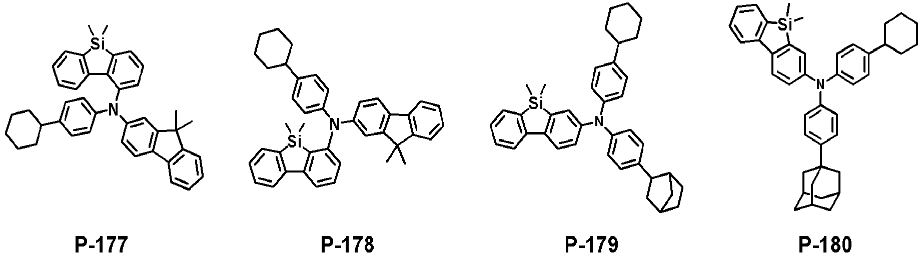

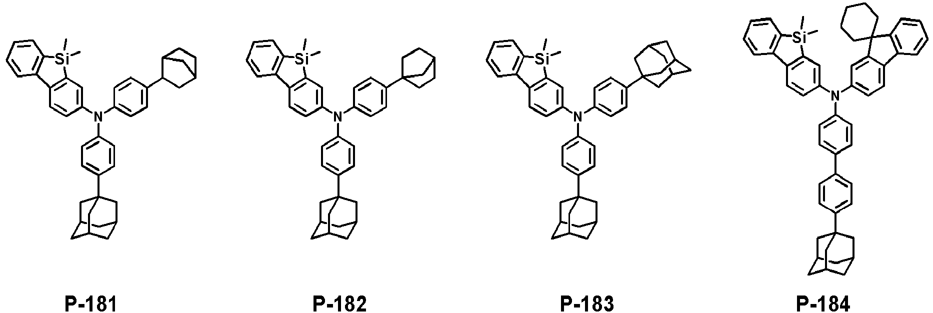

5. An organic electronic element comprising an anode, a cathode, and an organic material layer formed between the anode and the cathode, wherein the organic material layer comprises a single compound or 2 or more compounds represented by Formula 1 of claim 1.

6. The organic electronic element according to claim 5, wherein the organic material layer comprises at least one of a hole injection layer, a hole transport layer, an emitting-auxiliary layer, an emitting layer, an electron transport-auxiliary layer, an electron transport layer and an electron injection layer.

7. The organic electronic element according to claim 5, wherein the organic material layer is an emitting-auxiliary layer.

8. The organic electronic element according to claim 5, further comprising a light efficiency enhancing layer formed on at least one surface of the anode and the cathode, the surface being opposite to the organic material layer.

9. The organic electronic element according to claim 5, wherein the organic material layer comprises 2 or more stacks comprising a hole transport layer, an emitting layer and an electron transport layer sequentially formed on the anode.

10. The organic electronic element according to claim 9, wherein the organic material layer further comprises a charge generation layer formed between the 2 or more stacks.

11. An electronic device comprising a display device comprising the organic electronic element according to claim 5; and a control unit for driving the display device.

12. An electronic device according to claim 11, wherein the organic electronic element is at least one of an OLED, an organic solar cell, an organic photo conductor(OPC), organic transistor (organic TFT) and an element for monochromic or white illumination.

13. A method for reusing Formula 1 of claim 1 comprising:
recovering a crude organic light emitting material comprising Formula 1 of claim 1 from a deposition apparatus used in the process for depositing the organic emitting material to prepare an organic an organic light emitting device;
removing impurities from the crude organic light emitting material;
recovering the organic light emitting material after the impurities are removed; and
purifying the recovered organic light emitting material to have a purity of 99.9% or higher.
